# EUROPEAN PATENT APPLICATION

(11) **EP 2 348 551 A2**
(43) Date of publication of application: **27.07.2011**
(21) Application number: 09818024.3
(22) Date of filing: 01.10.2009
(51) Int. Cl.: H01L 33/56

(54) **LIGHT-EMITTING DIODE PACKAGE USING A LIQUID CRYSTAL POLYMER**

(30) Priority: 01.10.2008 KR 20080096763
(71) Applicant: Samsung LED Co., Ltd., Gyunggi-do 442-743 (KR)
(72) Inventor: KWAK, Chang-Hoon, Seoul 139-911 (KR); PARK, Il-Woo, Suwon Gyunggi-do 443-756 (KR); SOHN, John Rak, Gyunggi-do 445-753 (KR); LEE, Hyo-Jin, Seoul 135-270 (KR); PARK, Na-na, Seoul 138-160 (KR); JOO, Seong-Ah, Suwon Gyunggi-do 443-710 (KR)
(74) Representative: Grünecker, Kinkeldey, Stockmair & Schwanhäusser Anwaltssozietät
(86) International application number: PCT/KR2009/005671
(87) International publication number: WO 2010/039014

(57) **Abstract**

A light emitting diode (LED) package using a liquid crystal polymer, includes: a package main body formed by using a liquid crystal polymer; a lead frame formed on the package main body; an LED chip mounted on the lead frame; and a resin packaging unit encapsulating the LED chip, the resin packaging unit including phosphors. The LED package is highly reliable.

## Description

### [Technical Field]

The present invention relates to a light emitting diode package using a liquid crystal polymer and, more particularly, to an environmentally-friendly light emitting diode (LED) package implemented by using a liquid crystal polymer, thus improving reliability and preventing environmental pollution or contamination.

### [Background Art]

A light emitting diode (LED) chip is a solid light emitting element made of a semiconductor, which, in comparison with other thermal conversion light emitting elements is stable, reliable and has a long lifespan. In addition, the LED chip can be driven at low voltage and with a current having tens of mA, thus consuming less power, so the usefulness of the LED chip as a light emitting element may be further anticipated.

LEDs are increasingly used as a light source in various fields. For example, a side view LED may be used as a light source in a backlight unit of a small liquid crystal display such as a display of a mobile phone or a PDA; a flash light emitting diode may be used as a light source of a mobile phone having a camera and as signboard illumination; and a high output LED may be used as a light source of a lighting system, for electrical devices, or the like. As the field of applications of LEDs is extending, LEDs are required to be developed as next-generation illumination light sources ensuring long-term reliability.

However, in an existing LED package, a package main body is formed by molding a cup-like shaped LED package on a lead frame through injection molding. In this case, a nylon-based polymer, e.g., a polyphthalamide (PPA) or a polyamide (PA)-based polymer, is used as an injection-molded material.

As for the package main body formed by injection-molding nylon-based polymers (PPA, PA, PA46, PA9T), when a high voltage current is applied to the LED package to generate light of high luminance, the package main body may be degraded be being discolored due to high temperature heat generated by an LED chip, degrading reflector efficiency. This results in a degradation of the luminous efficiency and reliability of the overall LED package.

In addition, the nylon-based polymer may include halogen elements (F, Cl, Br, and I), causing environmental pollution.

### [Disclosure]

### [Technical Problem]

An aspect of the present invention provides an environmentally-friendly light emitting diode (LED) package using a liquid crystal polymer, instead of the conventionally used nylon-based resin, thus providing long-term reliability, and excluding the use of halogen elements.

### [Technical Solution]

According to an aspect of the present invention, there is provided a light emitting diode (LED) package using a liquid crystal polymer, including: a package main body formed by using a liquid crystal polymer; a lead frame formed on the package main body; an LED chip mounted on the lead frame; and a resin packaging unit encapsulating the LED chip, the resin packaging unit including phosphors.

The liquid crystal polymer may include glass fibers or mineral salts. The liquid crystal polymer may include at least any one of TiO₂, MgO, and CaCO₃. The liquid crystal polymer may include at least any one of a heat stabilizer and a light stabilizer.

The LED package using a liquid crystal polymer may further include a bonding wire electrically connecting the LED chip and the lead frame.

The package main body may include a reflective cup having a recess portion to accommodate the LED chip. The LED chip is mounted in the recess portion. The lead frame may be formed on the bottom of the reflective cup.

The package main body may be formed by molding a portion of the lead frame, and the lead frame may be plated with silver (Ag).

The resin packaging unit may include one or more of blue, green, red, and yellow phosphors or may be formed to have a multi-layered structure, and the resin packaging unit may be made of a transparent resin.

The liquid crystal polymer may have 90% or more whiteness (Lx(D65)) and reflectance (or reflectivity) of 70% or higher, according to the wavelength in a visible region ranging from 450 nm to 780 nm.

### [Description of Drawings]

FIG. 1 is a vertical cross-sectional view of a light emitting diode (LED) package using a liquid crystal polymer according to an exemplary embodiment of the present invention;
FIG. 2 is a graph of reflectance over wavelength in a visible ray region;
FIGS. 3 to 8 are views illustrating an LED chip according to an exemplary embodiment of the present invention;
FIGS. 9 to 27 are views illustrating an LED chip according to another exemplary embodiment of the present invention;
FIGS. 28 to 31 are views illustrating an LED chip according to another exemplary embodiment of the present invention;
FIGS. 32 to 37 are views illustrating an LED chip according to another exemplary embodiment of the present invention;
FIGS. 38 to 41 are views illustrating an LED chip according to another exemplary embodiment of the present invention;
FIGS. 42 to 52 are views illustrating an LED chip according to another exemplary embodiment of the present invention;
FIGS. 53 to 62 are views illustrating an LED chip according to another exemplary embodiment of the present invention;
FIGS. 63 to 66 are sectional views illustrating examples of structures in which phosphors are stacked in a multi-layered form on a UV LED chip or a blue LED chip;
FIG. 67 is a vertical cross-sectional view illustrating an LED package using a liquid crystal polymer according to another exemplary embodiment of the present invention;
FIG. 68 is a graph of luminance variation over operation time of the LED package using a liquid crystal polymer according to an exemplary embodiment of the present invention; and
FIG. 69 is a graph of reflectance over material forming a package main body.

### [Mode for Invention]

Exemplary embodiments of the present invention will now be described in detail with reference to the accompanying drawings. The invention may, however, be embodied in many different forms and should not be construed as being limited to the embodiments set forth herein. Rather, these embodiments are provided so that this disclosure will be thorough and complete, and will fully convey the scope of the invention to those skilled in the art. In the drawings, the shapes and dimensions may be exaggerated for clarity, and the same reference numerals will be used throughout to designate the same or like components.

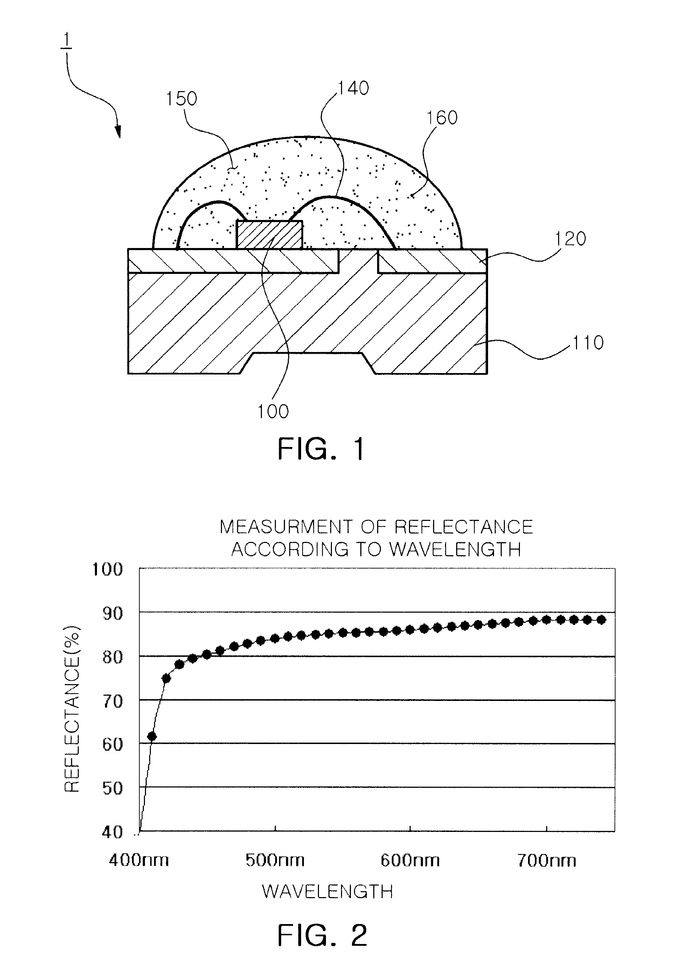

FIG. 1 is a vertical cross-sectional view of a light emitting diode (LED) package using a liquid crystal polymer according to an exemplary embodiment of the present invention. As shown in FIG. 1, an LED package 1 according to an exemplary embodiment of the present invention includes a package main body 110, a lead frame 120 molded in the package main body 110, an LED chip 100 mounted on the lead frame 120, phosphors 16, and a resin packaging unit 150. Also, the LED package 1 further includes bonding wires 140 electrically connecting the LED chip 100 to the lead frame 120.

The package main body 110 is injection-molded by using a liquid crystal polymer, and the lead frame 120 is formed on the package main body 110. Electrodes are formed and connected to a positive electrode terminal and a negative electrode terminal of the LED chip 100. The positive electrode terminal and the negative electrode terminal are separately disposed so as to be electrically insulated from each other.

Here, the liquid crystal polymer is a polymer exhibiting crystallinity in a solution or dissolved state. Even in a molten state, the liquid crystal polymer maintains a crystal state and has excellent heat resistance and compactibility (or formability). In particular, compared with the nylon-based polymer used in injection-molding a package main body of the related art LED package, the liquid crystal polymer has excellent heat conductivity to effectively release heat generated from the LED chip to the outside.

The liquid crystal polymer has a self-reinforcement effect according to the orientation (or alignment) of stiff molecular cycles therein, having a high mechanical strength, and also has a high impact strength from a low temperature to a high temperature. Also, the liquid crystal polymer has excellent heat resistance and electric insulation, low melt viscosity to facilitate shaping to allow for shaping to have a small thickness, and excellent gas barrier properties.

Thus, in the present exemplary embodiment, the liquid crystal polymer is used for the package main body 110. Namely, since the liquid crystal polymer is used in the injection-molding of the package main body 110, package main body 110 exhibits excellent reliability with respect to high temperature and light compared with the existing nylon-based injection-molded resin products, and since the package main body 110 has low moisture absorption, it is less degraded by moisture infiltration. Also, recently, the environmental regulations with respect to the use of halogen elements (F, Cl, Br, and I) have been strengthened in many jurisdictions, and the existing injection-molded resin contains a small amount of halogen elements, while the liquid crystal polymer does, thereby allowing the liquid crystal polymer to be used as an environmentally-friendly material in the future.

Also, the addition of glass fibers and mineral salts to the liquid crystal polymer used for injection-molding the package main body 110 can further increase the mechanical strength thereof.

Also, at least any one of TIO2, MgO, and CaCO3 may be added as a photocatalyst to the liquid crystal polymer to improve whiteness (Lx(D65)) to fabricate a package main body satisfying a whiteness level of 90% or more.

In this case, as shown in FIG. 2, a liquid crystal polymer can have a reflectance of 70% or greater, according to wavelength in a visible right region (wavelength range).

Besides, in the present exemplary embodiment, since the package main body 110 is injection-molded by using the liquid crystal polymer including a thermal stabilizer and a photostabilizer, the thermal and optical reliability of the LED package can be further improved.

The lead frame 120 is protruded from the package main body 110 so as to be electrically connected to an external power source. The protruded lead frame may have various shapes and may be plated with silver (Ag) to reflect light emitted from the LED chip 120.

The LED chip 100 may be bonded to an upper surface of the lead frame 120 by means of an adhesive, or the like, and generate light of a predetermined wavelength upon receiving a current from the external power source through the bonding wires 140. Here, the LED chip 100 may be configured to have a semiconductor stacked structure emitting light of a first wavelength region selected from among UV, blue, green, or red wavelength regions, from UV, blue, yellow, and green wavelength regions, from UV and blue wavelength regions, from UV and green wavelength regions, from blue, yellow and green wavelength regions, or from yellow and red wavelength regions.

The semiconductor stacked structure may have the following structure: A low temperature (200°C to 500°C) buffer layer such as (Al)GaN, AIN, or InGaN formed on a single crystalline substrate such as sapphire (Al2O3), silicon carbide (SiC), zinc oxide (ZnO), gallium arsenide (GaAs), or silicon (Si) substrate as a crystal growth substrate, an n-type clad layer including multiple layers of (In)GaN or (Al)GAN layer with Si doped thereon or without Si formed on the buffer layer, and a multi-layered active layer including InGaN (well layer)/InGaN (barrier layer) InGaN/GaN, or InGaN/AlGaN formed on the n-type clad layer. A p-type clad layer including multiple layers of (Al)GaN or (In)GaN with Mg doped thereon or without Mg may be formed on the active layer.

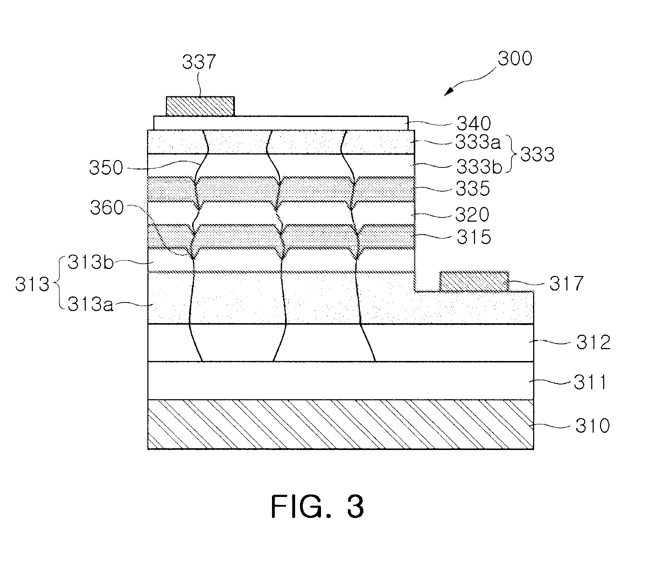

Various examples of the stacked structure of the LED chip according to an exemplary embodiment of the present invention will now be described with reference to FIGS. 3 to 62.

First, FIGS. 3 to 8 illustrate an LED chip according to an exemplary embodiment of the present invention.

As illustrated, the LED chip according to an exemplary embodiment of the present invention includes a substrate 310, a buffer layer 311 formed on the substrate 310, a light emission structure including n-type nitride semiconductor layers, an active layer 320, p-type nitride semiconductor layers 335 and 333 which are sequentially stacked on the buffer layer 311, a through defect penetratingly formed in an at least a portion of the light emission structure, and a V-shaped distortion structure 360 based on the through defect. An undoped GaN layer 312 may be further included between the buffer layer 311 and the n-type nitride semiconductor layer 313.

Portions of the p-type nitride semiconductor layers 333 and 335 and the active layer 320 are removed through a mesa etching process to expose a portion of an upper surface of the n-type nitride semiconductor layer 313, and an n-type electrode 317 is formed on the exposed n-type nitride semiconductor layer 313.

A transparent electrode 340 made of ITO (Indium Tin Oxide), or the like, is formed on the p-type nitride semiconductor layer 333, and a bonding electrode 337 is formed on the transparent electrode 340.

The substrate 310, suitable for growing a nitride semiconductor single crystal, is preferably made of a transparent material including sapphire. Besides, the substrate 310 may be made of zinc oxide (ZnO), gallium nitride (GaN), gallium arsenide (GaAs), silicon, silicon carbide (SiC), aluminum nitride (AIN), or the like.

The buffer layer 311 serves to improve lattice-matching with the substrate 310 formed to include sapphire before the n-type nitride semiconductor layer 313 is grown on the substrate 310. The buffer layer 311 may generally be made of a material of one or more layers of undoped GaN, InGaN, AIN, InN, AlInGaN, SiC, and ZnO. The buffer layer 311 may be omitted according to the type of the substrate 310 and the growth method thereof.

The n-type nitride semiconductor layer 313 includes an n-type GaN contact layer 313a with n-type impurities such as Si, Ge, Sn, and the like, doped therein, an n-type GaN layer 313b having a V-shaped distortion structure 360 on the n-type GaN contact layer 313a, and an n-type super-lattice layer 315.

The n-type super-lattice layer 315 has a structure in which three or more layers including AlxlnyGazN (0≤x, y, z≤1) are repeatedly stacked, and preferably, three layers including an AIGaN layer, a GaN layer, and an InGaN layer are repeatedly stacked, and in this case, at least one of the AIGaN layer, the GaN layer, and the InGaN layer has a thickness of 20 nm or smaller.

The n-type GaN layer 313b or the n-type super-lattice layer 315 may be formed as a multi-layered film by changing the concentration of the n-type impurities, the thickness of the respective layers, or the ingredients of the respective layers. For example, the doping concentration of the GaN ingredient may be changed and several different layers formed, or two or more layers having different GaN, InGaN, and AlGaN ingredients may be stacked, layers having different impurity concentrations may be repeated, or layers having different thicknesses may be repeated to form an n-side multi-layered film. The n-side multi-layered film may be positioned between the n-type contact layer and the active layer.

Meanwhile, the V-shaped distortion structure 360 is formed around a through potential 350 in order to prevent a current to be concentrated in the through potential 350.

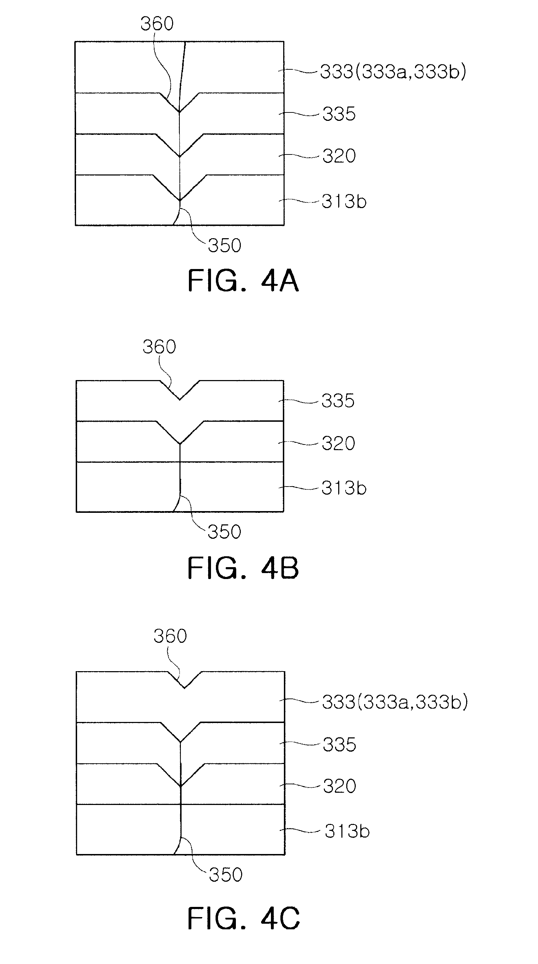

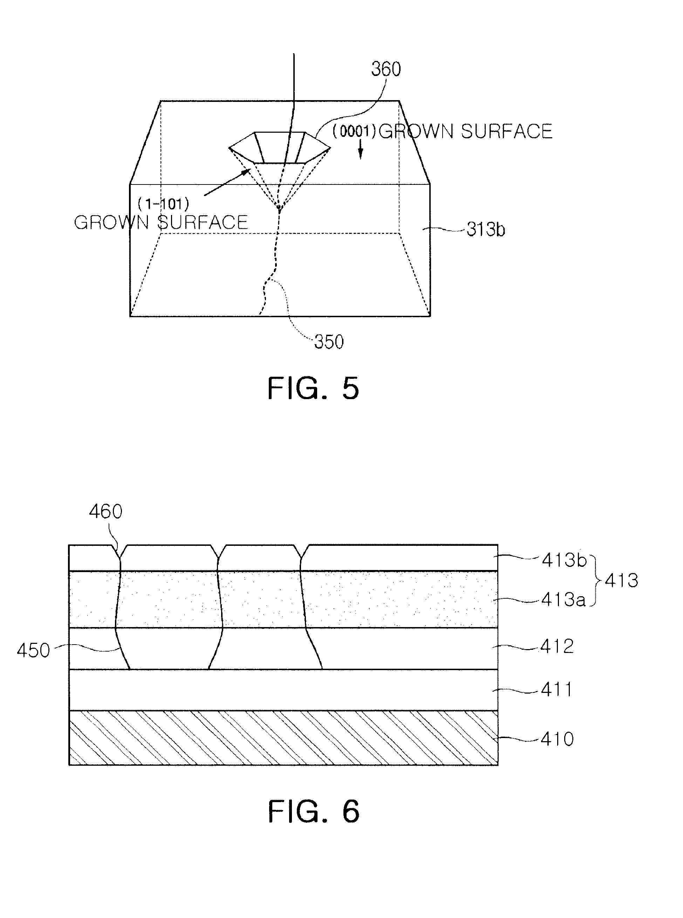

FIGS. 4 and 5 show the V-shaped distribution structure 360, and FIG. 4 is a cross-sectional view while FIG. 5 is a perspective view.

As illustrated, the V-shaped distribution structure 360 has a surface form including both a regular grown surface 0001 and a sloped grown surface 1-101. The sloped grown surface 1-101 has a regular hexagonal shape when viewed from above and has a V-like cross-sectional shape.

As mentioned above, the V-shaped distortion structure is selectively generated in a position where the through potential 350 is formed. The through potential 350 may end in the V-shaped distortion layer (See FIGS. 4b and 4c).

In the V-shaped distortion structure 360, the V-shaped valley forms become gentler in the thickness direction of the respective layers, i.e., toward the active layer 320 and the p-type nitride semiconductor layer 333 from the n-type GaN layer 313b, and the V-shaped valley is gradually flattened in the vicinity of the p-type GaN contact layer 333a following the p-type GaN layer 333b, resulting in a formation of a uniform layer structure (See FIG. 4).

In this case, the V-shape is maintained because a growth temperature of the layer in which it is formed is 900°C or lower, while the V-shape may be filled if the growth temperature of the layer in which it is formed is 1,000°C or higher.

In this manner, in the present exemplary embodiment, the V-shaped distortion structure is controlled by regulating the growth temperature of the semiconductor layer, and a method for manufacturing the nitride semiconductor LED chip will later be described in greater detail.

As discussed above, in the p-type nitride semiconductor layer 333 formed in a state in which the sloped grown surface exists, since the p-type GaN layer having semi-insulator characteristics with low conductivity is formed at the portion where the V-shaped distortion structure 260 is present, a current interrupting effect may be apparent.

According to the characteristics of interrupting the current at the portion where the V-shaped distortion structure is present, the current concentrated through the defect (through potential) is interrupted when static electricity is applied, significantly improving the ESD resistance (or tolerance) of the element. In particular, in the present exemplary embodiment, the ESD withstand voltage value is increased to be 6kV or higher, based on a reverse direction.

In the evaluation of ESD resistance, the viability (the number of non-defective units after ESD is applied/the number of non-defective units before ESD is applied × 100) at a particular voltage is more important than an absolute withstand voltage value. Based on the viability at a reverse voltage of 2kV, the application of the structure proposed in the present exemplary embodiment obtained an effect in which the ESD viability of 60% in the existing structure was drastically improved to 95%.

In general, the light emitting element having the width and length of hundreds of micrometers includes one or more V-shaped distributions which are equal to or less than the distributions of the through potentials 350. For example, when there are 5 x 108/cm2 number of potentials, 5 x 108/cm2 or less number of V-shaped distortions exist, and most ideally, V-shaped distortions are generated in all of the potentials and the potentials and the V-shaped distortions are formed by the same distribution and the same number. In the structure according to present exemplary embodiment, V-shaped distortions are formed substantially in all of the potentials.

The configuration of the nitride semiconductor LED chip 300 will now be described with reference to FIG. 3. The active layer 320 formed on the n-type super-lattice layer 315 may be configured to have a multi-quantum well structure formed of AlxlnyGazN (0≤x,y,z≤1). For example, the active layer 320 may be formed to have a multi-quantum well structure in which an InGaN-based quantum well layer and a GaN-based quantum barrier layer are alternately stacked.

The wavelength or quantum efficiency of the active layer 32 may be regulated by adjusting the height of the quantum barrier layer, the thickness, or the composition of the quantum well layer, and the number of quantum wells.

Meanwhile, the active layer 320 may be configured as a single quantum well layer or may be configured to have a double-hetero structure.

The p-type nitride semiconductor layer 333 is a semiconductor layer doped with p-type impurities such as Mg, Zn, Be, and the like. The p-type nitride semiconductor layer 333 includes a p-type super-lattice layer 335, a p-type AlGaN layer 333b, and a p-type (In)GaN contact layer 333a.

The p-type super-lattice layer 335 has a structure in which three or more layers made of AlxlnyGazN (0≤x,y,z≤1) are repeatedly stacked. For example, the p-type super-lattice layer 335 may typically have a structure in which three layers, each made of an AIGaN layer, a GaN layer, and an InGaN layer, the thickness of at least one layer being 20 nm or smaller, are repeated.

Also, the p-type (Al)GaN layer 333b or the p-type super-lattice layer 335 may be formed as a multi-layered layer by changing the concentration of the n-type impurities, the thickness of the respective layers, or the ingredients of the respective layers. For example, the doping concentration of the GaN ingredient may be changed to form several layers, or two or more layers having different GaN, InGaN, and AIGaN ingredients may be stacked, layers having different impurity concentrations may be repeated, or layers having different thicknesses may be repeated to form a p-side multi-layered film. The p-side multi-layered film may be positioned between the p-type contact layer and the active layer.

In particular, the thickness of the p-type (Al)GaN layer 333b affects forward ESD characteristics. In the present exemplary embodiment, the thickness of the p-type GaN-based material layer (p-type super-lattice layer, p-type GaN layer, and p-type GaN contact layer) on the active layer is 250 nm or greater, so that the forward ESD value can have a relatively high withstand voltage value of 6kV or higher.

In the nitride semiconductor LED chip 300 according to an exemplary embodiment of the present invention, V-shaped distortion is formed around the through potential passing through the light emission structure to increase resistance at the portion to thus interrupt current concentrated through the defect (through potential) when static electricity is applied, thus improving ESD resistance (or toleration).

Namely, in the related art, the through potential causes a leakage current, so when static electricity is discharged, the current is concentrated, damaging the element, while in the present exemplary embodiment, the through potential is instead used to increase the resistance in the vicinity of the through potential through the V-shaped distortion structure to thus improve the ESD level of 6kV or higher based on a reverse direction.

A method for manufacturing the nitride semiconductor LED chip according to an exemplary embodiment of the present invention, configured as described above, will now be described.

FIGS. 6 to 8 are views illustrating sequential processes of a method for manufacturing the nitride semiconductor LED chip according to an exemplary embodiment of the present invention.

First, as shown in FIG. 6, a substrate 410 is prepared and a buffer layer 411 is formed on the substrate 410.

As stated above, the substrate 410, suitable for growing a nitride semiconductor single crystal, is preferably made of a transparent material, including sapphire. The substrate 310 may be made of zinc oxide (ZnO), gallium nitride (GaN), gallium arsenide (GaAs), silicon, silicon carbide (SiC), aluminum nitride (AIN), or the like.

Also, one or more depressions and protrusions may be formed in the surface of the substrate. The depressions and protrusions may have various shapes such as a circular shape, a triangular shape, a quadrangular shape, a pentagonal shape, a hexagonal shape, an octagonal shape, or the like. Also, a substrate surface structure having various shapes such as a circular shape (or an oval shape), a triangular shape, a quadrangular shape, or the like, in the section of the depressions and protrusions may be used to improve the luminance of the light emitting element and reduce crystal defects.

The buffer layer 411 serves to improve lattice-matching with the substrate 410 formed to include sapphire before the n-type nitride semiconductor layer is grown on the substrate. In general, the buffer layer 411 may be made of a nitride semiconductor (GaN, AIN, etc.)-based or a carbide (SiC, etc.)-based material.

When a nitride semiconductor-based material is used to form the buffer, the formation temperature (growth temperature) may be regulated to be within the range from 200°C to 900°C, and when the carbide-based material is used to form the buffer, the formation temperature (growth temperature) may be regulated to be within the range from 500°C to 1,500°C. However, the buffer layer 411 may be omitted according to the type and growth method of the substrate 410.

Subsequently, an undoped GaN layer 412 is grown within the range from 0.01 µm to a few µm, without adding an n-type impurities, on the buffer layer 411, and an n-type GaN contact layer 413a with an n-type impurities such as Si, Ge, Sn, or the like, doped therein is formed on the GaN layer 412.

In this case, the concentration of the n-type impurities is preferably 3 × 1018/cm3 or more, and an effect in which as the concentration of the n-type impurities increases, a threshold voltage (Vf) is reduced to within a range in which crystallinity is not degraded can be obtained. In this case, if the concentration of the n-type impurities exceeds 5 × 1021/cm3, the crystalinity will be degraded, so preferably, the concentration of the n-type impurities is determined to be within the range (3 × 1018/cm3 to 5 × 1021/cm3), in which the crystallinity is not degraded.

Subsequently, an n-type GaN layer 413b having a V-shaped distortion structure 460 is formed on the n-type GaN contact layer 413a. The V-shaped distortion structure 460 is formed by using a method of regulating a growth temperature or by using a chemical etching method.

In the method of regulating a growth temperature, n-type or undoped GaN is grown at a temperature ranging from 700°C to 950°C under an atmosphere using nitrogen as a carrier gas to form the V-shaped distortion structure 460 on the GaN layer 413b.

In the chemical etching method, the substrate having the structure with up to the n-type GaN layer 413b formed thereon is taken out of a reactor tank (or reactor system) and the surface of the n-type GaN layer 413b is then chemically etched by using phosphoric acid. In this case, a similar V-shaped layer structure can be formed.

The V-shaped layer structure exists substantially at a portion in which a through potential is formed. The through potential may still exist to penetrate the semiconductor layer to be formed thereafter, but in most cases, the through potential substantially stops in the middle of the layer.

In general, the light emitting element having the width and length of hundreds of micrometers includes one or more V-shaped distributions which are equal to or less than the distributions of the through potentials 450. For example, when there are 5 x 108/cm2 number of potentials, 5 x 108/cm2 or less number of V-shaped distortions exist, and most ideally, V-shaped distortions are generated at all potentials and potentials and the V-shaped distortions are formed by the same distribution and in the same number. In the structure according to present exemplary embodiment, V-shaped distortions are formed at the substantially all of the potentials.

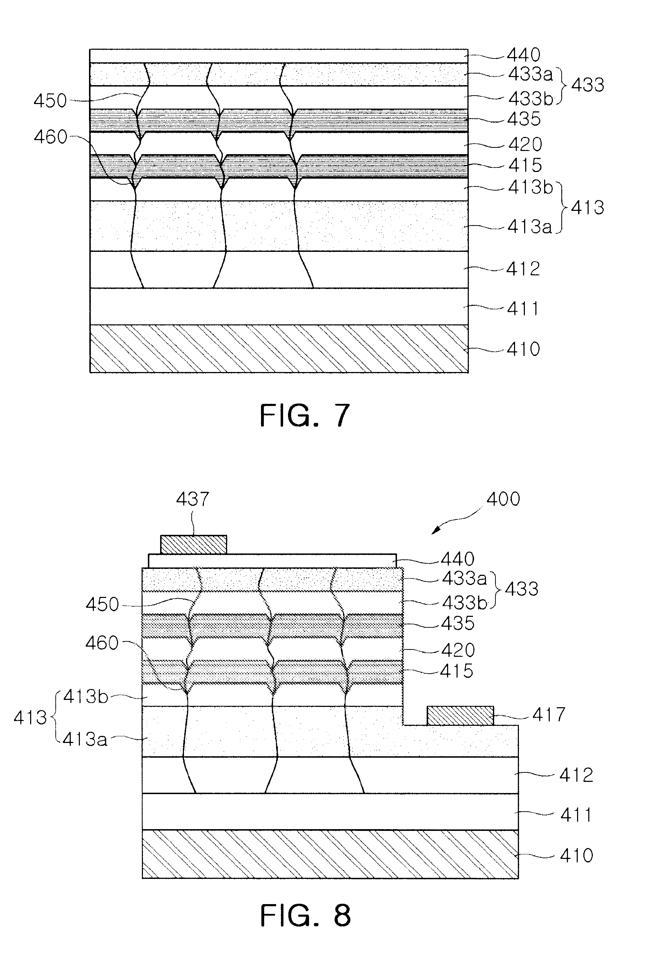

In this manner, the n-type GaN layer 413b having the V-shaped distortion structure 460 is formed, and then, as shown in FIG. 7, three or more layers formed of AlxInyGazN (0≤x,y,z≤1), each having a different composition, are repeatedly stacked on the n-type GaN layer 413b, to form an n-type super-lattice layer 415.

Thereafter, AlxlnyGazN and AlxlnyGazN (0≤x,y,z≤1) are alternately stacked to form an active layer 420 having at one or more quantum-well structures. In this case, the wavelength or quantum efficiency can be adjusted by regulating the height of the barrier of the quantum wells of the active layer 420, the thickness and composition of the well layer, and the number of the quantum wells.

Meanwhile, the growth temperature of the n-type super-lattice layer 415 and the active layer 420 is 900°C or lower, so as to maintain the V-shaped distortion structure formed on the n-type GaN layer 413b.

Subsequently, three or more layers formed of AlxlnyGazN 0≤x,y,z≤1), doped or partially undoped with p-type impurities, each having a different composition, are repeatedly stacked to form a p-type super-lattice layer 435. Typically, AlGaN/GaN/InGaN may be sequentially repeatedly performed.

The p-type impurities include Mg, Zn, Be, or the like, and among them, Mg may typically be used.

Thereafter, a p-type GaN layer 433b is formed on the p-type super-lattice layer 435, and a p-type GaN contact layer 433a having a higher doping concentration of the p-type impurity is formed on the p-type GaN layer 433b, and then, a transparent conductive material such as ITO or IZO is deposited on the p-type GaN contact layer 433a to form a transparent electrode 440.

The thickness of the p-type GaN layer 433b affects the forward ESD characteristics. When the thickness of the p-type GaN-based material layer on the active layer is 250 nm or greater, a high withstand voltage value of 6kB or higher can be achieved as the forward ESD value.

Meanwhile, the p-type super-lattice layer 435, the p-type GaN layer 433b, and the p-type GaN contact layer 433a are grown at a temperature of 1,000°C or higher, and at this growth temperature, the V-shaped valley is filled to flatten the surface of the p-type GaN contact layer 233a.

Then, as shown in FIG. 8, the transparent electrode 440, the p-type GaN contact layer 433a, the p-type GaN layer 433b, the p-type super-lattice layer 435, the active layer 420, and the n-type GaN layer 413b, and the n-type GaN contact layer 413a are mesa-etched to expose a portion of the n-type GaN contact layer 413a.

An n-type electrode 417 is formed on the exposed n-type GaN contact layer 413a, and a p-type electrode 437 is formed on the transparent electrode 440 to thus fabricate a nitride semiconductor LED chip 400 according to an exemplary embodiment of the present invention.

In fabricating the LED chip, the growth substrate may be eliminated and electrodes may be respectively formed on a p-type upper side and an n-type lower side so as to be fabricated as a vertical-type element.

Also, at least one or more depressions and protrusions (or concavo-convex structure or an irregular or uneven structures) may be formed on at least one side of the p-type or n-type semiconductor or on the exposed surface of the LED chip to improve light extraction efficiency.

In the present exemplary embodiment, the semiconductor layers may be formed through metal organic chemical vapor deposition (MOCVD), or various other conventionally known methods may be also used.

In the nitride semiconductor LED chip fabricated through the method as described above, the V-shaped distortion structure is intentionally formed on a portion, in which a through potential is positioned, of at least one of the n-type nitride semiconductor layer, the active layer, or the p-type nitride semiconductor layer, in order to improve the ESD effect.

As described above, the basic concept of the present invention is to form the V-shaped distortion structure near (around or in the vicinity of) the through potential to prevent current concentration in the area when static electricity is applied thereto to thus prevent damage to the LED chip. The V-shaped distortion structure may be formed on any layer of the light emission structure in which the through potential is located.

In addition, besides the structure of the LED chip illustrated in the present exemplary embodiment, it may include any known structure so long as it can form a V-shaped structure near the through potential to prevent a leakage current.

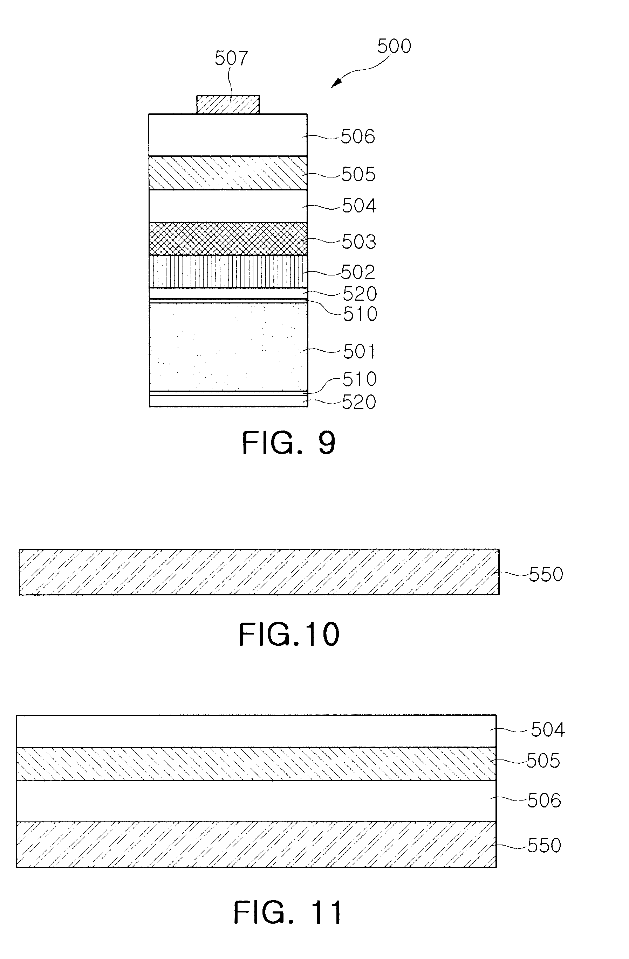

An LED chip according to a different exemplary embodiment of the present invention will now be described with reference to FIGS. 9 to 27.

FIG. 9 is a sectional view showing the structure of a semiconductor LED chip according to a different exemplary embodiment of the present invention.

A semiconductor LED chip 500 according to the exemplary embodiment illustrated in FIG. 9 includes a substrate 501 made of an Si-Al alloy (referred to as an 'Si-Al alloy substrate', hereinafter) and protective layers 520 formed on upper and lower surfaces of the substrate 501.

A junction metal layer 502, a reflective metal layer 503, a p-type semiconductor layer 502, an active layer 505, and n-type semiconductor layer 506 are sequentially stacked on the protective layer 520 formed on the upper surface of the Si-Al alloy substrate 501.

The p-type and n-type semiconductor layers 504 and 506 and the active layer 505, which may be made of a GaN-based semiconductor material, i.e., AlxGay ln(1-x-y)N (0≤x≤1, 0≤y≤1, 0≤x+y≤1), or the like, constitute a light emission structure. An n-side electrode 507 is formed on the n-type semiconductor layer 506.

The reflective metal layer 503 interposed between the junction metal layer 502 and the p-type semiconductor layer 504 reflects light made incident from the semiconductor layer upwardly to increase the luminance of the vertical-type semiconductor LED chip 500.

The reflective metal layer 503 may be made of a metal selected from the group consisting of Au, Ag, Al, Rh, and an alloy of two or more thereof, or the like. However, the reflective metal layer 503 may be omitted as necessary.

The junction metal layer 502 serve to bond the Si-Al alloy substrate 501 to the light emission structure. The junction metal layer 502 may be made of Au, or the like.

In the present exemplary embodiment, the semiconductor LED chip 500 includes the junction metal layer 502, but the Si-Al alloy substrate 501 may be directly bonded to the surface of the semiconductor layer 504 without the presence of the junction metal layer 502.

As mentioned above, the semiconductor LED chip 500 according to the present exemplary embodiment uses the Si-Al alloy substrate 501 as a conductive substrate. The Si-Al alloy is advantageous in terms of thermal expansion coefficient, mechanical processibility, and price.

Namely, the thermal expansion coefficient of the Si-Al alloy substrate 501 is similar to the thermal expansion coefficient (approximately 6 to 7 ppm/K) of the sapphire substrate (550 in FIG. 10). Thus, when the semiconductor LED chip 500 is fabricated by using the Si-Al alloy substrate 501, a bending phenomenon of the substrate occurring in the processing of bonding the conductive substrate made of silicon (Si) and in the process of separating the sapphire substrate through laser irradiation as well as a crack generation phenomenon occurring in the light emission structure can be significantly reduced, so a high quality semiconductor LED chip 500, having low defectivity, can be obtained.

Also, the heat conductivity of the Si-Al alloy substrate 501 ranges from 120 to 180 W/m.K, having excellent heat dispersion characteristics. Besides, since the Si-Al alloy substrate 501 can be easily fabricated by melting Si and Al, the Si-Al alloy substrate 501 can be easily obtained at a low cost.

In particular, in the semiconductor LED chip 500 according to the present exemplary embodiment, the protective layers 520 are additionally formed on the upper and lower surfaces of the Si-Al alloy substrate 501 to prevent chemical damage to the Si-Al alloy substrate 501.

Here, the protective layer 520 may be made of metal or a conducive dielectric. In this case, when the protective layer 520 is made of metal, the metal may be one selected from the group consisting of Ni, Au, Cu, W, Cr, Mo, Pt, Ru, Rh, Ti, and Ta, or an alloy of at least two or more thereof.

When the protective layer 520 is made of metal, the protective layer 520 may be formed through electroless plating. In this case, a seed metal layer 510 may be further formed between the Si-Al alloy substrate 501 and the protective layer 520 made of a metallic material in order to serve as a seed in the process of plating the protective layer 520. The seed metal layer 510 may be made of Ti/Au, or the like

Also, when the protective layer is formed of a conductive dielectric, the protective layer made of the conductive dielectric material may be formed through deposition, sputtering, or the like.

Preferably, the protective layer 520 has a thickness ranging from 0.01 µm to 20 µm, and preferably more, it has a thickness ranging from 1 µm to 10 µm.

A method for fabricating the semiconductor LED chip according to the present exemplary embodiment will now be described with reference to FIGS. 10 to 17.

FIGS. 10 to 17 are sectional views illustrating sequential processes to demonstrate a method for fabricating the semiconductor LED chip according to the present exemplary embodiment.

First, as shown in FIG. 10, the sapphire substrate 550 is prepared as a growth substrate. Next, as shown in FIG. 11, the n-type semiconductor layer 506, the active layer 505, and the p-type semiconductor layer 504 are sequentially formed on the sapphire substrate 550.

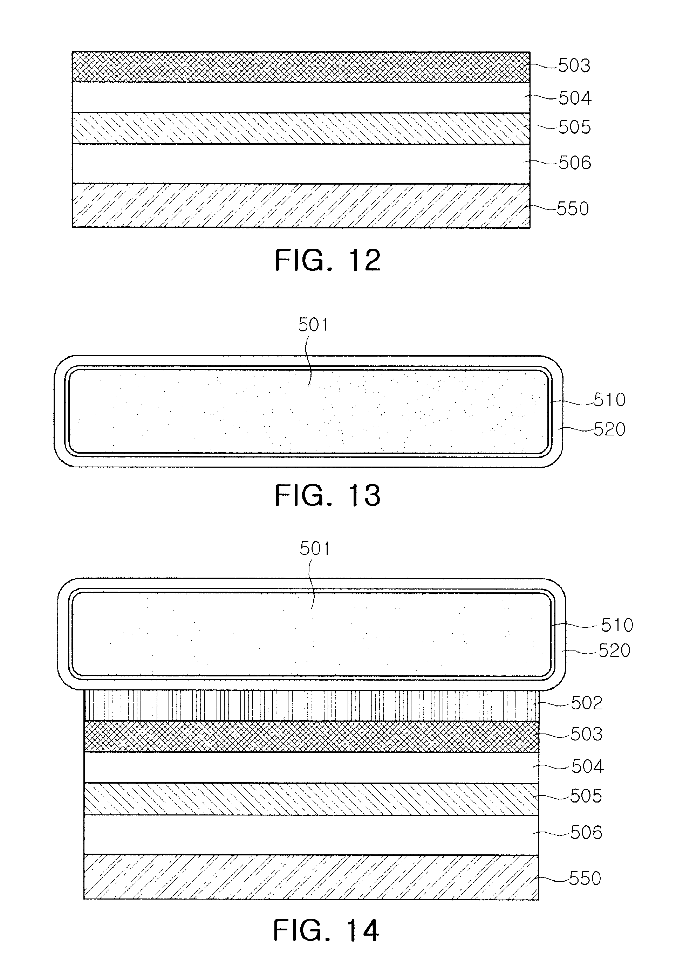

Then, as shown in FIG. 12, the reflective metal layer 503 is formed on the p-type semiconductor layer 504 by using a metallic material having high reflectance, e.g., Au, Al, Ag, Rh, or the like.

Thereafter, as shown in FIG. 13, the protective layer 520 is formed on the Si-Al alloy substrate 501. The protective layer 520 may be formed by using metal or a conductive dielectric.

Here, when the protective layer 520 is made of metal, the protective layer 520 may be made of any one selected from the group consisting of Au, Cu, W, Cr, Mo, Pt, Ru, Rh, Ti, and Ta, or an alloy of two or more among the metal group and may be formed through electroless plating, metal deposition (or metalizing), sputtering, Chemical Vapor Deposition, or the like.

In this case, when the protective layer 520 made of a metallic material is formed through electroless plating, the seed metal layer 510 may additionally be formed to serve as a seed in the plating process before the protective layer 520 is formed on the surface of the Si-Al alloy substrate 501.

Also, when the protective layer 520 is made of a conductive dielectric, the protective layer 520 may be made of ITO, IZO, CIO, or the like, and be formed through deposition, sputtering, or the like.

Preferably, the protective layer 520 may be formed to have a thickness ranging from 0.01 µm to 20 µm on the entirety of the surface of the Si-Al alloy substrate 501, and more preferably, the protective layer 520 is formed to have a thickness ranging from 1 µm to 10 µm.

If the protective layer 520 is formed to be thinner than 0.01 µm, the protective layer 520 could not properly prevent chemical damage by a chemical such as HCl, HF, KOH, or the like (to be described), while if the protective layer 520 is formed to be thicker than 20 µm, the thermal expansion coefficient of the Si-Al alloy substrate 501 would possibly be changed. Thus, the protective layer 520 is preferably formed to have a thickness within the foregoing range.

Although not shown, after the protective layer 520 is formed, the surface of the protective layer 520 may be subjected to chemical mechanical polishing (CMP) to improve a surface roughness thereof.

As described above, after the Si-Al alloy substrate 501 with the protective layer 520 formed thereon is prepared, as shown in FIG. 14, the Si-Al alloy substrate 501 with the protective layer 520 formed thereon is bonded to the reflective metal layer 503 by using the junction metal layer 502.

Here, as described above, the Si-Al substrate 501 may be bonded by using the junction metal layer 502, or the Si-Al alloy substrate 501 with the protective layer 520 formed thereon may be directly bonded to the reflective metal layer 503 without using the junction metal layer 502.

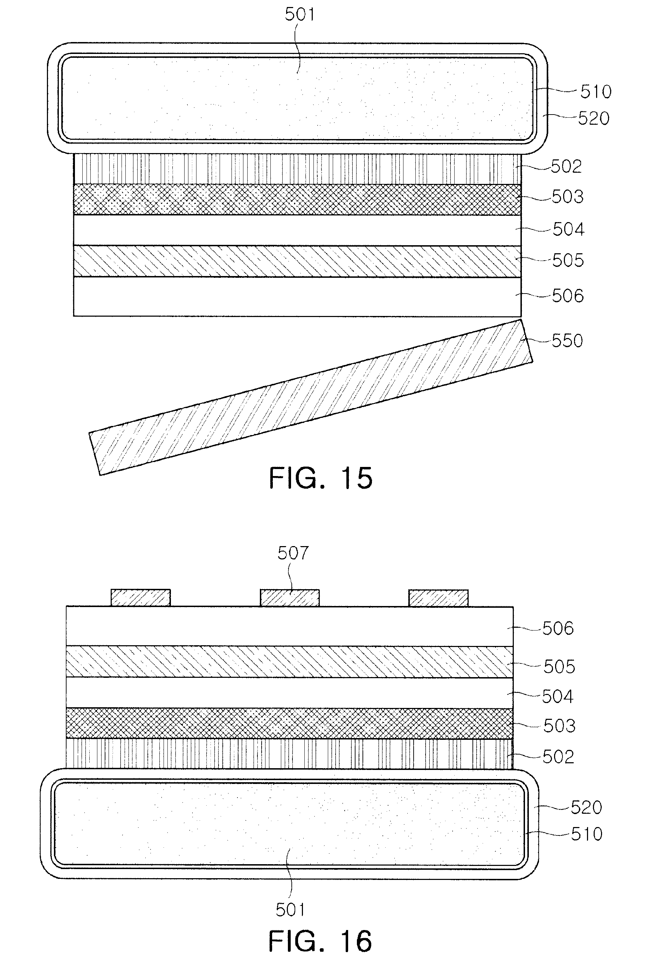

Then, as shown in FIG. 15, the sapphire substrate 550 is separated from the n-type semiconductor layer 506 through a laser lift-off (LLO) process. After the sapphire substrate 550 is separated, a cleaning process using a chemical substance such as HCl HF, KOH, or the like may be performed.

Thereafter, as shown in FIG. 16, a plurality of n-side electrodes 507 are formed on the n-type semiconductor layer 506 exposed according to the separation of the sapphire substrate 550.

Here, before the n-side electrode 507 is formed, a texturing process using KOH, or the like, may be performed on the surface of the n-type semiconductor layer 506 in order to improve light extraction efficiency of the chip.

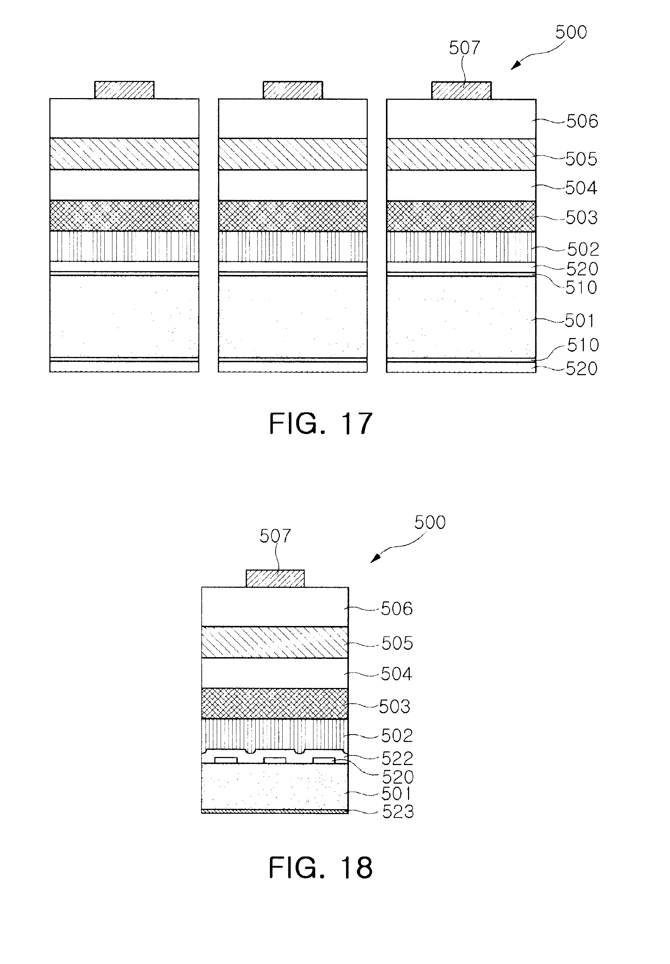

Subsequently, as shown in FIG. 17, the n-type semiconductor layer 506, the active layer 505, the p-type semiconductor layer 504, the reflective metal layer 503, the junction metal layer 502, the protective layer 520, the seed metal layer 510, and the Si-Al alloy substrate 501 between the n-side electrodes 507 are diced so as to be separated by chip (or into chips). Accordingly, the semiconductor LED chip 500 according to the present exemplary embodiment is obtained.

In this manner, in the present exemplary embodiment, the additional formation of the protective layer 520 such as Ni on the surface of the Si-Al alloy substrate 501 has the effect that the Al metal of the Si-Al alloy substrate 501 can be prevented from being etched by a chemical substance such as HCl, HF, KOH, or the like, used in the cleaning process, or KOH used in the surface-texturing process of the n-type semiconductor layer 506 performed after the sapphire substrate 550 is separated therefrom.

Thus, in the present exemplary embodiment, the surface of the Si-Al alloy substrate 501 can be prevented from becoming irregular, thus preventing the light emission structure bonded to the surface of the Si-Al alloy substrate 501 from peeling off.

In addition, when the metal such as Ni, or the like, is used to form the protective layer 520, it improves the surface roughness of the Si-Al alloy substrate 501 to advantageously solidify the junction between the Si-Al alloy substrate 501 and the light emission structure.

Namely, in the related art, before the Si-Al alloy substrate 501 is formed on the junction metal layer 502, the Si-Al alloy substrate 501 undergoes a cleaning process using a chemical substance such as an acid or the like, in order to eliminate a natural oxide film, and in this case, the surface of the Si-Al alloy substrate 501 is etched to form an irregular surface having an average size ranging from 200 nm to 500 nm (200 nm2 to 500 nm2?). However, in the present exemplary embodiment, metal, such as Ni, or the like, is formed as the protective layer 520 on the surface of the Si-Al alloy substrate 501 and then subjected to Ni CMP (Chemical Mechanical Polishing) to reduce the irregular surface to have a size of 5 nm or lower, thus improving the surface roughness as in the case of a mirror surface.

Since the surface roughness of the Si-Al alloy substrate 501 is improved, the bonding between the Si-Al alloy substrate 501 and the light emission structure can be solidified, improving the bonding yield.

A semiconductor LED chip according to a modification of the present exemplary embodiment will be described in detail with reference to FIG. 18. A description of the elements of the embodiment of FIG. 18 the same as those of the embodiment of FIG. 9 will be omitted and only different elements will be described.

FIG. 18 is a sectional view showing the structure of an LED chip according to a modification of the present exemplary embodiment.

As shown in FIG. 18, most elements of the semiconductor LED chip 500 according to the modification are the same as those of the semiconductor LED chip according to the embodiment of FIG. 9, except that the protective layer 520 is formed on the Si-Al alloy substrate 501 such that portions of the Si-Al alloy substrate 501 are exposed, rather than being formed on the entirety of the upper and lower surfaces of the Si-Al alloy substrate 501, and a conductive layer 522 is additionally formed on the protective layer 520 and on the exposed upper surface of the Si-Al alloy substrate 501, an a contact metal layer 523 is formed on a lower surface of the Si-Al alloy substrate 501.

In particular, in the semiconductor LED chip according to this modification, preferably, the protective layer 520 is made of an insulating material, rather than metal or a conductive dielectric.

Namely, in the semiconductor LED chip according to this modification, while the protective layer 520 is made of an insulating material, rather than metal or a conductive dielectric, instead, the protective layer 520 is formed on the Si-Al alloy substrate 501 such that portions thereof are exposed and the conductive layer 522 is formed on the upper surface of the Si-Al alloy substrate 501 including the protective layer 520 in order to electrically connect the Si-Al alloy substrate 501 and the light emission structure at the upper portion of the protective layer 520.

Here, the conductive layer 522 may be made of metal, or the like.

A method for manufacturing the semiconductor LED chip according to this modification will now be described in detail. A description of the same elements as those of the exemplary embodiment of FIG. 9 will be omitted and only different elements in this modification will be described.

First, as shown in FIGS. 10 to 12, the n-type semiconductor layer 506, the active layer 505, the p-type semiconductor layer 504, and the reflective metal layer 503 are sequentially formed on the sapphire substrate 550. Here, the reflective metal layer 503 may not be formed as necessary.

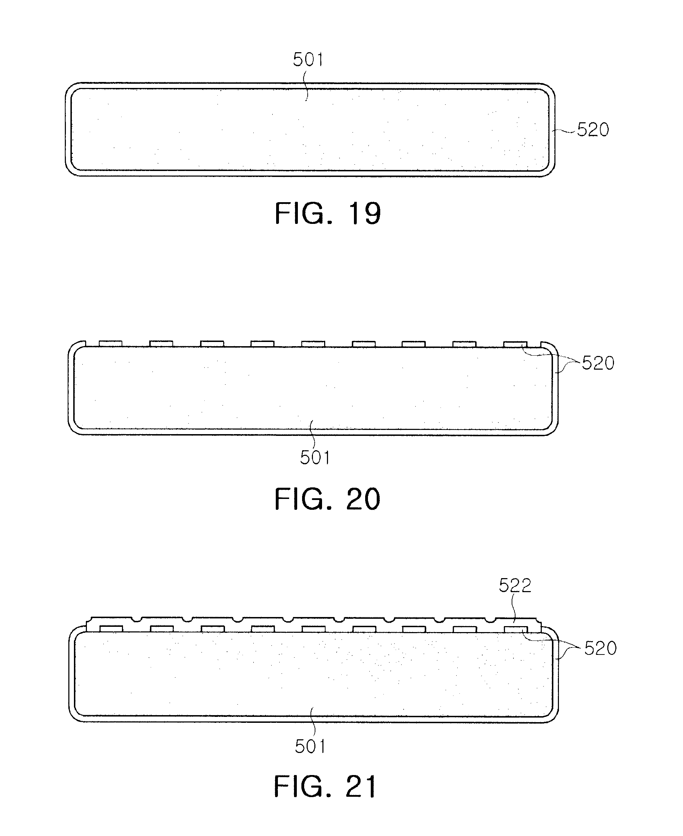

Next, as shown in FIG. 19, the protective layer 520 is formed on the entirety of the surface of the Si-Al alloy substrate 501.

Here, the protective layer 520 may be made of an insulating material. The protective layer 520 may be formed to have a thickness ranging from 0.01 µm to 1 µm.

Although not shown, after the protective layer 520 is formed, the surface of the protective layer 520 may be subjected to CMP (Chemical Mechanical Polishing).

And then, as shown in FIG. 20, portions of the protective layer 520 are removed through etching, or the like, to expose portions of the upper surface of the Si-Al alloy substrate 501.

Thereafter, as shown in FIG. 21, the conductive layer 522 is formed on the upper surface of the Si-Al alloy substrate 501 including the protective layer 520.

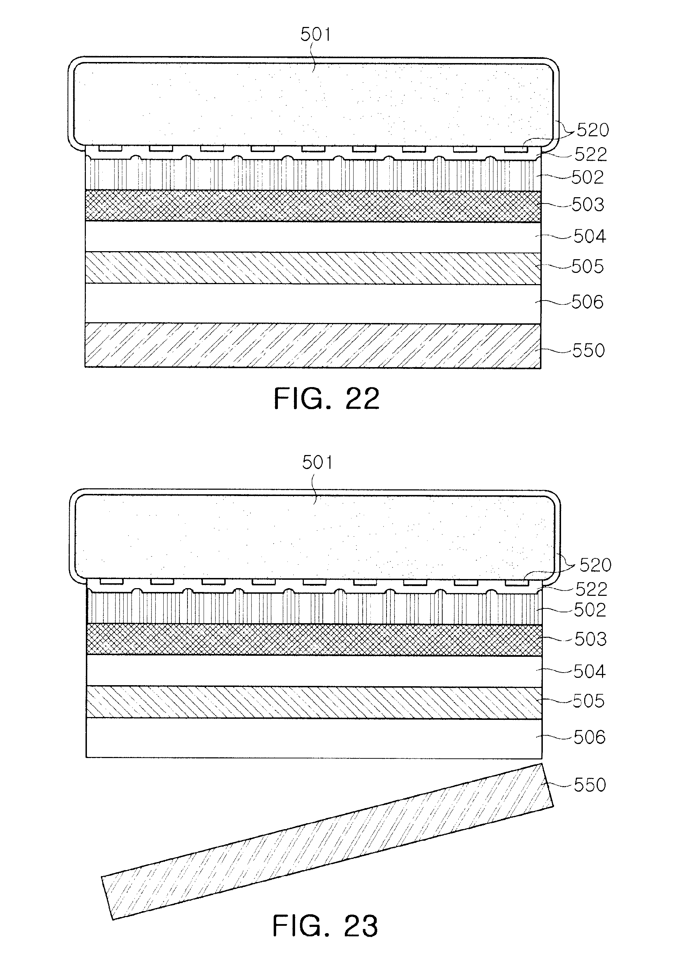

Then, as shown in FIG. 22, the conductive layer 522 formed on the upper surface of the Si-Al alloy substrate 501 is bonded to the reflective metal layer 503 by using the junction metal layer 502.

Thereafter, as shown in FIG. 23, the sapphire substrate 550 is separated from the n-type semiconductor layer 506 through a laser lift off process.

Here, after the sapphire substrate 550 is separated, a cleaning process using a chemical substance such as 11CL, HF, KOH, or the like, may be performed. In this case, according to the present exemplary embodiment, since the protective layer 520 and the conductive layer 522 are formed on the surface of the Si-Al alloy substrate 501, the Al metal of the Si-Al alloy substrate 501 can be prevented from being etched by the chemical substance used in the cleaning process.

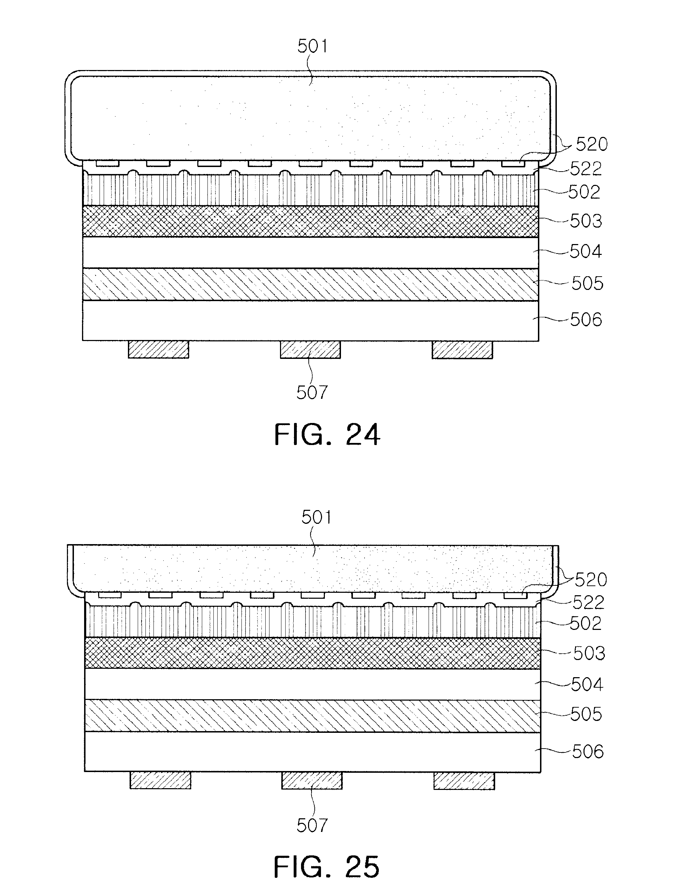

Thereafter, as shown in FIG. 24, a plurality of n-side electrodes 507 are formed on the n-type semiconductor layer 506 exposed according to the separation of the sapphire substrate 550.

Here, before the n-side electrodes 507 are formed, a texturing process using KOH, or the like, may be performed on the surface of the n-type semiconductor layer 506 in order to improve light extraction efficiency of the chip. In this case, according to the present exemplary embodiment, since the protective layer 520 and the conductive layer 522 are formed on the surface of the Si-Al alloy substrate 501, the Al metal of the Si-Al alloy substrate 501 can be prevented from being etched by the chemical substance used in the texturing process.

Thereafter, as shown in FIG. 25, a lapping process is performed to remove an amount of a lower surface of the Si-Al alloy substrate 501 including the protective layer 520 by equal to a predetermined thickness.

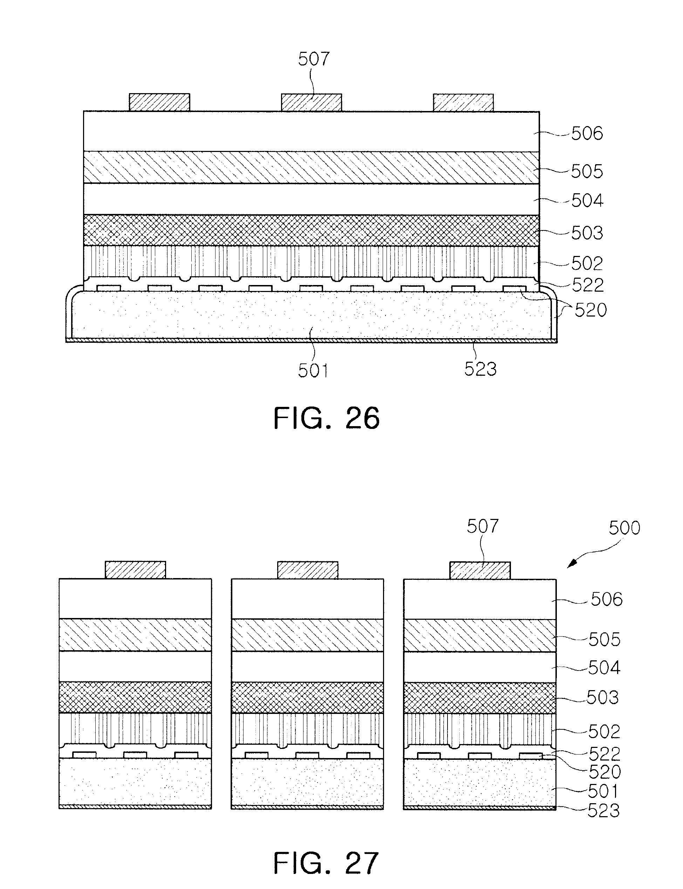

Thereafter, as shown in FIG. 26, the contact metal layer 523 is formed on the lower surface of the Si-Al alloy substrate 501 exposed through the lapping process.

Thereafter, as shown in FIG. 27, the n-type semiconductor layer 506, the active layer 505, the p-type semiconductor layer 504, the reflective metal layer 503, the junction metal layer 502, the conductive layer 522, the protective layer 520, the Si-Al alloy substrate 501, and the contact metal layer 523 between the n-side electrodes 507 are diced so as to be separated by chip (or into chips). Accordingly, the semiconductor LED chip 500 according to this modification is obtained.

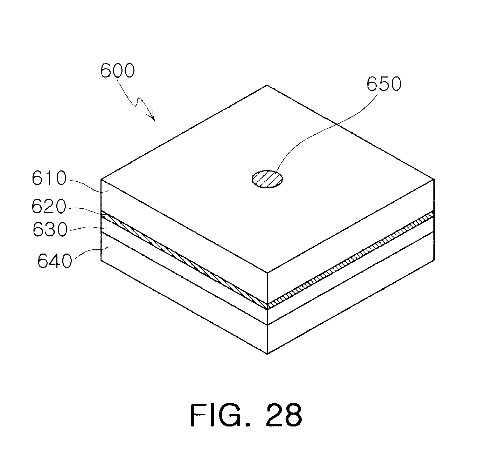

The structure of a semiconductor LED chip according to a different exemplary embodiment of the present invention will now be described with reference to FIGS. 28 to 31.

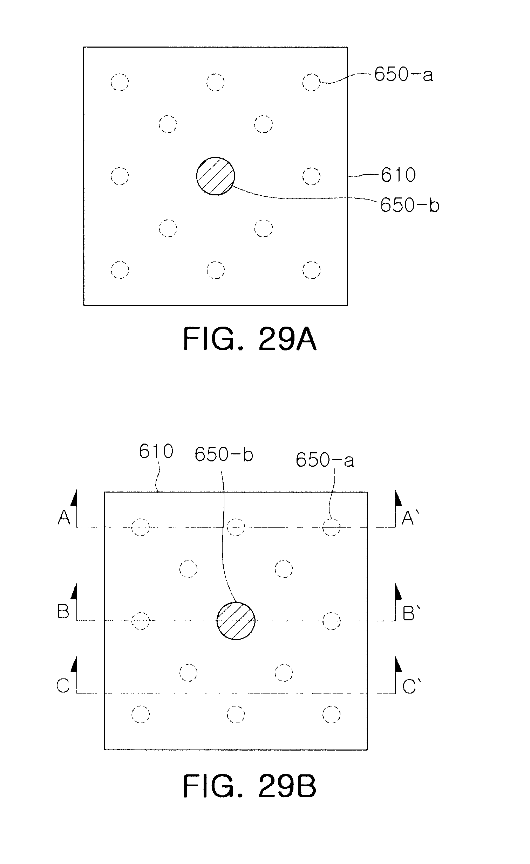

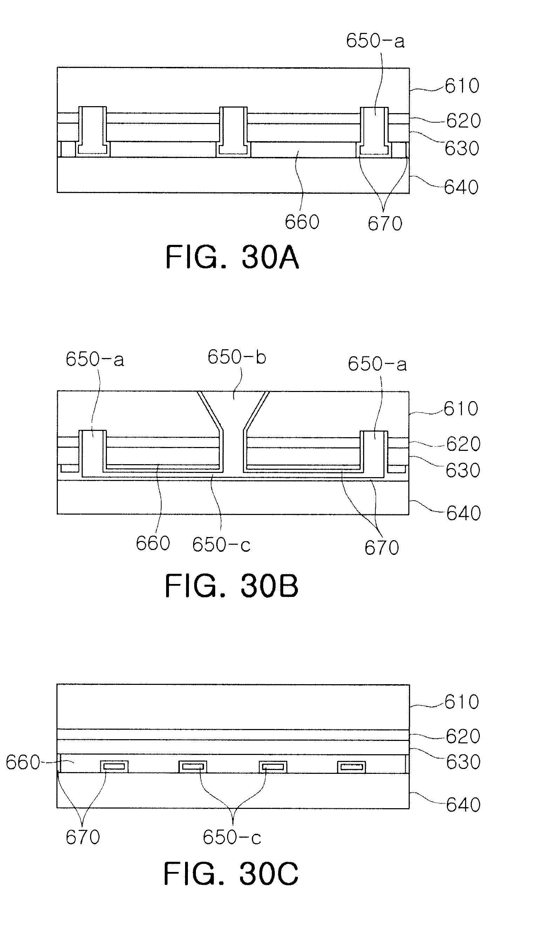

FIG. 28 is a sectional view of the semiconductor LED chip according to a different exemplary embodiment of the present invention. FIGS. 29a and 29b are plan views of the semiconductor LED chip of FIG. 29, and FIGS. 30a to 30c are sectional views of the semiconductor LED chip illustrated in FIG. 29b taken along lines A-A', B-B', and C-C', respectively.

A semiconductor LED chip 600 according to the present exemplary embodiment is formed by sequentially stacking a conductive substrate 640, a first conductive semiconductor layer 630, an active layer 520, and a second conductive semiconductor layer 610. In particular, the semiconductor LED chip 600 according to the present exemplary embodiment includes a first electrode layer 660 formed between the conductive substrate 640 and the first conductive semiconductor layer 630 and a second electrode unit 650 including an electrode pad part 650-b, an electrode extension part 650-a, and an electrode connection part 650-c.

The electrode pad part 650-b is formed to extend from the first electrode layer 660 to the surface of the second conductive semiconductor layer 610, and is electrically isolated from the first electrode layer 660, the first conductive semiconductor layer 630, and the active layer 620. The electrode extension part 650-a is formed to extend from the first electrode layer 660 to the interior of the second conductive semiconductor layer 610 and are electrically isolated from the first electrode layer 660, the first conductive semiconductor layer 630, and the active layer 620. The electrode connection part 650-c is formed on the same layer on which the first electrode layer 660 is formed, but is electrically isolated from the first electrode layer 660. The electrode connection part 650-c serves to connect the electrode pad part 650-b and the electrode extension part 650-a.

The conductive substrate 640 may be a metal substrate or a semiconductor substrate. When the conductive substrate 640 is made of metal, the metal may be any one of Au, Ni, Cu, and W and when the conductive substrate 640 is a semiconductor substrate, it may be made of any one of Si, Ge, and GaAS. In order to form the conductive substrate on the semiconductor light emitting element, a plating method for forming the substrate by forming a plating seed layer or a substrate bonding method for preparing the conductive substrate 640 and bonding it by using a conductive adhesive such as Au, Au-Sn, or Pb-Sr may be used.

The respective semiconductor layers 630 and 610 may be formed of an inorganic semiconductor such as a GaN-based semiconductor, a ZnO-based semiconductor, a GaAs-based semiconductor, a GaP-based semiconductor, or a GaAsP- based semiconductor. The semiconductor layers may be formed, for example, by using a molecular beam epitaxy (MBE) method. The semiconductor layers may also be implemented by appropriately selecting semiconductors from a group consisting of group III-V semiconductors, group II-VI semiconductors, and silicon (Si).

The active layer 620, serving to activate light emissions, is formed by using a material having an energy band gap smaller than that between the first conductive semiconductor layer 630 and the second conductive semiconductor layer 610. For example, when the first conductive semiconductor layer 630 and the second conductive semiconductor layer 610 are GaN-based compound semiconductors, the active layer 620 may be formed by using an InAlGaN-based compound semiconductor having an energy band gap smaller than that of GaN. Namely, the active layer 620 may include InxAlyGa(1-x-y)N(0≤x≤1, 0≤y≤1, 0≤x+y≤1).

In this case, in terms of the characteristics of the active layer 620, preferably, an impurity is not doped therein, and the wavelength of emitted light can be regulated by adjusting the molar ratio of constituents of the active layer 620. Thus, the semiconductor LED chip 600 is able to emit one of infrared rays, visible light, and ultraviolet rays according to the characteristics of the active layer 620.

An overall energy band diagram of the semiconductor LED chip 600 includes an energy well structure according to the active layer 620, and as electrons and holes from the respective semiconductor layers 630 and 610 move, they become captive in the energy well structure, according to which light emission can be generated more effectively.

The first electrode layer 660 electrically connects the first conductive semiconductor layer 630 to an external power source (not shown). The first electrode layer 660 may be made of metal. For example, the first electrode layer 660 may include Ti as a n-type electrode and Pd or Au as a p-type electrode.

Preferably, the first electrode layer 660 reflects light generated from the active layer 620. The reflected light proceeds to a light emission surface, increasing the luminous efficiency of the semiconductor LED chip. In order to reflect light generated from the active layer 620, preferably, the first electrode layer 660 is made of metal of white series in a visible light area. For example, the first electrode layer 660 may be made of any one of Ag, Al, and Pt. The first electrode layer 660 will be described later with reference to FIGS. 30a to 30c.

The second electrode unit 650 electrically connects the second conductive semiconductor layer 610 to an external power source (not shown). The second electrode unit 650 may be made of metal. The second electrode unit 650 may include Ti as an n-type electrode and Pd or Au as a p-type electrode. In particular, the second electrode unit 650 according to the present exemplary embodiment includes the electrode pad part 650-b, the electrode extension part 650-a, and the electrode connection part 650-c.

With reference to FIG. 29a, the electrode pad part 650-b is formed on the surface of the second conductive semiconductor layer 610, and the plurality of electrode extension parts 650-a, denoted by dotted lines, are positioned in the interior of the second conductive semiconductor layer 610.

FIG. 29b shows the upper surface of the second conductive semiconductor layer 610 illustrated in FIG. 29a taken along lines A-A', B-B', and C-C'. Line A-A' is selectively taken to show the section including only the electrode extension parts 650-a, B-B' is selectively taken to show the section including the electrode pad part 650-b and the electrode extension parts 650-a, and C-C' is selectively taken to show the section not including the electrode extension part 650-a and the electrode pad part 650-b.

FIGS. 30a to 30c are sectional views of the semiconductor LED chip illustrated in FIG. 29b taken along lines A-A', B-B', and C-C'. The semiconductor LED chip will now be described with reference to FIGS. 28, 29a, 29b, and 30a to 30c.

In FIG. 30a, the electrode extension part 650-a extends from the first electrode layer 660 to the interior of the second conductive semiconductor layer 610. The electrode extension part 650-a, passing through the first conductive semiconductor layer 630 and the active layer 620, extends up to the second conductive semiconductor layer 610, and in this case, the electrode extension part 650-a extends to at least a portion of the second conductive semiconductor layer 610, rather than reaching the surface of the second conductive semiconductor layer 610 like the electrode pad part 650-b does, because the electrode extension part 650-a is aimed to distribute current in the second conductive semiconductor layer 610.

Since the electrode extension part 650-a serves to distribute current in the second conductive semiconductor layer 610, it is required to have a certain area. In this case, because the electrode extension part 650-a is not used for an electrical connection like the electrode pad part 650-b does, preferably, a certain number of electrode extension parts 650-a are formed to have an area sufficiently small as to allow current to be uniformly distributed within the second semiconductor layer 610. If the number of electrode extension parts 650-a is too small, current distribution could not be easily performed to degrade electrical characteristics, whereas if the number of the electrode extension parts 650-a is too large, the process for forming the large number of electrode extension parts would be difficult and the active layer would be reduced, resulting in a reduction in a light emission area. Thus, the number of electrode extension parts may be appropriately selected in consideration of such conditions. That is, the electrode extension parts 650-a are implemented to have a configuration such that they occupy the area formed to be as small as possible and have an effective shape for current distribution.

Preferably, a plurality of electrode extension parts 650-a are provided for current distribution. Also, the electrode extension part 650-a may have a cylindrical shape. Preferably, the area of the cylindrical electrode extension part 650-a is smaller than that of the electrode pad part 650-b. The electrode extension parts 650-a may be formed to be spaced apart from the electrode pad part 650-b. Since the electrode extension parts 650-a can be connected by the electrode connection part 650-c on the first electrode layer 660, so they are required to be spaced apart by a certain distance to induce a uniform current distribution.

The electrode extension parts 650-a are formed to extend from the first electrode layer 660 to reach even the interior of the second conductive semiconductor layer 610, and since the electrode extension parts 650-a are formed to serve to distribute current, they are required to be electrically isolated from the other layers. Thus, preferably, the electrode extension parts 650-a are electrically isolated from the first electrode layer 660, the first conductive semiconductor layer 630, and the active layer 620. The electrical isolation may be performed by using an insulating material such as a dielectric, or the like.

In FIG. 30b, the electrode pad part 650-b extends from the first electrode layer 660 up to the surface of the second conductive semiconductor layer 610. The electrode pad part 650-b starts to be formed from the first electrode layer 660 and extends to reach the surface of the second conductive semiconductor layer 610 through the first conductive semiconductor layer 630, the active layer 620, and the second conductive semiconductor layer 610. In particular, the electrode pad part 650-b is aimed at connecting the second electrode part 650 to an external power source (not shown), so the second electrode part 650 may include at least one electrode pad part 650-b.

The electrode pad part 650-b extends from the first electrode layer 660 up to the surface of the second conductive semiconductor layer 610. The electrode pad part 650-b is electrically connected to an external power source on the surface of the second conductive semiconductor layer 610, to supply current to the electrode extension parts 650-a, so preferably, it is electrically isolated from the first electrode layer 660, the first conductive semiconductor layer 630, and the active layer 620. The electrical isolation may be performed by forming an insulating layer by using an insulating material such as a dielectric, or the like.

The electrode pad part 650-b serves to supply current to the electrode extension parts 650-a, and besides, since the electrode pad part 650-b is not electrically isolated from the second conductive semiconductor layer 610, it can directly distribute current. In consideration of a required function among the function of supplying current to the electrode extension parts 650-a and the function of distributing current to the second semiconductor layer 610, the electrode pad part 650-b can be appropriately electrically isolated from the second conductive semiconductor layer 610.

Preferably, the area of the section of the electrode pad part 650-b in the active layer 620 is smaller than the area of the section of the electrode pad part 650-b on the surface of the second conductive semiconductor layer 610. This is to secure the active layer 620 to be as large as possible to increase luminous efficiency. However, the electrode pad part 650-b is required to have a certain area on the surface of the second conductive semiconductor layer 610, so as to be connected to an external power source (not shown).

The electrode pad part 650-b may be positioned at the center of the semiconductor LED chip 600, and in this case, the electrode extension parts 650-a may be spaced apart from the electrode pad part 650-b and evenly distributed to be positioned. With reference to FIG. 29a, the electrode pad part 650-b and the electrode extension parts 650-a are evenly distributed to be positioned on the second conductive semiconductor layer 610 to optimize current distribution. In FIG. 29a, one electrode pad part 650-b and twelve electrode extension parts 650-a are formed as illustrated, but the number of the electrode pad parts 650-b and the electrode extension parts 650-a may be appropriately selected in consideration of an electrical connectivity situation (e.g., current distribution situation such as the location of an external power source, the thickness of the second conductive semiconductor layer 610, and the like).

When the plurality of the electrode extension parts 650-a are provided, the electrode pad part 650-b and the plurality of electrode extension parts 650-a may be directly connected. In this case, the electrode pad part 650-2 may be formed on the central portion of the semiconductor light emitting element 600 (or the semiconductor LED chip 600), the electrode extension parts 650-a may be positioned around the electrode pad part 650-b, and the electrode connection part 650-c may directly connect the electrode pad part 650-b and the electrode extension parts 650-a in a radial manner.

Alternatively, some of the plurality of the electrode extension parts 650-a may be directly connected to the electrode pad part 650-b and the other may be connected to the electrode extension parts 650-a directly connected to the electrode pad part 650-b; namely, the other electrode extension parts 650-a may be indirectly connected to the electrode pad part 650-b. In this case, a larger number of electrode extension parts 650-a can be formed to improve the efficiency of the current distribution.

In FIGS. 30a to 30c, the electrode connection part 650-c is formed on the first electrode layer 660 to connect the electrode pad part 650-b and the electrode extension parts 650-a. Accordingly, a considerable amount of portions of the second electrode unit 650 are positioned on a rear surface opposed to the direction in which light from active layer 620, which emits light, proceeds, thus increasing luminous efficiency. In particular, in FIG. 30c, only the electrode connection parts 650-c are positioned on the first electrode layer 660, so the second electrode unit 650 is not positioned on the first conductive semiconductor layer 630, the active layer 620, and the second conductive semiconductor layer 610. Accordingly, in the case illustrated in FIG. 30c, the electrode pad part 650-b and the electrode extension parts 650-a do not affect light emission, increasing luminous efficiency. In FIG. 30c, in particular, the first electrode layer 660 is in contact with the conductive substrate 640 so as to be connected to an external power source (not shown).

The electrode connection parts 650-c are electrically isolated from the first electrode layer 660. The first electrode layer 660 and the second electrode part 650 are electrodes having mutually opposite polarities and supplying external power to the first conductive semiconductor layer 630 and the second conductive semiconductor layer 610, respectively, so the both must necessarily be electrically separated. The electrical isolation thereof may be achieved by using an insulating material such as a dielectric, or the like.

In FIG. 30b, since the electrode pad part 650-b is positioned on the surface of the second conductive semiconductor layer 610, the characteristics of a vertical-type semiconductor LED chip can be obtained, and in FIG. 30c, the electrode connection part 650-c is positioned on the same plane on which the first electrode layer 660 is positioned, the characteristics of a horizontal-type semiconductor LED chip can be obtained. Accordingly, the semiconductor LED chip 600 can have the structure incorporating the horizontal-type and vertical-type semiconductor LED chips.

In FIGS. 30a to 30c, the second conductive semiconductor layer may be an n-type semiconductor layer, and the second electrode unit may be an n-type electrode unit. In this case, the first conductive semiconductor layer 630 may be a p-type semiconductor layer, and the first electrode layer 660 may be a p-type electrode. The electrode pad part 650-b, the electrode extension parts 650-a, and the electrode connection part 650-c constitute the second electrode unit 650 (namely, the electrode pad part 650-b, the electrode extension parts 650-a, and the electrode connection part 650-c are connected second electrode parts), and when the second electrode unit 650 is an n-type electrode, an insulating part 670 may be formed with an insulating material to electrically isolate the second electrode unit 650 from the first electrode layer 660, the p-type electrode.

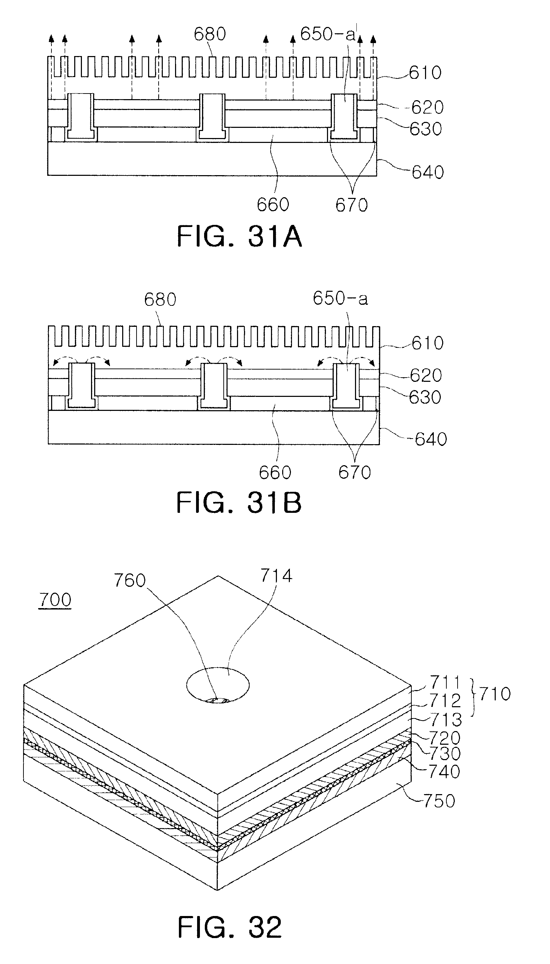

FIG. 31a illustrates light emission of a semiconductor LED chip having a depression and protrusion pattern 680 formed thereon according to a different exemplary embodiment of the present invention, and FIG. 31b illustrates current distribution in the semiconductor LED chip with the depression and protrusion pattern 680 formed thereon according to the different exemplary embodiment of the present invention.

In the semiconductor LED chip 600 according to the present exemplary embodiment, the second conductive semiconductor layer 610 is configured to be the outermost surface in the direction in which emitted light proceeds. Thus, the depression and protrusion pattern can be easily formed on the surface of the second conductive semiconductor layer 610 by using a conventionally known method, such as photolithography, or the like. In this case, light emitted from the active layer 620 is extracted upon passing through the depression and protrusion pattern 680 formed on the surface of the second conductive semiconductor layer 610, and light extraction efficiency can be increased by the depression and protrusion pattern 680.

The depression and protrusion pattern 680 may have a photonic crystal structure. In the photonic crystal structure, mediums, each having a different refractive index, are regularly arranged like crystals, and such photonic crystals allow for light regulation by unit of the length of the multiple of the wavelength of light, further increasing light extraction efficiency. The photonic crystal structure can be formed through a certain appropriate process after the second conductive semiconductor layer 610 and up to the second electrode unit 650 are fabricated. For example, the photonic crystal structure may be formed through an etching process.

Although the depression and protrusion pattern 680 is formed on the second conductive semiconductor layer 610, current distribution is not affected. With reference to FIG. 31b, the distribution of current in the electrode extension parts 650-a is not affected by the depression and protrusion pattern 680. The respective electrode extension parts 650-a distribute current under the depression and protrusion pattern 680, and the depression and protrusion pattern 680 extracts emitted light to thus increase luminous efficiency.

The structure of an LED chip according to a different exemplary embodiment of the present invention will now be described with reference to FIGS. 32 to 37.

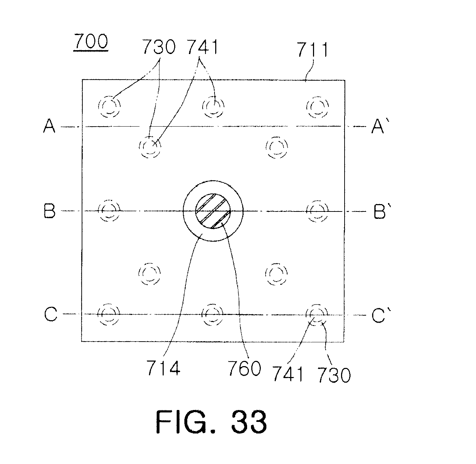

FIG. 32 is a perspective view of a semiconductor LED chip according to a different exemplary embodiment of the present invention, and FIG. 33 is a plan view of the semiconductor LED chip of FIG. 32. The semiconductor LED chip according to a different exemplary embodiment of the present invention will now be described with reference to FIGS. 32 and 33.

A semiconductor LED chip 700 according to a different exemplary embodiment of the present invention is formed by sequentially stacking a first conductive semiconductor layer 711, an active layer 712, a second conductive semiconductor layer 713, a second electrode layer 720, a first insulating layer 730, a first electrode layer 740, and a conductive substrate 750. In this case, the second electrode layer 720 includes an exposed portion of the interface between the second conductive semiconductor layer 713 and the first electrode layer 740 is electrically connected to the first conductive semiconductor layer 711 and electrically insulated from the second conductive semiconductor layer 713 and the active layer 712, thereby forming one or more contact holes 741 extending from one surface of the first electrode layer 740 up to at least a portion of the first conductive semiconductor layer 711.

Light emission of the semiconductor LED chip 700 is performed by the first conductive semiconductor layer 711, the active layer 712, and the second conductive semiconductor layer 713, so these layers will be referred to as a light emission stacked body 710. Namely, the semiconductor light emitting element 700 includes the light emission stacked body 710, the first electrode layer 740 electrically connected to the first conductive semiconductor layer 711, the second electrode layer 720 electrically connected to the second conductive semiconductor layer 713, and the first insulating layer 730 for electrically insulating the electrode layers 720 and 740. Further, the semiconductor light emitting element 700 includes a conductive substrate 750 for growing or supporting the semiconductor LED chip 700.

The semiconductor layers 711 and 713 may include, for example, a GaN-based semiconductor, a ZnO-based semiconductor, a GaAs-based semiconductor, a GaP-based semiconductor, or a GaAsP-based semiconductor. The semiconductor layers may be formed, for example, by using a molecular beam epitaxy (MBE) method. Besides, the semiconductor layers may be implemented by appropriately selecting semiconductors from a group consisting of group III-V semiconductors, group II-VI semiconductors, and silicon (Si). The semiconductor layers 711 and 713 are doped with appropriate impurities in consideration of their conductivity types.

The active layer 712, serving to activate light emissions, is formed by using a material having an energy band gap smaller than that of the first conductive semiconductor layer 711 and the second conductive semiconductor layer 712. For example, when the first conductive semiconductor layer 711 and the second conductive semiconductor layer 712 are GaN-based compound semiconductors, the active layer 712 may be formed by using an InAlGaN-based compound semiconductor having an energy band gap smaller than that of GaN. Namely, the active layer 712 may include InxAlyGa(1-x-y)N(0≤x≤1, 0≤y≤1, 0≤x+ y≤1).

In this case, in terms of the characteristics of the active layer 712, preferably, an impurity is not doped therein, and the wavelength of emitted light can be regulated by adjusting the molar ratio of constituents of the active layer 712. Thus, the semiconductor LED chip 700 is able to emit one of infrared rays, visible light, and ultraviolet rays according to the characteristics of the active layer 712.

The electrode layers 720 and 740 are layers for applying voltage to semiconductor layers having the same conductive type, respectively, so they may include metal in consideration of their electric conductivity. Namely, the electrode layers 720 and 740 are electrodes for electrically connecting the semiconductor layers 711 and 713 and an external power source (not shown). The electrode layers 720 and 740 may include, for example, Ti as an n-type electrode and Pd or Au as a p-type electrode.

The first electrode layer 740 is connected to the first conductive semiconductor layer 711, and the second electrode layer 720 is connected to the second conductive semiconductor layer 713, respectively, so the first and second electrode layers 740 and 720 are electrically isolated by the first insulating layer 730 in terms of their characteristics of being connected to different conductivity types. Preferably, the first insulating layer 730 is made of a material having low electric conductivity, so it may include, for example, an oxide such as Si02.

Preferably, the second electrode layer 720 reflects light generated from the active layer 712. Since the second electrode layer 720 is positioned at a lower side of the active layer 712, it is positioned at the side opposite to the light emission direction of the semiconductor light emitting element 700 based on the active layer 712. Thus, light proceeding from the active layer 712 to the second electrode layer 720 is the opposite to the light emission direction of the semiconductor LED chip 700, and light proceeding to the second electrode layer 720 must be reflected to increase the luminous efficiency. Thus, when the second electrode layer 720 exhibits light reflective properties, reflected light proceeds to the light emission surface, thus increasing the luminous efficiency of the semiconductor LED chip 700.

In order to reflect light generated from the active layer 712, the second electrode layer 720 is made of metal of white series in a visible light area. For example, the second electrode layer 720 may be made of any one of Ag, Al, and Pt. The first electrode layer 740 includes an exposed portion of the interface thereof with the second conductive semiconductor layer 713. A lower surface of the first electrode layer 740 is in contact with the conductive substrate 750, and is electrically connected to an external power source (not shown) through the conductive substrate 750. However, in order for the second electrode layer 720 to be connected to an external power source (not shown), it requires a connection area. Thus, the second electrode layer 720 has the area exposed as a portion of the light emission stacked body 710 is etched, or the like.

In FIG. 32, a via hole 714 is illustrated to be formed as a central portion of the light emission stacked body 710 is etched to form the exposed portion of the second electrode layer 720. An electrode pad part 760 may be formed on the exposed area of the second electrode layer 720. The second electrode layer 720 can be electrically connected to an external power source (not shown) through the exposed area, and in this case, the second electrode layer 720 is connected to the external source by using the electrode pad part 760. The connection of the second electrode layer 720 to the external power source (not shown) may be made by using, for example, a wire, so preferably, the diameter of the via hole 714 is increased toward the first conductive semiconductor layer from the second electrode layer 720.

In performing etching to form the via hole 714, selective etching is performed such that only the light emission stacked body 710 including a semiconductor material is etched and the second electrode layer 720 generally including metal is not etched. The diameter of the via hole 714 may be appropriately selected by a person skilled in the art to which the present invention pertains in consideration of an electrical connection efficiency and current distribution in the second electrode layer 720.

The first electrode layer 740 includes one or more contact holes 741 electrically connected to the first conductive semiconductor layer 711 and electrically insulated from the second conductive semiconductor layer 713 and the active layer 712 and extending up to at least a portion of the first conductive semiconductor layer 711. The first electrode layer 740 is electrically connected to the first conductive semiconductor layer 711 and electrically insulated from the second conductive semiconductor layer 713 and the active layer 712, thereby forming one or more contact holes 741 extending up to at least a portion of the first conductive semiconductor layer 711. In order to electrically connect the first conductive semiconductor layer 711 to an external power source (not shown), the first electrode layer 740 includes one or more contact holes 741 which extends to the first conductive semiconductor layer 711 through the second electrode layer between the first electrode layer 740 and the second conductive semiconductor layer 713, the second conductive semiconductor layer 713, and the active layer 712 and includes an electrode material.

When the contact holes 741 are used only for an electrical connection, the first electrode layer 740 may include only a single contact hole 741, but for an even distribution of current transferred to the first conductive semiconductor layer 711, the first electrode layer 740 may include a plurality of contact holes 741 at certain positions.

The conductive substrate 740 is formed to be in contact with the second electrode layer 720 and electrically connected thereto. The conductive substrate 750 may be a metal substrate or a semiconductor substrate. When the conductive substrate 740 is a metal substrate, it may be made of any one of metals among Au, Ni, Cu, and W. Also, when the conductive substrate 750 is a semiconductor substrate, it may be made of any one among Si, Ge, and GaAs. The conductive substrate 750 may be a growth substrate, or may be a support substrate bonded upon removing a non-conductive substrate such as a sapphire substrate having a relatively low lattice mismatch after it is used as a growth substrate.

When the conductive substrate 740 is a support substrate, it may be formed by using a plating method or a substrate bonding method. In detail, in order to form the conductive substrate 750 on the semiconductor LED chip 700, a plating method for forming a substrate by forming a plating seed layer or a substrate bonding method for preparing the conductive substrate 750 and bonding it by using a conductive adhesive such as Au, Au-Sn, or Pb-Sr may be used.

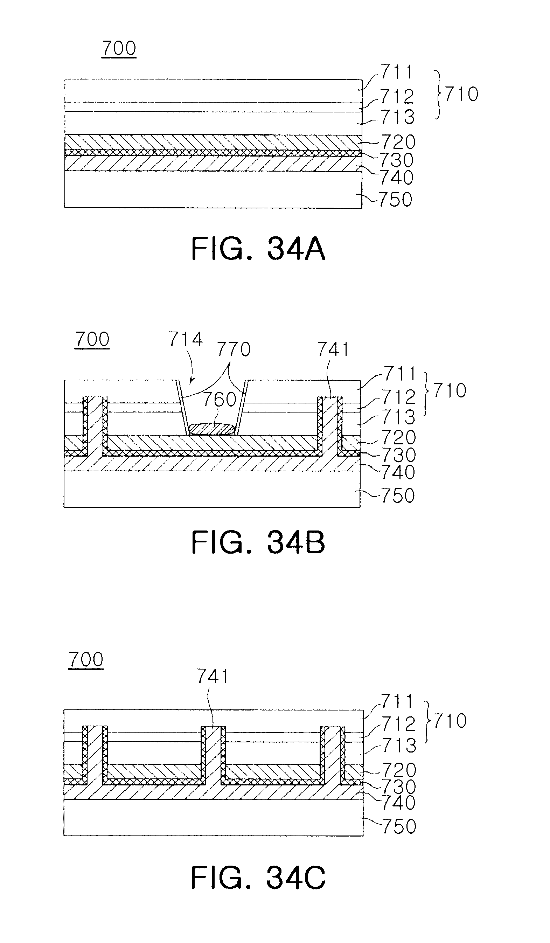

FIG. 33 is a plan view of the semiconductor LED chip 700. The via hole 714 is formed on the upper surface of the semiconductor LED chip 700, and the electrode pad part 760 is positioned on the exposed area formed on the second electrode layer 720. In addition, although not shown on the upper surface of the semiconductor LED chip 700, the contact holes 741 are illustrated with dotted lines in order to show the positions of the contact holes 741. In order to electrically isolate the contact holes 741 from the second electrode layer 720, the second conductive semiconductor layer 713, and the active layer 712, the first insulating layer 730 may extend to the circumference. This will be described further with reference to FIGS. 34b and 34c.

FIGS. 34a to 34c are sectional views of the semiconductor LED chip of FIG. 33 taken along lines A-A', B-B', and C-C', respectively. Line A-A' is selectively taken to show the section of the semiconductor LED chip 700, B-B' is selectively taken to show the section including the contact holes 741 and the via hole 714, and C-C' is selectively taken to show the section only including the contact holes 741. Hereinafter, the semiconductor LED chip will be described with reference to FIGS. 34a to 34c.

With reference to FIG. 34c, the contact hole 741 and the via hole 714 are not shown. The contact hole 741 is not connected through a connection line but is electrically connected through the first electrode layer 740, it is not shown in the section A-A' in FIG. 33. With reference to FIGS. 34b and 34c, the contact hole 741 extends from the interface between the first electrode layer 740 and the second electrode layer 720 to the interior of the first conductive semiconductor layer 711. The contact hole 741 extends up to the first conductive semiconductor layer 711 through the second conductive semiconductor layer 713 and the active layer 712, and extends at least to the interface between the active layer 712 and the first conductive semiconductor layer 711. Preferably, the contact hole 741 extends up to a portion of the first conductive semiconductor layer 711. In this case, the contact hole 730 provides for an electrical connection and current distribution, so it is only required to be in contact with the first conductive semiconductor layer 711 without having to extend even up to the outer surface of the first conductive semiconductor layer 711.

Since the contact hole 741 serves to distribute current in the first conductive semiconductor layer 711, it is required to have a certain area. Preferably, a certain number of the contact holes 730 are formed to have an area sufficiently small as to allow current to be uniformly distributed within the first semiconductor layer 711. If the number of the contact holes 741 is too small, current distribution may be difficult, thereby degrading electrical characteristics, whereas if the number of the contact holes 741 is too large, the process for forming the large number of electrode extension parts will be difficult and the active layer would be reduced to result in a reduction in a light emission area. Thus, the number of the contact holes 741 may be appropriately selected in consideration of such conditions. That is, the contact holes 741 are implemented with a configuration such that they occupy as small an area as possible and have a shape effective for current distribution.

The contact hole 741 is formed to extend from the second electrode layer 720 up to the first conductive semiconductor layer 711, and in this case, since the contact hole 741 distributes current on the first conductive semiconductor layer 711, it is required to be electrically isolated from the second conductive semiconductor layer 713 and the active layer 712. Thus, preferably, the contact hole 741 is electrically isolated from the second electrode layer 720, the second conductive semiconductor layer 713, and the active layer 712. Thus, the first insulating layer 730 may extend while covering the circumference of the contact hole 130. The electrical isolation may be performed by using an insulating material such as a dielectric, or the like.

In FIG. 34b, the exposed area of the second electrode layer 720 is an area for an electrical connection to an external power source (not shown) of the second electrode layer 720. The electrode pad part 760 may be positioned on the exposed area. In this case, a second insulating layer 770 is formed on an inner side surface of the via hole 714 to electrically isolate the light emission stacked body 710 and the electrode pad part 760.

In FIG. 34a, since the first electrode layer 740 and the second electrode layer 720 are positioned on the same plane, the semiconductor LED chip 700 can exhibit the characteristics of a horizontal-type semiconductor LED chip, and in FIG. 34b, since the electrode pad part 760 is positioned on the first conductive semiconductor layer 711, the semiconductor LED chip 700 can exhibit the characteristics of a vertical-type semiconductor LED chip. Accordingly, the semiconductor LED chip 700 has the structure incorporating the horizontal-type and the vertical-type chips.

In FIGS. 34a to 34c, the first conductive semiconductor layer 711 may be an n-type semiconductor layer, and the first electrode layer 740 may be an n-type electrode. In this case, the second conductive semiconductor layer 713 may be a p-type semiconductor layer and the second electrode layer 720 may be a p-type electrode. Accordingly, the first electrode layer 740 as the n-type electrode and the second electrode layer 720 as the p-type electrode may be electrically insulated from the first insulating layer 730 interposed therebetween.

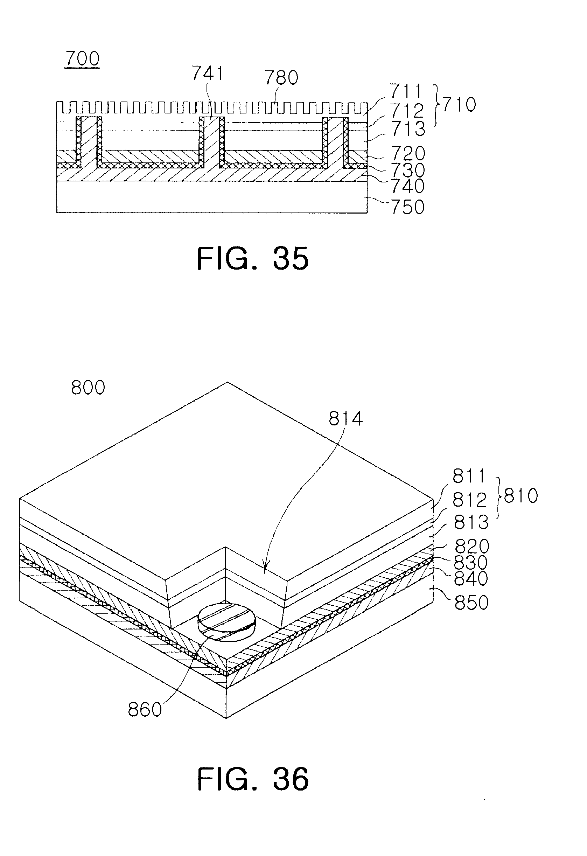

FIG. 35 illustrates light emission of the semiconductor LED chip having a depression and protrusion pattern formed in the surface thereof according to an exemplary embodiment of the present invention. A description of the same elements as described above will be omitted.

In the semiconductor LED chip 700 according to the present exemplary embodiment, the second conductive semiconductor layer 711 is configured to be the outermost surface in the direction in which emitted light proceeds. Thus, a depression and protrusion pattern 780 can be easily formed on the surface of the first conductive semiconductor layer 711 by using a conventionally known method, such as photolithography, or the like. In this case, light emitted from the active layer 712 is extracted upon passing through the depression and protrusion pattern 780 formed on the surface of the first conductive semiconductor layer 711, and the light extraction efficiency can be increased by the depression and protrusion pattern 780.

The depression and protrusion pattern 780 may have a photonic crystal structure. In the photonic crystal structure, mediums, each having a different refractive index, are regularly arranged like crystals, and such photonic crystals allow for light regulation by unit of the length of the multiple of the wavelength of light, further increasing the light extraction efficiency.

FIG. 36 illustrates an exposure of the second electrode layer at the corner of the semiconductor LED chip according to the present exemplary embodiment.

According to another aspect of the present invention, there is provided a method for fabricating a semiconductor LED chip including: sequentially stacking a first conductive semiconductor layer 811, an active layer 812, a second conductive semiconductor layer 813, a second electrode layer 820, an insulating layer 830, a first electrode layer 840, and a conductive substrate 850; forming an exposed area on a portion of the interface between the second electrode layer 820 and the second conductive semiconductor layer 813; and forming one or more contact holes 841 extending from one surface of the first electrode layer 840 up to at least a portion of the first conductive semiconductor layer 811 such that the first electrode layer 840 is electrically connected to the first conductive semiconductor layer 811 and electrically insulated from the second conductive semiconductor layer 813 and the active layer 812.

In this case, the exposed area of the second electrode layer 820 may be formed by forming a via hole 814 in the light emission stacked body 710 (See FIG. 32), or as shown in FIG. 34, the light emission stacked body 810 may be mesa-etched to form the exposed area of the second electrode layer 820. In the present exemplary embodiment, a description of elements the same as those described above with reference to FIG. 32 will be omitted.

With reference to FIG. 36, one corner of the semiconductor LED chip 800 is mesa-etched. The etching is performed on the light emission stacked body 810 to allow the second electrode layer 820 to be exposed from the interface with the second conductive semiconductor layer 813. Accordingly, the exposed area of the second electrode layer 820 is formed on the corner of the semiconductor LED chip 800. The formation of the exposed area at the corner is a simpler process than the formation of the via hole in the former exemplary embodiment and facilitates a follow-up electrical connection process.

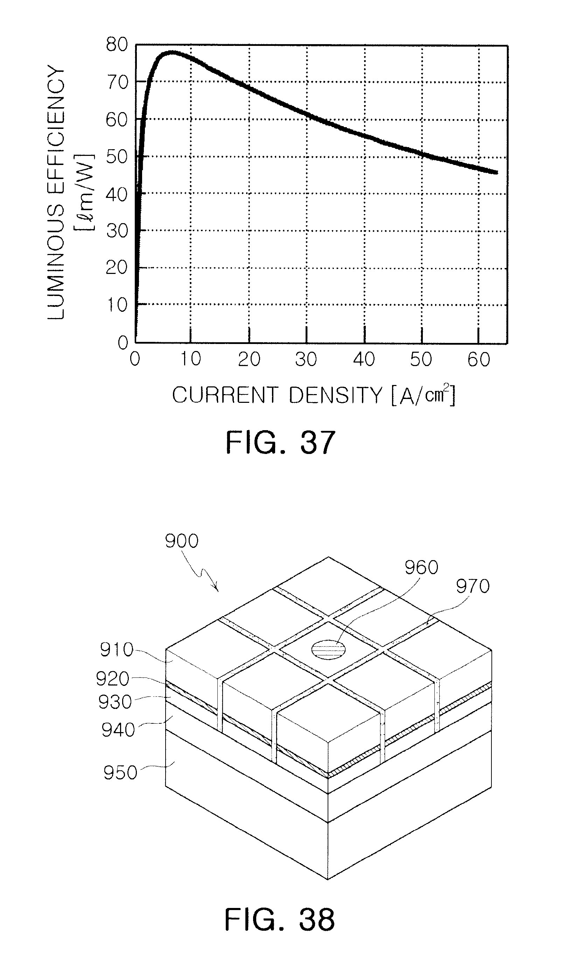

FIG. 37 is a graph of luminous efficiency over current density of the light emission surface. In the graph, the current density is about 10 A/cm2.

Table 1 below shows numerical values of this tendency together with light emission areas.

**[Table 1]**

| Light emission area (cm2) | Current density (A/cm2) | Luminous efficiency (1m/W) | Enhancement rate |
|---|---|---|---|
| 0.0056 | 62.5 | 46.9 | 100 |
| 0.0070 | 50.0 | 51.5 | 110 |
| 0.0075 | 46.7 | 52.9 | 113 |
| 0.0080 | 43.8 | 54.1 | 115 |

It is noted that the luminous efficiency is improved as the light emission area is increased, but in order to secure a light emission area, the area of distributed electrodes needs to be reduced, so the current density of the light emission surface tends to be reduced. The reduction in the current density of the light emission surface may negatively effect the electrical characteristics of the semiconductor light emitting element.

However, such a problem can be resolved by securing current distribution using an electrode extension part according to the present exemplary embodiment. Thus, the problem of the electrical characteristics possibly caused by the reduction in the current density can be overcome by forming an electrode extension part in the interior, rather than being formed up to the light emission surface, to handle current distribution. Accordingly, the semiconductor LED chip according to the present exemplary embodiment can obtain a desirable luminous efficiency by securing a maximum light emission area while acquiring an intended degree of current distribution.

The structure of an LED chip according to a different exemplary embodiment of the present invention will now be described with reference to FIGS. 38 to 41.

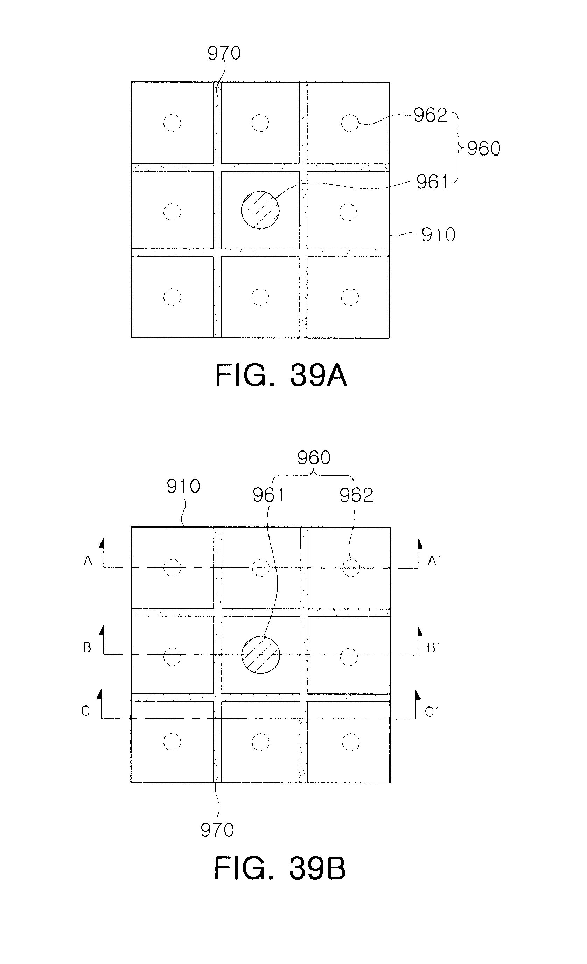

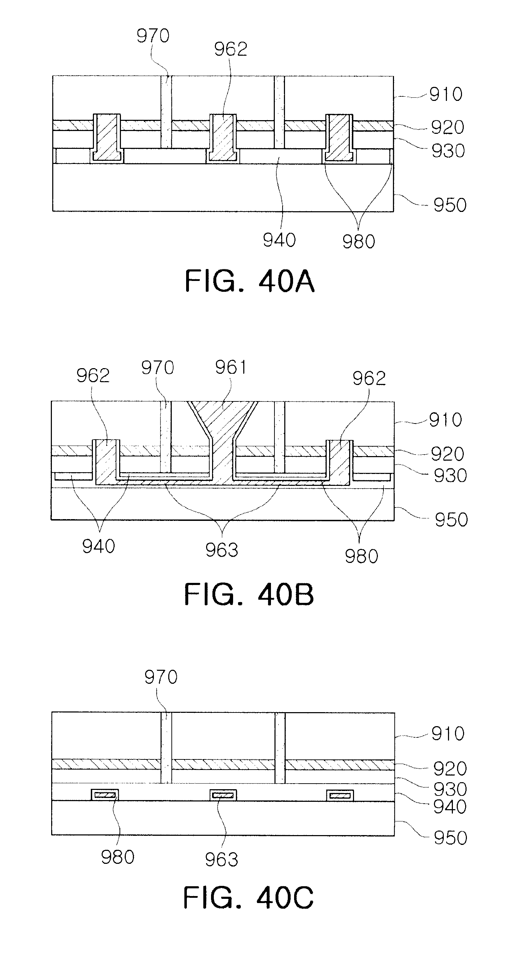

FIG. 38 is a perspective view of an LED chip according to a different exemplary embodiment of the present invention. FIGS. 39a and 39b are plan views of the LED chip of FIG. 38. FIGS. 40a to 40c are sectional views of the LED chip illustrated in FIG. 39b taken along lines A-A', B-B', and C-C', respectively.

An LED chip 900 according to the present exemplary embodiment includes a light emission stacked body 910, 920, and 930 including first and second conductive semiconductor layers 910 and 930 and an active layer 920 formed therebetween and having first and second faces which are provided to the first and second conductive semiconductor layers 910 and 930 and are opposed to each other; at least one partition wall part 970 extending from the second face of the light emission stacked body 910, 920 and 930 to at least a portion of the first conductive semiconductor layer 910 such that the light emission stacked body 910, 920 and 930 is divided into a plurality of light emission areas, the partition wall part 970 having electrical insulation properties; a first electrode structure 960 formed to be connected to each of the first conductive semiconductor layer 910 positioned in the plurality of light emission areas; a second electrode structure 960 formed on the second face of the light emission stacked body 910, 920, and 930 such that it is connected to the second conductive semiconductor layer 930; and a conductive substrate 950 formed on the second face of the light emission stacked body 910, 920, and 930 and electrically connected to the second electrode structure 940.

The light emission stacked body 910, 920, and 930 includes the first and second conductive semiconductor layers 910 and 930 and the active layer 920 formed therebetween. The light emission stacked body 910, 920, and 930 has an outer surface of the first conductive semiconductor layer 910 as the first face and an outer surface of the second conductive semiconductor layer 930 as the second face.

The respective semiconductor layers 910 and 930 may include, for example, a GaN-based semiconductor, a ZnO-based semiconductor, a GaAs-based semiconductor, a GaP-based semiconductor, or a GaAsP-based semiconductor. The semiconductor layers may be formed, for example, by using a molecular beam epitaxy (MBE) method. Besides, the semiconductor layers may be implemented by appropriately selecting semiconductors from a group consisting of group III-V semiconductors, group II-VI semiconductors, and silicon (Si). The light emission stacked body may be grown on a non-conductive substrate such as a sapphire substrate having a relatively low lattice mismatch. The non-conductive substrate (not shown) is removed before the conductive substrate is bonded later.

The active layer 920, serving to activate light emissions, is formed by using a material having an energy band gap smaller than that of the first conductive semiconductor layer 910 and the second conductive semiconductor layer 930. For example, when the first conductive semiconductor layer 910 and the second conductive semiconductor layer 930 are GaN-based compound semiconductors, the active layer 920 may be formed by using an InAlGaN-based compound semiconductor having an energy band gap smaller than that of GaN. Namely, the active layer 920 may include InxAlyGa(1-x-y)N(0≤x≤1, 0≤y≤1, 0≤x+ y≤1).

In this case, in terms of the characteristics of the active layer 920, preferably, an impurity is not doped therein, and the wavelength of emitted light can be regulated by adjusting the molar ratio of constituents of the active layer 920. Thus, the semiconductor LED chip 900 is able to emit one of infrared rays, visible light, and ultraviolet rays according to the characteristics of the active layer 920.

An overall energy band diagram of the semiconductor LED chip 600 includes an energy well structure according to the active layer 920, and as electrons and holes from the respective semiconductor layers 910 and 930 move, they become captive in the energy well structure, according to a light emission which can be generated more effectively.

The partition wall part 970 is formed to extend from the second face of the light emission stacked body 910, 920, and 930 up to a portion of the first conductive semiconductor layer 910 to divide the light emission stacked body 910, 920, and 930 into a plurality of light emission areas. The partition wall part 970 divides the first conductive semiconductor layer 910, so that when a separation means such as a laser, or the like, is applied between the first conductive semiconductor layer 910 and a growth substrate (not shown) formed on the first conductive semiconductor layer 910, the partition wall part 970 reduces stress caused by thermal energy applied to the interface.

For example, when a laser is used as a separation means for separating the first conductive semiconductor layer 910 and the growth substrate, the temperature at the interface is approximately 1,000°C. Thus, the thermal energy is used for separating them, but such heat generates stress inducing a contraction and expansion to the semiconductor layer and the conductive substrate 950 to be bonded later. In general, the size of the stress is proportional to the area, so such stress may negatively affect a large-scale LED chip.

However, since the LED chip 900 according to the present exemplary embodiment includes the partition wall part 970, the area of the first conductive semiconductor layer 910 is reduced to the areas of the plurality of light emission areas, reducing the stress. Namely, since the plurality of light emission areas are easily expanded and contracted, the light emission of the light emission stacked body 910, 920, and 930 can be stabilized. Preferably, the partition wall part 970 electrically insulates the semiconductor layers 910 and 930 and the active layer 920, and to this end, the partition wall part 970 may be charged with air. Alternatively, the partition wall part 970 may include an insulating layer on an inner surface thereof, and the interior of the insulating layer may be charged with air. Besides, the entirety of the interior may be charged with an insulating material such as a dielectric to perform electrical insulation.

In order to electrically insulate the light emission stacked body 910 and 930, the partition wall part 970 may be formed to extend from the second face up to the upper surface of the first conductive semiconductor layer 910; however, in this case, the partition wall part 970 may not necessarily extend up to the upper surface of the first conductive semiconductor layer 910 but extends to the interior of the first conductive semiconductor layer 910.

Also, the partition wall part 970 may be configured as an integrated body, or alternatively, it may be configured to include a plurality of partition walls. In this case, the plurality of partition walls may be formed to be different so as to have required electrical insulation properties. For example, a partition wall surrounding a bonding part 961 and a partition wall surrounding a contact hole 962 may have different heights and shapes.

The first electrode structure 960 is formed to be connected to the first conductive semiconductor layer 910 positioned at the plurality of light emission areas divided by the partition wall part 970. The first electrode structure 960 includes the contact hole 962, the bonding part 961, and a wiring part 963.

A plurality of contact holes 962 may be provided, and each of them may be provided to each of the plurality of light emission areas. A single contact hole 962 may be provided to a single light emission area, or a plurality of contact holes 962 may be provided to a single light emission area. The contact hole 962 is formed to be electrically connected to the first conductive semiconductor layer 910 and electrically insulated from the second conductive semiconductor layer 930 and the active layer 920, and to this end, the contact hole 962 extends from the second face of the light emission stacked body 910, 920, and 930 to at least a portion of the first conductive semiconductor layer 910. The contact hole 962 is formed to distribute current on the first conductive semiconductor layer 910.

The bonding part 961 is formed to be connected to at least one of the plurality of contact holes 962 from the first face of the light emission stacked body 910, 920, and 930, and an area exposed to the first face is provided as a bonding area.

The wiring part 963 is provided to the second face of the light emission stacked body 910, 920, and 930, and is formed to electrically connect the contact holes 962 which are electrically connected to the bonding part 961 in a state of being electrically insulated from the second conductive semiconductor layer 930. The wiring part 963 electrically connects the contact holes 962 and connects the contact holes and the bonding part 961. Since the wiring part 963 is positioned at a lower side of the first conductive semiconductor layer 910 and the active layer 920, the luminous efficiency can be improved.

The contact hole 962, the bonding part 962, and the wiring part 963 will be described in more detail with reference to FIGS. 39a to 40c.

The second electrode structure 940 is formed on the second face of the light emission stacked body 910, 920, and 930 so as to be electrically connected to the second conductive semiconductor layer 930. Namely, the second electrode structure 940 is an electrode electrically connecting the second conductive semiconductor layer 930 to an external power source (not shown). The second electrode structure 940 may be made of metal. For example, the second electrode structure 940 may include Ti in the case of an n-type electrode and Pd or Au in the case of a p-type electrode.

Preferably, the second electrode structure 940 is positioned at the lower side of the active layer 920, disposed on the side opposite to the light emission direction of the LED chip, based on the active layer 712. Accordingly, light proceeding from the active layer 920 to the second electrode structure 940 moves opposite to the light emission direction, and such light must be reflected to increase luminous efficiency. Thus, light reflected from the second electrode structure 940 proceeds to the light emission surface, increasing the luminous efficiency of the semiconductor LED chip.

In order to reflect light generated from the active layer 920, the second electrode structure 940 is made of metal of white series in a visible light area. For example, the second electrode structure 940 may be made of any one of Ag, Al, and Pt. The second electrode structure 940 will be described further with reference to FIGS. 4a to 4c.

The conductive substrate 950 is formed on the second face of the light emission stacked body 910, 920, and 930 so as to be electrically connected to the second electrode structure 940. The conductive substrate 950 may be a metal substrate or a semiconductor substrate. When the conductive substrate 950 is a metal substrate, it may be made of any one of metals among Au, Ni, Cu, and W. Also, when the conductive substrate 950 is a semiconductor substrate, it may be made of any one among Si, Ge, and GaAs. In order to form the conductive substrate 950 on the LED chip, a plating method for forming a substrate by forming a plating seed layer or a substrate bonding method for preparing the conductive substrate 950 and bonding it by using a conductive adhesive such as Au, Au-Sn, or Pb-Sr may be used.

With reference to FIG. 39a, the bonding part 961 is formed on the surface of the first conductive semiconductor layer 910, and the plurality of contact holes 962 indicated by dotted lines are positioned in the interior of the first conductive semiconductor layer 910. The first conductive semiconductor layer 910 includes a plurality of light emission areas divided by the partition wall part 970. Only one bonding part 961 is illustrated in FIGS. 39a and 39b, but the present invention is not limited thereto and a plurality of bonding parts may be formed on the same light emission area, or a plurality of bonding parts may be formed on a plurality of light emission areas, respectively. Also, one contact hole 962 is formed in each of the light emission areas, but the present invention is not limited thereto and a plurality of contact holes may be formed in a single light emission area to further improve the current distribution.

FIG. 39b is a sectional view of the upper surface of the first conductive semiconductor layer 910 taken along lines A-A', B-B', and C-C'. Line A-A' is selectively taken to show section including only the contact holes 962, B-B' is selectively taken to show the section including the bonding part 961 and the contact holes 962, and C-C' is selectively taken to show the section only including the wiring part 963 without the contact hole 962 or the bonding part 961.

FIGS. 40a to 40c are sectional views of the LED chip illustrated in FIG. 39b taken along lines A-A', B-B', and C-C'. The LED chip will be described with reference to FIGS. 38, 39a, 39b, and 40a to 40c.

In FIG. 40a, the contact hole 962 extends from the second electrode structure 940 to the interior of the first conductive semiconductor layer 910. The contact hole 962, passing through the first conductive semiconductor layer 910 and the active layer 920, extends up to the first conductive semiconductor layer 910, and in this case, the contact hole 962 extends to at least a portion of the first conductive semiconductor layer 910, rather than reaching the surface of the first conductive semiconductor layer 910 like the bonding part 961 does. However, because the contact hole 962 is aimed to distribute current in the first conductive semiconductor layer 910, it must extend up to the first conductive semiconductor layer 910.

Since the contact hole 962 serves to distribute current in the first conductive semiconductor layer 910, it is required to have a certain area. In this case, because the contact hole 962 is not used for an electrical connection like the bonding part 961 does, preferably, a certain number of contact holes 962 are formed to have an area sufficiently small as to allow current to be uniformly distributed within the first semiconductor layer 910. If the number of the contact holes 962 is too small, current distribution could not be easily performed to degrade electrical characteristics, whereas if the number of the contact holes 962 is too large, the process for forming the large number of electrode extension parts will be difficult and the active layer reduced, resulting in a reduction in a light emission area. Thus, the number of contact holes may be appropriately selected in consideration of such conditions. That is, the contact holes 962 are implemented to have a configuration such that they occupy the as small an area as possible and have a shape effective for current distribution.

Preferably, a plurality of contact holes 962 are provided for current distribution. Also, the contact hole 962 may have a cylindrical shape. The area of the section of the cylindrical contact hole 962 may be smaller than that of the bonding part 961. The contact holes 962 may be formed to be spaced apart from the bonding part 961. Since the contact holes 962 may be connected by the wiring part 963 (to be described) on the second electrode structure 940, they are required to be spaced apart by a certain distance to induce a uniform current distribution.

The contact holes 962 are formed to extend from the second electrode structure 940 to reach even the interior of the first conductive semiconductor layer 910, and since the contact holes 962 are formed to serve to distribute current, they are required to be electrically isolated from the second conductive semiconductor layer 930 and the active layer 920. Thus, preferably, the contact holes 962 are electrically isolated from the second electrode structure 940, the second conductive semiconductor layer 930, and the active layer 920. The electrical isolation may be performed by using an insulating material such as a dielectric, or the like.

In FIG. 40b, the bonding part 961 extends from the second electrode structure 940 up to the surface of the first conductive semiconductor layer 910. The bonding part 961 may be formed from the second electrode structure 940 and extend so as to reach the surface of the first conductive semiconductor layer 910 through the second conductive semiconductor layer 930, the active layer 920, and the first conductive semiconductor layer 910. The bonding part 961 is formed to be connected to at least one of the plurality of contact holes 962 from the first face of the light emission stacked body 910, 920, and 930, and an area thereof exposed to the first face is provided as a bonding area. In particular, the bonding part 961 is aimed to connect the first electrode structure 960 to an external power source (not shown), so the first electrode structure 960 may include at least one bonding part 961.

The bonding part 961 extends from the second electrode structure 940 up to the surface of the first conductive semiconductor layer 910. The bonding part 961 is electrically connected to an external power source on the surface of the first conductive semiconductor layer 910, to supply current to the contact holes 962, so preferably, it is electrically isolated from the second electrode structure 940, the first conductive semiconductor layer 910, and the active layer 920. The electrical isolation may be performed by forming an insulating layer by using an insulating material such as a dielectric, or the like.

The bonding part 961 serves to supply current to the contact holes 962, and besides, the bonding part 961 may be configured not to be electrically isolated from the first conductive semiconductor layer 910 to directly distribute current. In consideration of a required function among the function of supplying current to the contact holes 962 and the function of distributing current in the first conductive semiconductor layer 910, the bonding part 961 can be appropriately electrically isolated from the first conductive semiconductor layer 910.

Preferably, the area of the section of the bonding part 961 in the active layer 920 is smaller than the area of the section of the bonding part 961 on the surface of the first conductive semiconductor layer 910. This is to secure the active layer 920 to be as large as possible to increase luminous efficiency. However, the bonding part 961 is required to have a certain area on the surface of the first conductive semiconductor layer 910, so as to be connected to an external power source (not shown).

The bonding part 961 may be positioned at the center of the semiconductor LED chip 900, and in this case, the contact holes 962 may be spaced apart from the bonding part 961 and evenly distributed to be positioned. With reference to FIG. 37a, the bonding part 961 and the contact holes 962 are evenly distributed to be positioned on the first conductive semiconductor layer 910 to optimize current distribution. In FIG. 39a, one bonding part 961 and eight contact holes 962 are formed to be illustrated, but the number of the bonding parts 961 and the contact holes 962 may be appropriately selected in consideration of an electrical connection situation (e.g., current distribution situation such as the location of an external power source, the thickness of the first conductive semiconductor layer 910, and the like).

When the plurality of the contact holes 962 are provided, the bonding part 961 and the plurality of contact holes 962 may be directly connected. In this case, the bonding part 961 may be formed at the central portion of the semiconductor LED chip 900, the contact holes 962 may be positioned around the bonding part 961, and the wiring part 963 may radially directly connect the bonding part 961 and the contact holes 962.

Alternatively, some of the plurality of the contact holes 962 may be directly connected to the bonding part 961 and the other may be connected to the contact holes 962 directly connected to the bonding part 961; namely, the other contact holes 962 may be indirectly connected to the bonding part 961. In this case, a larger number of contact holes 962 can be formed to improve the efficiency of the current distribution.

In FIGS. 40a to 40c, the wiring part 963 is formed on the second electrode structure 940 to connect the bonding part 961 and the contact holes 962. Accordingly, considerable portions of the second electrode structure 950 are positioned on a rear surface opposed to the direction in which light from active layer 920, which emits light, proceeds, thus increasing luminous efficiency. In particular, in FIG. 40c, only the wiring parts 963 are positioned on the second electrode structure 940, so the second electrode structure 950 is not positioned on the first conductive semiconductor layer 910, the active layer 920, and the second conductive semiconductor layer 930. Accordingly, in the case illustrated in FIG. 40c, the bonding part 961 and the contact holes 962 do not affect light emission, increasing luminous efficiency.

The wiring parts 963 are electrically isolated from the second electrode structure 940. The second electrode structure 960 and the second electrode structure 950 are electrodes having mutually opposite polarities and supplying external power to the first conductive semiconductor layer 910 and the second conductive semiconductor layer 930, respectively, so that both must be necessarily electrically isolated. Their electrical isolation may be performed by using an insulating material such as a dielectric, or the like.

In FIG. 40b, since the bonding part 961 is positioned on the surface of the first conductive semiconductor layer 910, the characteristics of a vertical-type semiconductor LED chip can be obtained, and in FIG. 40c, the wiring part 963 is positioned on the same plane on which the second electrode structure 940 is positioned, the characteristics of a horizontal-type semiconductor LED chip can be obtained. Accordingly, the semiconductor LED chip 900 can have the structure incorporating the horizontal-type and vertical-type semiconductor LED chips.

In FIGS. 40a to 40c, the second conductive semiconductor layer may be an n-type semiconductor layer, and the second electrode structure may be an n-type electrode unit. In this case, the first conductive semiconductor layer 910 may be a p-type semiconductor layer, and the first electrode structure 940 may be a p-type electrode. The bonding part 961, the contact holes 962, and the wiring part 963 constitute the second electrode structure 950 (namely, the bonding part 961, the contact holes 962, and the wiring part 963 are connected second electrode structure), and when the second electrode structure 950 is an n-type electrode, an insulating part 970 may be formed with an insulating material to electrically isolate it from the first electrode structure 940, the p-type electrode.

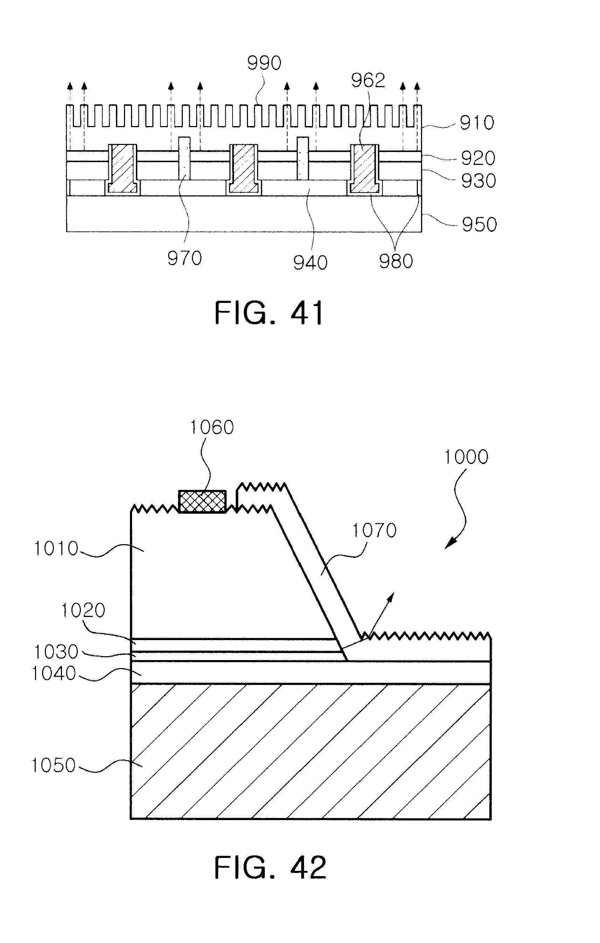

FIG. 41a illustrates light emission of a semiconductor LED chip having a depression and protrusion pattern formed thereon according to the present exemplary embodiment. In the semiconductor LED chip according to the present exemplary embodiment, the first conductive semiconductor layer 910 is configured to be the outermost surface in the direction in which emitted light proceeds. Thus, the depression and protrusion pattern can be easily formed on the surface of the first conductive semiconductor layer 910 by using a conventionally known method, such as photolithography, or the like. In this case, light emitted from the active layer 920 is extracted upon passing through the depression and protrusion pattern 990 formed on the surface of the first conductive semiconductor layer 910, and the light extraction efficiency can be increased by the depression and protrusion pattern 990.

The depression and protrusion pattern 990 may have a photonic crystal structure. In the photonic crystal structure, mediums, each having a different refractive index, are regularly arranged like crystals, and such photonic crystals allow for light regulation by unit of the length of the multiple of the wavelength of light, further increasing light extraction efficiency. The photonic crystal structure can be formed through a certain appropriate process after the first conductive semiconductor layer 910 and up to the second electrode structure 950 are fabricated. For example, the photonic crystal structure may be formed through an etching process.

When the depression and protrusion pattern 990 is formed on the first conductive semiconductor layer 910, preferably, the partition wall part 970 is formed to extend only to the interior of the first conductive semiconductor layer 910, rather than reaching the surface of the first conductive semiconductor layer 910. The partition wall part 970 serves to divide the light emission area into a plurality of sections, without affecting the performance of improving the light extraction efficiency of the depression and protrusion pattern 990.

The structure of an LED chip according to a different exemplary embodiment of the present invention will now be described with reference to FIGS. 42 to 52.

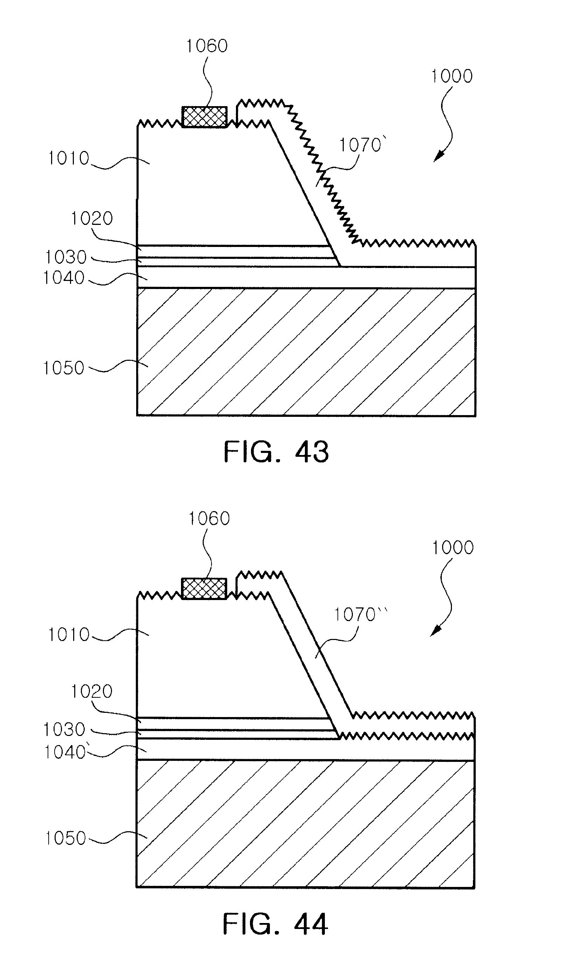

FIG. 42 is a cross-sectional view showing a vertical type semiconductor LED chip according to an exemplary embodiment of the present invention, and FIGS. 43 and 44 are cross-sectional views showing a vertical type semiconductor LED chip according to a modification of the exemplary embodiment of the present invention in FIG. 42.

With reference to FIG. 42, in a vertical type semiconductor LED chip 1000, n-type and p-type semiconductor layers 1010 and 103 and an active layer 102 formed therebetween constitute a light emission structure, and a reflective metal layer 1040 and a conductive substrate 1050 are formed at a lower side of the light emission structure. An n-type electrode 1060 is formed on the n-type semiconductor layer 1010, and a passivation layer 1070 having a depression and protrusion structure is formed to cover a side surface of the light emission structure.

The n-type semiconductor layer 1010 and the p-type semiconductor layer 1030 are typically formed of a nitride semiconductor. Namely, the n-type semiconductor layer 1010 and the p-type semiconductor layer 1030 may be made of a semiconductor material with n-type and p-type impurities doped therein, having an empirical formula of AlxlnyGa(1-x-y)N (here, 0≤x≤1, 0≤y≤1, 0≤x+ y≤1), and typical semiconductor materials may include GaN, AlGaN, and InGaN. Also, Si, Ge, Se, Te, or the like, may be used as the n-type impurities, and Mg, Zn, Be, and the like, may be typical p-type impurities. Meanwhile, in order to improve the efficiency of light emitted in a vertical direction, a depression and protrusion structure may be formed on an upper surface of the n-type semiconductor layer 1010.

The active layer 1020 formed between the n-type and p-type nitride semiconductor layers 1010 and 1030 emits light having a certain amount of energy according to the recombination of electrons and holes, and may have a multi-quantum well (MQW) structure in which a quantum well layer and a quantum barrier layer are alternately stacked. In general, an InGaN/GaN structure may be used as the MQW structure.

The reflective metal layer 1040 may serve to reflect light, which is emitted from the active layer 1020, toward the n-type nitride semiconductor layer 1010, and may be made of Ag, Ni, Al, Rh, Pd, Ir, Ru, Mg, Zn, Pt, Au, or the like. In this case, although not shown in detail, the reflective metal layer 1040 may have a structure including two or more layers so as to be employed to improve reflection efficiency. For example, the structure having two or more layers of the reflective metal layer 1040 may include, for example, Ni/Ag, Zn/Ag, Ni/Al, Zn/Al, Pd/Ag, Pd/Al, Ir/Ag, Ir/Au, Pt/Ag, Pt/Al, Ni/Ag/Pt, and the like. However, in the present exemplary embodiment, the reflective metal layer 1040 is not an essential element and may be omitted according to circumstances.

The conductive substrate 1040 serves as a p-type electrode and also serves as a support for supporting the light emission structure, namely, the n-type semiconductor layer 1010, the active layer 1020, and the p-type semiconductor layer 1030, in a laser lift off process (to be described). In this case, the conductive substrate 1050 may be made of a material such as Si, Cu, Ni, Au, W, Ti, or the like, and may be formed according a method such as a plating method or a bonding method, or the like, depending on a selected material.

The passivation layer 1070 is an insulating layer for protecting the active layer 1020. The passivation layer 1070 is formed on an area formed by removing a portion of the light emission structure. In detail, as shown in FIG. 42, the passivation layer 1070 may also be formed on a portion of the upper surface of the n-type semiconductor layer 1010 and on an upper surface of the reflective metal layer 1040. In this case, if the reflective metal layer 1040 is not employed, the passivation layer 1070 would be formed on the upper surface of the conductive substrate 1050. The side surface exposed by removing a portion of the light emission structure may be upwardly sloped, and this structure can lead to an improvement of a light emission area and facilitates the formation of the passivation layer 1070.

In order to perform a protection function, the passivation layer 1070 may be made of a silicon oxide or a silicon nitride such as SiO2 SiOxNy, SixNy, or the like, and may have a thickness ranging from 0.1 µm to 2 µm. Accordingly, the passivation layer 1070 may have a refractive index ranging from 1.4 to 2.0, and light emitted from the active layer 1020 cannot be easily leaked, or radiated outward, owing to the difference in the refractive index with air or a mold structure of the package. In particular, in case of the vertical type semiconductor light emitting element 1000 having such a configuration according to the present exemplary embodiment, since the thickness of the p-type semiconductor layer 1030 is relatively small, light emitted in a lateral direction of the active layer 1020 could be discharged to the outside through the passivation layer 1070, but in this case, the incident angle of the passivation layer 1070 to an outer side is too small to allow the light to be leaked out.

According to the present exemplary embodiment, a depression and protrusion structure is formed on the passivation layer 1070 to improve external light extraction efficiency, and in particular, as shown in FIG. 42, since the area allowing light, which is emitted in the lateral direction of the active layer 1020, to pass therethrough has the depression and protrusion structure, the amount of light emitted to the side of the vertical type semiconductor LED chip 1000 can be increased. Here, the area through which the light, which is emitted in the lateral direction of the active layer 1020, passes is considered not to have such a light emission structure on the upper surface of the reflective metal layer 1040. Simulation results obtained by comparing the light extraction efficiency of a structure employing the depression and protrusion structure on the passivation layer 1070 according to the present exemplary embodiment and that of a structure without the depression and protrusion structure while having the same constituents show that the light extraction efficiency according to the present exemplary embodiment was improved by about 5 % or greater. Meanwhile, the depression and protrusion structure of the passivation layer 1070 may be also formed on the upper surface of the n-type semiconductor layer 1010 to improve light extraction efficiency in a vertical direction, but it is not a must in the present exemplary embodiment.

As shown in FIGS. 43 and 44, the depression and protrusion structure formation area of the passivation layer may be variably changed to maximize external light extraction efficiency. The depression and protrusion structure as shown in FIG. 43 may be also formed on the side surface of a passivation layer 1070'. Also, as shown in FIG. 44, the depression and protrusion structure is also formed on a lower surface of a passivation layer 1070", namely, on the surface of the passivation layer 1070" facing the reflective metal layer 1040', and in this case, a pattern of a shape corresponding thereto may be formed on the reflective metal layer 1040'.

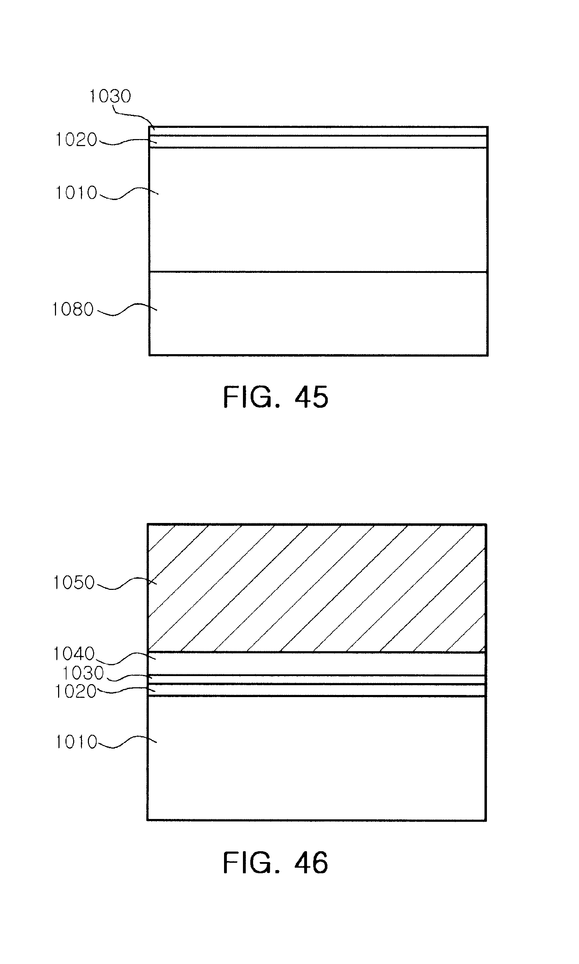

FIGS. 45 to 48 are sectional views showing sequential processes for explaining a method for fabricating the vertical type semiconductor LED chip having such a structure as described above with reference to FIG. 42.

First, as shown in FIG. 45, the n-type semiconductor layer 1010, the active layer 1020, and the p-type semiconductor layer 1030 are sequentially grown on a semiconductor single crystal growth substrate 1080 by using a process such as MOCVD, MBE, HVPE, or the like, to form the light emission structure. The semiconductor single crystal growth substrate 1080 may be a substrate made of a material such as sapphire, SiC, MgAl2O4, MgO, LiAlO2, LiGaO2, GaN, or the like. In this case, sapphire, a crystal having symmetry, has lattice constants of 13,001Å and 4.758Å, respectively, in c-axis and a-axis directions and have C(0001), A(1120), and R(1102) planes, etc. In this case, the C plane allows a nitride thin film to be relatively easily grown therefrom and is stable at a high temperature, so it is largely used as a nitride growth substrate.

Next, as shown in FIG. 46, the reflective metal layer 1040 and the conductive substrate 1050 are formed on the p-type semiconductor layer 1030 through a method such as plating or submount bonding, or the like. Thereafter, although not shown in detail, the semiconductor single crystal growth substrate 1080 is removed through an appropriate lift-off process such as laser lift-off, chemical lift-off, or the like.

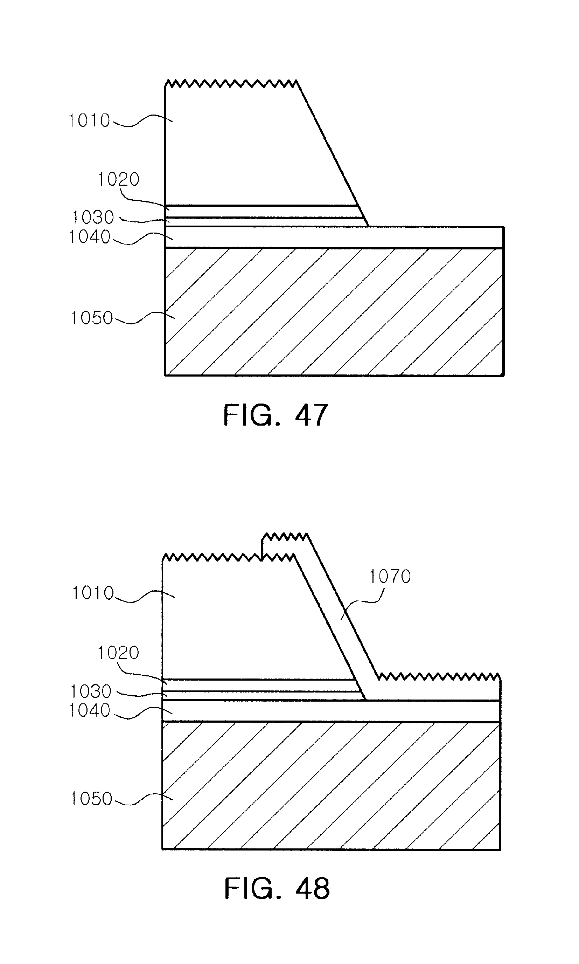

And then, as shown in FIG. 47, dicing is performed by element, and a portion of the light emission structure is removed in order to form a passivation layer. In this case, the side surface exposed by removing a portion of the light emission structure may be sloped upwardly. Also, in order to improve light extraction efficiency in a vertical direction, a depression and protrusion structure may be formed on an upper surface of the n-type semiconductor layer 1010, namely, on the surface exposed by removing the semiconductor single crystal growth substrate, through a process such as wet etching, or the like.

Subsequently, as shown in FIG. 48, the passivation layer 1070 is formed to protect the light emission structure. In this case, the passivation layer 1070 may be formed by appropriately depositing a silicon oxide or a silicon nitride. A depression and protrusion structure may be formed on one light emission surface of the passivation layer 1070 to improve light emission efficiency in a lateral direction. In this case, the depression and protrusion structure may be formed by using a dry etching process or a wet etching process known in the art. The depression and protrusion structure may also be formed on the other light emission surface of the passivation layer 1070 as necessary. After the passivation layer 1070 is formed, an n-type electrode is formed on the upper surface of the n-type semiconductor layer 1010 to obtain a completed structure illustrated in FIG. 40.

The present invention provides a semiconductor LED chip having a structure modified from the vertical type semiconductor LED chip as described above in order to further improve the electrical characteristics and optical characteristics.

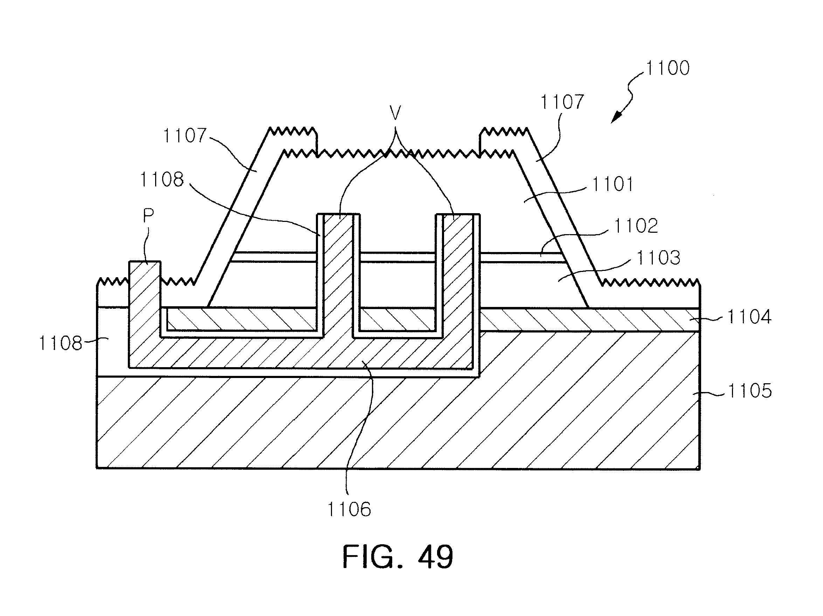

FIG. 49 is a schematic sectional view of a semiconductor LED chip according to a different exemplary embodiment of the present invention. With reference to FIG. 49, a semiconductor LED chip 1100 according to the present exemplary embodiment includes a conductive layer 1105, a light emission structure having a first conductive semiconductor layer 1103, an active layer 1102, and a second conductive semiconductor layer 1101, which are sequentially formed on the conductive layer 1105, a second conductive electrode 1106 for applying an electrical signal to the second conductive semiconductor layer 1101, and a passivation layer 1107 having a depression and protrusion structure formed on a side surface of the light emission structure. In the case illustrated in FIG. 49, the active layer 1102 is positioned at a relatively higher portion compared with the structure illustrated in FIG. 42, or the like, but the position of the active layer 1102 may be variably changed, and for example, it may be formed to have a height similar to a lower portion of the passivation layer 1107.

In the former exemplary embodiment, namely, in case of the vertical type semiconductor LED chip, the n-type electrode is formed on the surface of the n-type semiconductor layer exposed by removing the sapphire substrate, but in the present exemplary embodiment, it is exposed to the outside through a lower portion of the n-type semiconductor layer by using a conductive via. In detail, the second conductive electrode 1106 includes conductive vias (v) connected to the interior of the second conductive semiconductor layer 1101 through the first conductive semiconductor layer 1104 and the active layer 1102 and an electrical connection part (P) extending from the conductive via (v) and exposed to the outside of the light emission structure. In this case, the second conductive electrode 1106 needs to be electrically separated from the conductive substrate 1105, the first conductive semiconductor layer 1103, and the active layer 1102, an insulator 1108 is appropriately formed on or near the second conductive electrode 1106. Any material may be used as the insulator 1108 so long as it has low electric conductivity, and preferably, a material having low light observance is preferred. For example, the insulator 1108 may be made of the same material as that of the passivation layer 1107.

The second conductive electrode 1106 may be made of a metallic material which can be in ohmic-contact with the second conductive semiconductor layer 1101. Also, the second conductive electrode 1106 may be made entirely of the same material, or the electrical connection part (P) of the second conductive electrode 1106 may be made of a different material in consideration of the fact that the electrical connection part (P) may be used as a bonding pad part. Meanwhile, when the foregoing fabrication process is considered, in general, the first and second conductive semiconductor layers 1101 and 1103 may be p-type and n-type semiconductor layers, but the present invention is not necessarily limited thereto. As shown in FIG. 47, a supplemental element, a first contact layer 1104 may be formed between the first conductive semiconductor layer 1103 and the conductive substrate 1105, and in this case, the first contact layer 1104 may be made of metal having a high reflectance such as Ag, Al, or the like. The first contact layer 1104 and the second conductive electrode 1106 are electrically separated by the insulator 1108.

According to the foregoing electrical connection structure, an electrical signal may be applied to the second conductive semiconductor layer 110 from the interior thereof, rather than from an upper side thereof. In particular, since no electrode is formed on the upper surface of the second conductive semiconductor layer 1101, the light emission area can be increased and a current distribution effect can be improved by virtue of the conductive vias (v) formed therein. In this case, desired electrical characteristics can be obtained by appropriately regulating the number, area, and shape of the conductive vias (v). In the present exemplary embodiment, as for major processes such as forming the conductive substrate or removing the sapphire substrate, the fabrication process of the vertical type semiconductor LED chip is used, but the shape of the chip obtained by performing those processes is rather similar to the horizontal type semiconductor LED chip, so in this sense, the structure may be considered a mixed structure combining the vertical type and horizontal type semiconductor LED chips.

Likewise as in the former exemplary embodiment, the passivation layer 1107 is formed on the side surface, or the like, of the light emission structure and the depression and protrusion structure is formed in the path of light emitted from the active layer 1102, whereby the light extraction efficiency of light emitted in the lateral direction toward the passivation layer 1107 from the active layer 1102 can be improved. In addition, as shown in FIG. 49, the depression and protrusion structure may also be formed on the upper surface of the second conductive semiconductor layer 1101, and although not shown, the depression and protrusion structure may also be formed on the sloped side surface of the passivation layer 1107.

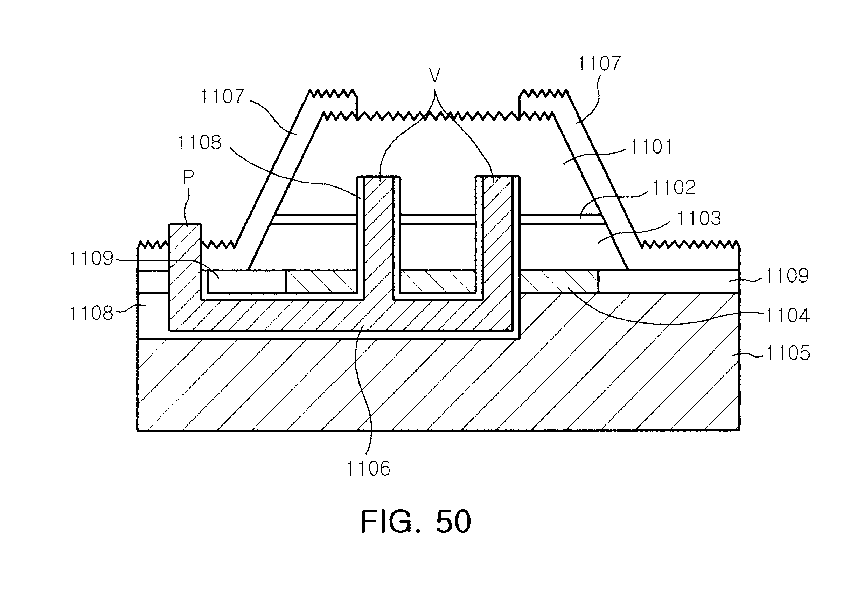

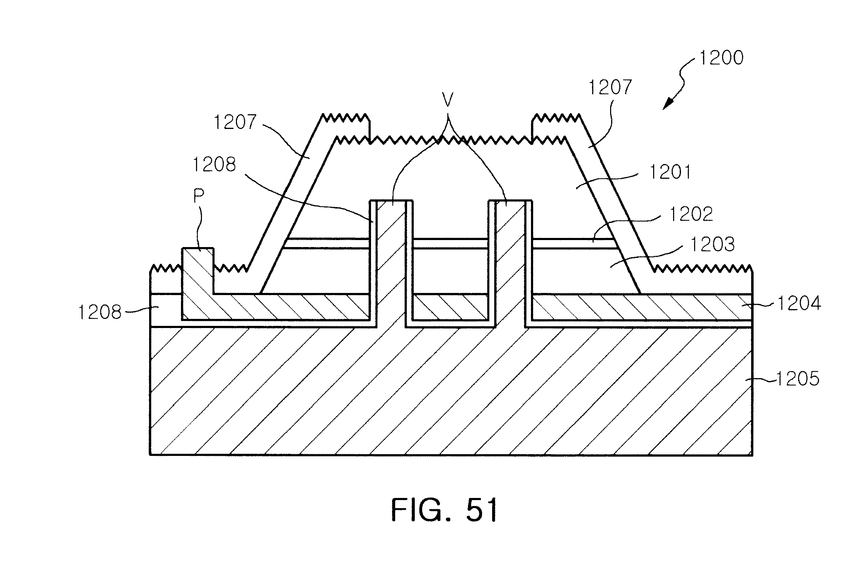

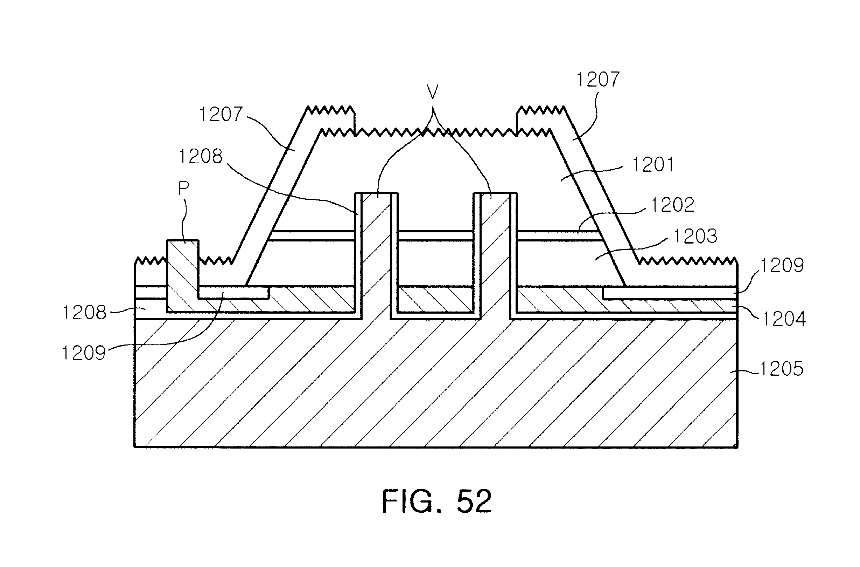

FIG. 50 is a schematic sectional view of a semiconductor LED chip having a structure modified from that illustrated in FIG. 51. In the exemplary embodiment illustrated in FIG. 52, an etching stop layer 1109 is added to the structure as described above with reference to FIG. 51. Hereinafter, only the etch stop layer 1109 will be described.

The etch stop layer 1109 is formed on an area, of at least the upper surface of the conductive substrate 1105, on which the light emission structure is not formed, and may be made of a material (oxide such as SiO2, or the like) having different etching characteristics from those of the semiconductor material, e.g., the nitride semiconductor, constituting the light emission structure, with respect to a particular etching method. When the light emission structure is etched, it can be etched only to the area on which the etch stop layer 1109 is positioned, so etching depth can be controlled by the etch stop layer 1109. In this case, in order to facilitate the process, the etch stop layer 1109 and the insulator 1108 may be made of the same material. When the light emission structure is etched for the necessity of exposing the second conductive electrode 1106, or the like, there is a possibility that the material constituting the conductive substrate 1105 or the first contact layer 1104 may be accumulated or heaped to the side surface of the light emission structure to thereby cause a leakage current. Thus, such a problem can be prevented by forming the etch stop layer 1109 in advance at a lower portion of the light emission structure to be removed through etching.

FIG. 51 is a cross-sectional view of a semiconductor LED chip according to a different exemplary embodiment of the present invention, and FIG. 52 shows a structure in which an etch stop layer is added to the structure of FIG. 51. With reference to FIG. 51, a semiconductor LED chip 1200 according to the present exemplary embodiment includes a conductive substrate 1205, a light emission structure having a first conductive semiconductor layer 1203, an active layer 1202, and a second conductive semiconductor layer 1201, which are sequentially formed on the conductive substrate 1205, a second contact layer 1204 for applying an electrical signal to the first conductive semiconductor layer 1203, conductive vias (v) extending from the conductive substrate 1205 to the interior of the second conductive semiconductor layer 1201, and a passivation layer 1207 having a depression and protrusion structure formed on a side surface of the light emission structure.

Differences from the structure described above with reference to FIG. 49 will hereinafter be described. First, the conductive substrate 1205 is electrically connected to the second conductive semiconductor layer 1201, and the first contact layer 1204 connected to the first conductive semiconductor layer 1203 includes an electrical connection part (P) so as to be exposed to the outside. The conductive substrate 1205 may be electrically separated from the first contact layer 1204, the first conductive semiconductor layer 1203, and the active layer 1202 by means of an insulator 1208.

Namely, in the exemplary embodiment of FIG. 49, the second conductive electrode 1106 connected to the second conductive semiconductor layer 1101 is exposed to provide the electrical connection part (P), and in comparison, in the present exemplary embodiment, the first contact layer 1204 connected to the first conductive semiconductor layer 1203 is exposed to provide the electrical connection part (P), providing a structural difference over the exemplary embodiment of FIG. 49.

Besides such a difference in the electrical connection method, other effects obtained from this structure are the same as those described above with reference to FIG. 49, and as shown in FIG. 52, an etch stop layer 1209 can also be employed. The exemplary embodiment illustrated in FIG. 51, namely, the structure in which the first contact layer 1204 is exposed to the outside, facilitates the formation process of an insulator 1208 as compared with the exemplary embodiment of FIG. 49.

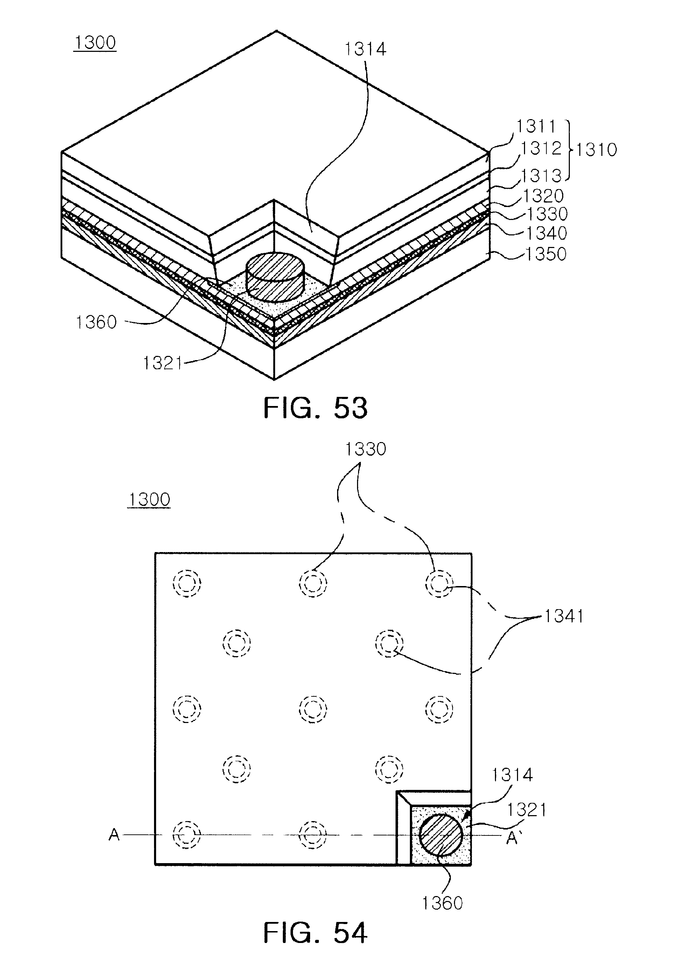

The structure of an LED chip according to a further exemplary embodiment of the present invention will now be described with reference to FIGS. 53 to 62.

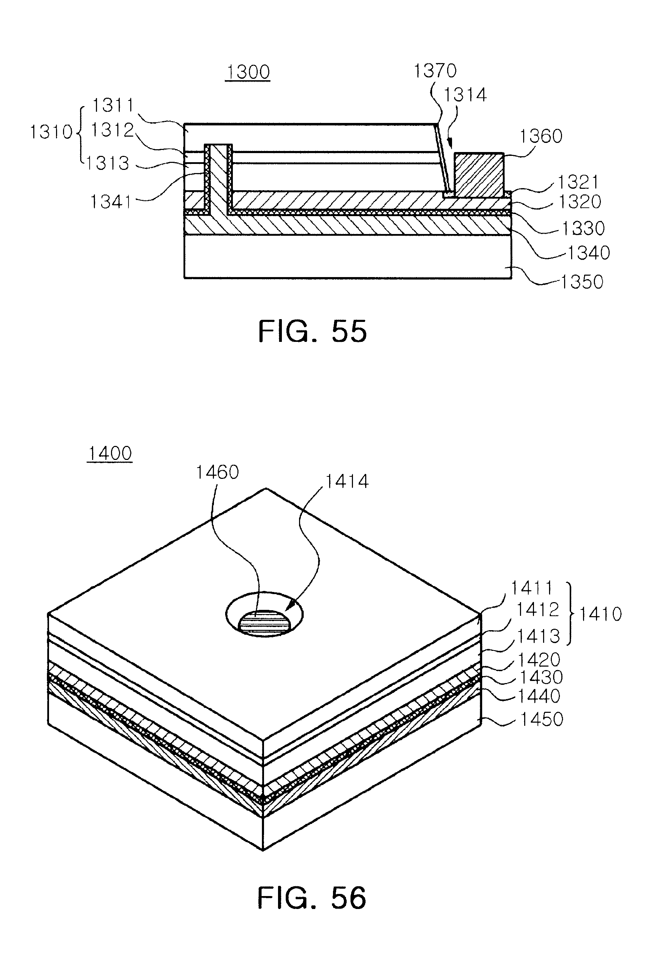

FIG. 53 is a perspective view of a semiconductor LED chip according to a different exemplary embodiment of the present invention, FIG. 54 is a plan view of the semiconductor LED chip of FIG. 53, and FIG. 55 is a cross-sectional view of the semiconductor LED chip of FIG. 54 taken along line A-A'. The exemplary embodiment will now be described with reference to FIGS. 53 to 55.

A semiconductor LED chip 1300 according to an exemplary embodiment of the present invention includes a first conductive semiconductor layer 1311, an active layer 1312, a second conductive semiconductor layer 1313, a second electrode layer 1320, an insulating layer 1330, a first electrode layer 1340, and a conductive substrate 1350. In this case, in order for the first electrode layer 1340 to be electrically connected to the first conductive semiconductor layer 1311, the first electrode layer 1340 includes one or more contact holes 1341 which are electrically insulated from the second conductive semiconductor layer 1313 and the active layer 1312 and extends from one surface of the first electrode layer 1340 up to at least a portion of the first conductive semiconductor layer 1311. The first electrode layer 1340 is not an essential constituent in the present exemplary embodiment. Although not shown, the first electrode layer may not be included and the contact hole 1341 may be formed from one surface of the conductive substrate 1350. Namely, in order for the conductive substrate 1350 to be electrically connected to the first conductive semiconductor layer 1311, the conductive substrate 1350 may include one or more contact holes 1341 which are electrically insulated from the second conductive semiconductor layer 1313 and the active layer 1312 and extend from one surface of the first electrode layer 1340 to at least a portion of the first conductive semiconductor layer 1311. In this case, the conductive substrate 1350 is electrically connected to an external power source (not shown), and voltage is applied to the first conductive semiconductor layer 1311 through the conductive substrate.

The second electrode layer 1320 includes an area 1314 formed as a portion of the interface with the second conductive semiconductor layer 1313 is exposed by etching the first conductive semiconductor layer 1311, the active layer 1312, and the second conductive semiconductor layer 1313, an etch stop layer 1321 is formed on the exposed area 1314.

The emission of light from the semiconductor LED chip 1300 is performed by the first conductive semiconductor layer 1311, the active layer 1312, and the second conductive semiconductor layer 1313, so these will be referred to as a light emission stacked body 1310. Namely, the semiconductor LED chip 1300 includes the light emission stacked body 1310, the first electrode layer 1340 electrically connected to the first conductive semiconductor layer 1311 by the contact hole 1341, the second electrode layer 720 electrically connected to the second conductive semiconductor layer 1313, and the insulating layer 1330 for electrically insulating the electrode layers 1320 and 1340. Further, the semiconductor LED chip 1300 includes a conductive substrate 1350 for supporting the semiconductor LED chip 1300.

The first and second semiconductor layers 1311 and 1313 may include semiconductor materials such as a GaN-based semiconductor, a ZnO-based semiconductor, a GaAs-based semiconductor, a GaP-based semiconductor, or a GaAsP- based semiconductor; however, the present invention is not limited thereto. Also, the semiconductor layers 1311 and 1313 may be appropriately selected from the group consisting of group III - V semiconductors, group II-VI semiconductors, and silicon (Si). The semiconductor layers 1311 and 1313 may be doped with n-type impurities or p-type impurities in consideration of their conductivity types.

The active layer 1312, serving to activate the emission of light, is formed by using a material having an energy band gap smaller than that of the first conductive semiconductor layer 1311 and the second conductive semiconductor layer 1312. For example, when the first conductive semiconductor layer 1311 and the second conductive semiconductor layer 1312 are GaN-based compound semiconductors, the active layer 1312 may be formed by using an InAlGaN-based compound semiconductor having an energy band gap smaller than that of GaN. Namely, the active layer 1312 may include InxAlyGa(1-x-y)N(0≤x≤1, 0≤y≤1, 0≤x+ y≤1).

In this case, in terms of the characteristics of the active layer 1312, preferably, impurities are not doped therein, and the wavelength of emitted light can be regulated by adjusting the molar ratio of constituents of the active layer 1312. Thus, the semiconductor LED chip 1300 is able to emit one of infrared rays, visible light, and ultraviolet rays according to the characteristics of the active layer 1312.

The electrode layers 1340 and 1320 are layers for applying voltage to the semiconductor layers having the same conductive type, respectively, so the semiconductor layers 1311 and 1313 are electrically connected to an external power source (not shown) by means of the electrode layers 1320 and 1340.

Since the first electrode layer 1340 is connected to the first conductive semiconductor layer 1311 and the second electrode layer 1320 is connected to the second conductive semiconductor layer 1313, they are electrically separated from each other through the first insulating layer 1330. Preferably, the insulating layer 1330 is made of a material having low electric conductivity. For example, the insulating layer 1330 may include an oxide such as SiO2, or the like.

In order to be electrically connected to the first conductive semiconductor layer 1311, the first electrode layer 1340 includes one or more contact holes 1341 electrically insulated from the second conductive semiconductor layer 1313 and the active layer 1312 (the insulating layer 1330 positioned between the first and second electrode layers may be formed to extend) and extending to a portion of the first conductive semiconductor layer 1311. The contact hole 1341, including an electrode material, extends to the first conductive semiconductor layer 1311 through the second electrode layer 1320, the insulating layer 1330, and the active layer 1312. The first electrode layer 1340 and the first conductive semiconductor layer 1311 are electrically connected by means of the contact hole 1341, so the first conductive semiconductor layer 1311 is connected to an external power source (not shown).

When the contact holes 1341 are used only for electrically connecting the first conductive semiconductor layer 1311, the first electrode layer 1340 may include only a single contact hole 1341. However, for an even distribution of current transferred to the first conductive semiconductor layer 1311, the first electrode layer 1340 may include a plurality of contact holes 1341 at predetermined positions.

Since the second electrode layer 1320 is positioned at a lower side of the active layer 1312, it is positioned at the side opposite to the light emission direction of the semiconductor light emitting element 1300 based on the active layer 1312.

In order to reflect light generated from the active layer 1312, the second electrode layer 1320 is made of metal of white series in a visible light area. For example, the second electrode layer 1320 may be made of any one of Ag, Al, and Pt.

A portion of the second electrode layer 1320 on the interface with the second conductive semiconductor layer 1313 is exposed by etching the first conductive semiconductor layer 1311, the active layer 1312, and the second conductive semiconductor layer 1313. An etch stop layer 1321 is formed on the exposed area 1314. The first electrode layer 1340 is in contact with the conductive substrate 1350 positioned on a lower surface thereof, so as to be connected to an external power source, while the second electrode layer 1320 requires a connection area for its connection to an external power source (not shown). Thus, the second electrode layer 1320 has the exposed area 1314 on a portion of the interface with the second conductive semiconductor layer 1313 by etching one area of the light emission stacked body 1310. Accordingly, the second conductive semiconductor layer 1313 can be connected to an external power source (not shown) by means of the second electrode layer 1320.

The area of the exposed area 1314 may be appropriately selected by a person skilled in the art to which the present invention pertains in consideration of the electrical connection efficiency and a current distribution in the electrode layer 1320. FIGS. 1 to 3 show an embodiment in which the corner of the light emission stacked body 1310 is etched, so the exposed area 1314 of the second electrode layer 1320 is positioned at the corner.

The exposed area 1314 is formed through selective etching so that only a portion of the light emission stacked body 1310 is etched and the second electrode layer 1320, generally including metal, is not etched. In this case, however, it is not easy to precisely control the selective etching for etching a portion of the light emission stacked body 1310, leading to the possibility that the second electrode layer 1320 positioned on the lower surface of the light emitting stacked body 1310 is also etched. If a portion of the second electrode layer 1320 is etched, the metallic material constituting the second electrode layer 1320 would be bonded to the second conductive semiconductor layer 1313, generating a leakage current. Thus, in order to prevent this, the etch stop layer 1321 is formed in the area (the exposed area of the second electrode layer 1320) of the light emission stacked body 1310 on which etching is performed.

The metal constituting the second electrode layer 1320 is prevented from being bonded to the side surface of the light emission stacked body 1310 by means of the etch stop layer 1321, thus reducing a leakage current and facilitating the etching operation. The etch stop layer 1321 is made of a material for restraining the light emission stacked body 1300 from being etched. For example, the etch stop layer 1321 may be made of one or more insulating materials selected from the group consisting of SiH4, SiN, SiON, and SiO2. In this case, the etch stop layer 1321 may not necessarily be made of an insulating material and even in the case that it is made of a conductive material, it does not affect the operation of the element. Thus, a conductive material may be selectively used to form the etch stop layer 1321 so long as it can perform the etch stop function.

Also, an electrode pad part 1360 may be formed on the exposed area 1314 such that it penetrates through the etch stop layer 1321. The electrode pad part 1360 may be electrically connected to the second electrode layer through the etch stop layer 1321. In this case, the electrical connection of the second electrode layer 1320 to an external power source (not shown) can be further facilitated.

The conductive substrate 1350 is positioned on a lower surface of the first electrode layer 1340. The conductive substrate 1350 is in contact with the first electrode layer 1350 so as to be electrically connected thereto. The conductive substrate 1350 may be a metal substrate or a semiconductor substrate. When the conductive substrate 740 is a metal substrate, it may be made of any one of metals among Au, Ni, Cu, and W. Also, when the conductive substrate 1350 is a semiconductor substrate, it may be made of any one among Si, Ge, and GaAs. The conductive substrate 1350 may be a support substrate bonded upon removing a sapphire substrate having a relatively low lattice mismatch after it used as a growth substrate.

FIG. 54 is a plan view of the semiconductor LED chip 1300. Although not shown on the upper surface of the semiconductor LED chip 1300, the contact holes 1341 are illustrated in dotted lines in order to show the positions of the contact holes 1341. In order to electrically separate the contact holes 1341 from the second electrode layer 1320, the second conductive semiconductor layer 1313, and the active layer 1312, the insulating layer 1330 may extend to the circumference of the contact hole 1341. This will be described in detail with reference to FIG. 55.

FIG. 55 is a cross-sectional view of the semiconductor LED chip illustrated in FIG. 54 taken along line A-A°. Line A-A' is selectively taken to show the section including the contact hole 1341 and the exposed area 1314.

With reference to FIG. 55, the contact hole 1341 extends from the interface of the first electrode layer 1340 to the interior of the first conductive semiconductor layer 1311 through the second electrode layer 1320, the second conductive semiconductor layer 1313, and the active layer 1312. The contact hole 1341 extends to at least the interface of the active layer 1312 and the first conductive semiconductor layer 1311, and preferably, extends to a portion of the first conductive semiconductor layer 1311. In this case, since the contact hole 1341 provides an electrical connection and a current distribution of the conductive semiconductor layer 1311, so it only needs to be in contact with the first conductive semiconductor layer 1311 without having to extend even to the outer surface of the first conductive semiconductor layer 1311.

Also, since the contact hole 1341 serves to distribute current in the first conductive semiconductor layer 1311, it is required to have a certain area. Preferably, a certain number of the contact holes 1341 are formed with an area sufficiently small as to allow current to be uniformly distributed within the first semiconductor layer 1311. If the number of the contact holes 1341 is too small, current distribution may not be easily carried out, thereby degrading the electrical characteristics of a device, whereas if the number of the contact holes 1341 is too large, the process for forming the large number of the contact holes 1341 will be difficult and the active layer may be reduced, resulting in a reduction in a light emission area. Thus, the number of the contact holes 1341 may be appropriately selected. That is, the contact holes 1341 are implemented to have a configuration such that they occupy the area as small as possible while effectively performing current distribution.

The contact hole 1341 is formed to extend from the first electrode layer 1340 to the first conductive semiconductor layer 1311, and in this case, since the contact hole 1341 is provided to distribute current of the first conductive semiconductor layer 1311, it is required to be electrically separated from the second conductive semiconductor layer 1313 and the active layer 1312. Thus, the insulating layer 1330 may extend while covering the circumference of the contact hole 1341. In FIG. 55, the second electrode layer 1320 includes an area 1314 formed by exposing a portion of the interface between the second conductive semiconductor layer 1313 and the area 1314 is used for electrically connecting the second electrode layer 1320 to an external power source (not shown). The etch stop layer 1321 is formed on the exposed area 1314. The exposed area 1314 may include the electrode pad part 1360 electrically connected to the second electrode layer 1320 through the etch stop layer 1321. In this case, the insulating layer 1370 may be formed on an inner surface of the exposed area 1314 in order to electrically separate the light emission stacked body 1310 and the electrode pad part 1360.

In FIG. 55, since the first electrode layer 1340 and the second electrode layer 1320 are positioned on the same plane, the semiconductor LED chip 1300 can exhibit the characteristics of a horizontal type semiconductor LED chip, and in FIG. 55, since the electrode pad part 1360 is positioned on the first conductive semiconductor layer 1311, the semiconductor LED chip 1300 can exhibit the characteristics of a vertical type semiconductor LED chip. Accordingly, the semiconductor LED chip 700 has a structure incorporating the horizontal type and the vertical type chips.

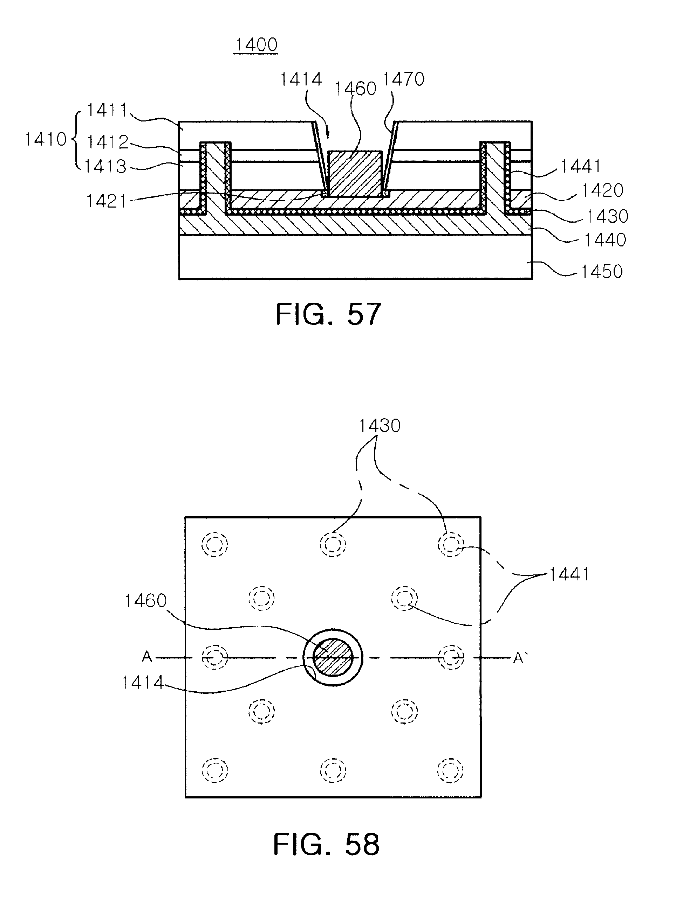

FIGS. 56 to 58 illustrate a semiconductor LED chip according to a different exemplary embodiment of the present invention. FIG. 56 is a perspective view of the semiconductor LED chip, FIG. 57 is a plan view of the semiconductor LED chip, and FIG. 58 is a cross-sectional view of the semiconductor LED chip of FIG. 57 taken along line A-A'.

In FIGS. 56 to 58, the center of a light emission stacked body 1410 is etched and an exposed area 1414 of the interface between the second electrode layer 1420 and the second conductive semiconductor layer is positioned at the center thereof. A description of the same elements which have been described above will be omitted. In this case, a portion of the etch stop layer 1421 formed on the exposed area may be removed so as to be electrically connected to an external power source (not shown), and an electrode pad part 1460 electrically connected to the second electrode layer 1420 through the etch stop layer 1421 can be included. In this case, the connection to the external power source (not shown) may be made by using a wire, so preferably, the exposed area 141 is formed to be increased toward the first conductive semiconductor layer from the second electrode area for the sake of the convenience of the connection.

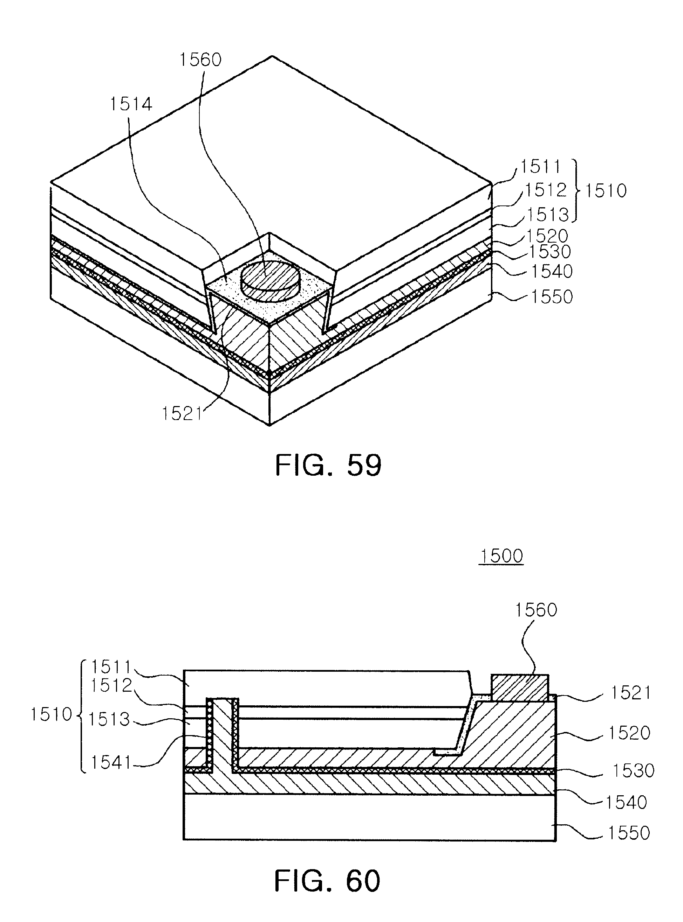

FIGS. 59 and 60 illustrate a semiconductor LED chip according to a different exemplary embodiment of the present invention. FIG. 59 is a perspective view of the semiconductor LED chip and FIG. 60 is a side cross-sectional view of the semiconductor LED chip. In this case, the plan view of the semiconductor LED chip is similar to FIG. 54, and FIG. 60 is a cross-sectional view taken along line A-A', similar to FIG. 55. A description of the same elements which have been already described above will be omitted.

With reference to FIGS. 59 and 60, an etch stop layer 1521 extends to the sides of the second conductive semiconductor layer and the active layer etched from an exposed area 1514 of the second electrode layer. The second electrode layer is exposed as a light emission stacked body 1510 is etched, and the etch stop layer 1521 formed on the exposed area extends to the sides of the second conductive semiconductor layer 1513 and the active layer 1512. In this case, as described above, while a first conductive semiconductor layer 1511 is being etched, a metal material of the second electrode layer can be prevented from being bonded to the semiconductor side and the active layer 1512 can be protected.

A method for fabricating the semiconductor LED chip as described above will now be explained.

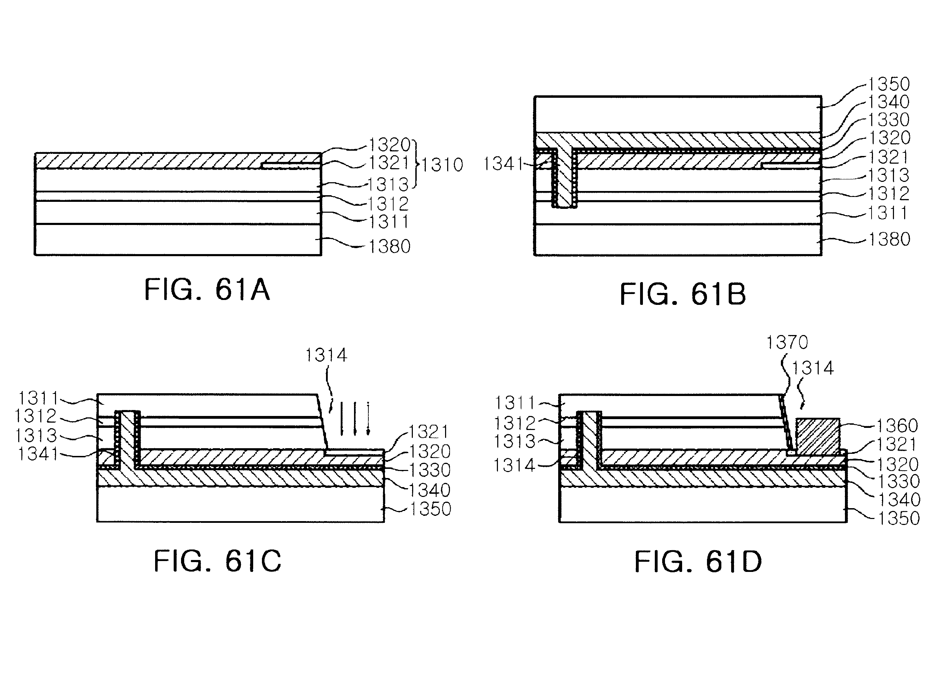

FIG. 61 is a sectional view showing a method for fabricating a semiconductor LED chip according to an exemplary embodiment of the present invention. Specifically, FIG. 61 shows a method for fabricating the semiconductor LED chip illustrated in FIGS. 53 to 55.

First, as shown in FIG. 61a, the first conductive semiconductor layer 1311, the active layer 1312, the second conductive semiconductor layer 1313, and the second electrode layer 1320 are sequentially stacked on the non-conductive substrate 1380.

In this case, the semiconductor layers and the active layer may be stacked by using a conventionally known process. For example, MOCVD, MBE, or HVPE may be used. The non-conductive substrate 1380 may be a sapphire substrate facilitating the growth of a nitride semiconductor layer.

When the second electrode layer 1320 is formed, it is stacked while forming the etch stop layer 1321 on the area to be exposed by etching the first conductive semiconductor layer 1311, the active layer 1312, and the second conductive semiconductor layer 1312.

Next, the insulating layer 1330 and the conductive substrate 1350 are formed on the second electrode layer 1320. In this case, as shown in FIG. 61b, the first electrode layer 1340 may be formed between the insulating layer 1330 and the conductive substrate 1350.

In order for the conductive substrate 1350 to be electrically connected to the first conductive semiconductor layer 1311, the conductive substrate 1350 is formed to include one or more contact holes 1341 which are electrically insulated from the second conductive semiconductor layer 1313 and the active layer 1312 and extend from one surface of the conductive substrate 1350 to a portion of the first conductive semiconductor layer 1311.

As shown in FIG. 61a, when the first electrode layer 1340 is formed between the insulating layer 1330 and the conductive substrate 1350, the contact hole 1341 is formed to extend from one surface of the first electrode layer 1340. Namely, in order for the first electrode layer 1340 to be electrically connected to the first conductive semiconductor layer 1311, the first electrode layer 1340 is formed to include one or more contact holes 1341 which are electrically insulated from the second conductive semiconductor layer 1313 and the active layer 1312 and extend from one surface of the first electrode layer 1340 to a portion of the first conductive semiconductor layer 1311.

In this case, since the contact hole 1341 is provided to distribute current on the first conductive semiconductor layer 1311, it is required to be electrically separated from the second conductive semiconductor layer 1313 and the active layer 1312. Thus, the insulating layer 1330 may extend while covering the circumference of the contact hole 1341.

Next, as shown in FIG. 61c (which is illustrated by reversing FIG. 61b), the non-conductive substrate 1380 is removed and portions of the first conductive semiconductor layer 1311, the active layer 1312, and the second conductive semiconductor layer 1313 are etched to form the exposed area 1314 on a portion of the interface between the second electrode layer 1320 and the second conductive semiconductor layer 1313.

The exposed area 1314 is formed through selective etching so that only a portion of the light emission stacked body 1310 is etched and the second electrode layer 1320 generally including metal is not etched. In this case, however, it is not easy to perfectly control the selective etching for etching a portion of the light emission stacked body 1310, having the possibility that the second electrode layer 1320 positioned on the lower surface of the light emitting stacked body 1310 is also etched. However, since the etch stop layer 1321 is formed on the area on which etching is performed, the etching can be easily performed and the metal of the second electrode layer 1320 may be prevented from being bonded to the side of the light emission stacked body 1310 to thus reduce a leakage current.

Next, as shown in FIG. 61d, a portion of the etch stop layer 1321 may be removed to connect the second electrode layer 1320 to an external power source. In this case, the electrode pad part 1360 may be formed in the area from which the etch stop layer 1321 has been removed. Also, in order to electrically separate the light emission stacked body 1310 and the electrode pad part 1360, the insulating layer 1370 may be formed on the inner side of the light emission stacked body in which etching has been performed.

FIG. 61 shows a case in which a corner of the light emission stacked body 1310 is etched and the exposed area 1314 of the second electrode layer 1320 is formed on the corner. When the central portion of the light emission stacked body 1310 is etched, the semiconductor LED chip having the configuration as shown in FIG. 56 is fabricated.

When the semiconductor LED chips 1300, 1400, and 1500 according to an exemplary embodiment of the present invention are mounted, the conductive substrates 1350, 1450, and 1550 are electrically connected to a first lead frame and the electrode pad parts 1360, 1460, and 1560 are respectively electrically connected to a second lead frame through a wire, or the like. Namely, the semiconductor LED chips 1300, 1400, and 1500 can be mounted by using both a die bonding method and a wire bonding method at a relatively low cost while guaranteeing luminous efficiency to its maximum level.

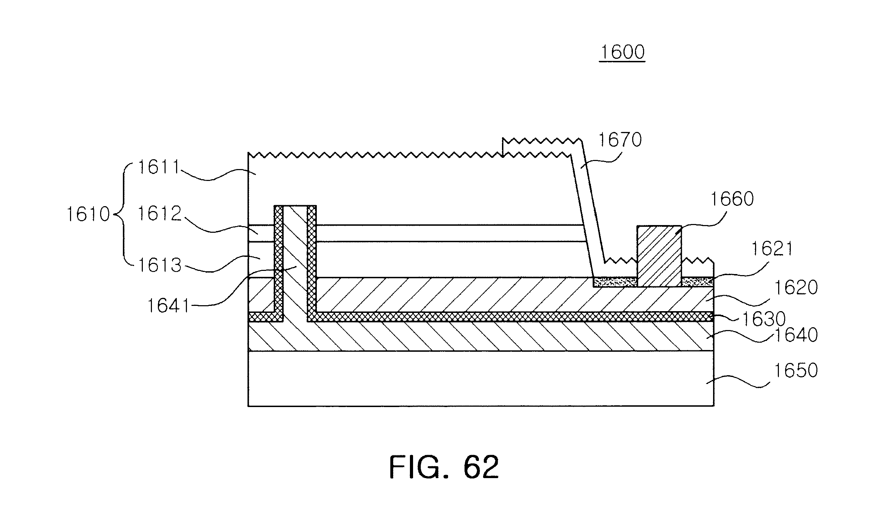

FIG. 62 is a schematic cross-sectional view of a semiconductor LED chip according to a different exemplary embodiment. With reference to FIG. 62, like those of the former exemplary embodiments, the semiconductor LED chip 1600 according to the present exemplary embodiment includes a first conductive semiconductor layer 1611, a active layer 1612, a second conductive semiconductor layer 1613, a second electrode layer 1620, an insulating layer 1630, a first electrode layer 1640, a conductive substrate 1650, an etch stop layer 1620, and an electrode pad part 1660. In order for the first electrode layer 1640 to be electrically connected to the first conductive semiconductor layer 1611, the first electrode layer 1640 includes one or more contact holes 1641 which are electrically insulated from the second conductive semiconductor layer 1613 and the active layer 1612 and extend from one surface of the first electrode layer 1640 to at least a portion of the first conductive semiconductor layer 1611. In the present exemplary embodiment, a passivation layer 1670 having a depression and protrusion structure is added. Since the same elements have been described in explaining the former exemplary embodiments, here, only the passivation layer 1670 will be described.

When the structure including the first conductive semiconductor layer 1611, the active layer 1612, and the second conductive semiconductor layer 1613 is defined as a light emission structure, the passivation layer 1670 is formed to cover the side of the light emission structure, and accordingly, it particularly serves to protect the active layer 1612. In this case, as shown in FIG. 62, the passivation layer 1670 may also be formed on an upper surface of the light emission structure as well as on the side surface thereof, and also at an upper portion of the etch stop layer 1620.

In order to protect the light emission structure, the passivation layer 1670 may be made of a silicon oxide or a silicon nitride such as SiO2, SiOxNy, SixNy , or the like, and preferably has a thickness ranging from 0.1 µm to 2 µm. Accordingly, the passivation layer 1670 has a refractive index ranging from 1.4 to 2.0, and light emitted from the active layer 1612 cannot be easily leaked owing to the difference in the refractive index with air or a mold structure of the package. In the present exemplary embodiment, the passivation layer 1670 includes the depression and protrusion structure to improve external light extraction efficiency, and in particular, as shown in FIG. 62, since the area allowing light, which is emitted in the lateral direction of the active layer 1612, to pass therethrough has the depression and protrusion structure, the amount of light emitted to the side of the semiconductor LED chip 1600 can be increased. Specifically, simulation results obtained by comparing light extraction efficiency of a structure employing the depression and protrusion structure on the passivation layer 1070 and that of a structure without the depression and protrusion structure while having the same constituents show that the light extraction efficiency according to the present exemplary embodiment was improved by about 5 % or greater. Meanwhile, the depression and protrusion structure of the passivation layer 1670 may be also formed on the upper surface of the first conductive semiconductor layer 1611 to improve light extraction efficiency in the vertical direction and also formed on the side surface of the passivation layer 1670, but it is not a must in the present exemplary embodiment.

Meanwhile, as shown in FIG. 1, the resin packaging unit 150 may be molded to cover at least portions of the LED chip 130, the bonding wires 140, and the lead frame 120, or a primary resin packaging unit in the form of a film may be configured and coated on the surface of the LED chip, excluding only the bonding electrode area, and a secondary resin packaging unit having a greater thickness than that of the primary resin packaging unit may be formed on the primary resin packaging unit.

The resin packaging unit 150 is a transparent resin material in which a phenomenon in which it is yellowed after the duration of a long period of time even after being subjected to high temperatures does not occur. The parent resin material may include silicon, an epoxy resin, or the like.

One or more of blue, green, red, and yellow phosphors may be mixedly stacked or respectively stacked in a multi-layered form on the primary resin packaging unit, on the secondary resin packaging unit, or on both primary and secondary resin packaging units.

For example, when the LED chip 130 is a blue LED chip, it includes the yellow, green or blue phosphor, and when the LED chip 130 is a UV LED chip, it may include the green, red, and yellow phosphor.

Various examples of the structure in which the phosphors are stacked in a multi-layered form on the UV LED chip or the blue LED chip will now be described.

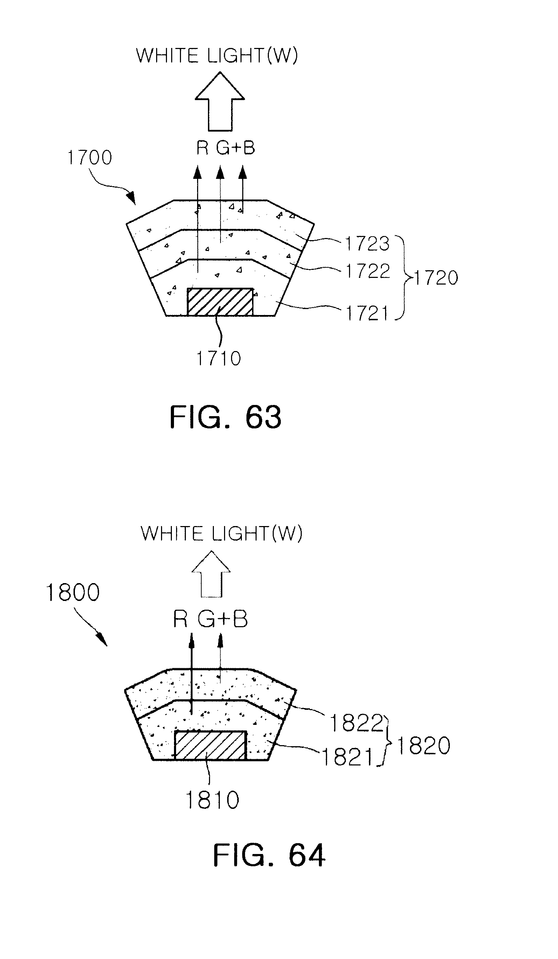

As shown in FIG. 63, a UV LED chip having a wavelength of approximately 410 nm or lower may be covered by multi-layered phosphors including first, second, and third phosphor layers each containing three types of phosphors which emit light of different colors upon being excited by ultraviolet ray.

In detail, the first phosphor layer may be formed on the UV LED chip and may be made of a mixture obtained by mixing a phosphor emitting red light (R) and a resin. As the phosphor emitting red light (R), a fluorescent material, which emits light having a wavelength ranging from 580 nm to 700 nm, preferably, ranging from 600 nm to 650 nm, upon being excited by ultraviolet rays, may be used.

The second phosphor layer may be stacked on the first phosphor layer and may be made of a mixture obtained by mixing a phosphor emitting green light (G) and a resin. As the phosphor emitting green light (G), a fluorescent material, which emits light having a wavelength ranging from 500 nm to 550 nm upon being excited by ultraviolet ray, may be used.

The third phosphor layer may be stacked on the second phosphor layer and may be made of a mixture obtained by mixing a phosphor emitting blue light (B) and a resin. As the phosphor emitting green light (B), a fluorescent material, which emits light having a wavelength ranging from 420 nm to 480 nm, upon being excited by ultraviolet ray, may be used.

With such a configuration, ultraviolet rays emitted from the UV LED chip excite the different types of phosphors containing in the first to third phosphor layers. Accordingly, red light (R), green light (G), and blue light (B) are emitted from the first to third phosphor layers, and the light beams of the three colors of light are combined to form white light (W).

In particular, the phosphor layers for converting ultraviolet rays into phosphors are formed as multiple layers, namely, three layers, and in this case, the first phosphor layer emitting light of the longest wavelength, namely, red light (R), is first stacked on the UV LED chip, and then, the second and third phosphor layers emitting green light (G) and blue light (B) having a shorter wavelength are sequentially stacked thereon. Thus, since the first phosphor layer containing the phosphor emitting red light (R) having the lowest photo conversion efficiency is positioned to be closest to the UV LED chip, the photo conversion efficiency of the first phosphor layer can be relatively increased, thus improving the overall photo conversion efficiency of the LED chip.

In FIG. 64, multiple phosphor layers are formed to cover a UV LED chip having a wavelength of 410 nm or lower, and in this case, the multiple phosphor layers are configured as two-storied phosphor layers.

In detail, the first phosphor layer formed on the UV LED chip is made of a mixture obtained by mixing a phosphor emitting red light (R) and a resin. The second phosphor layer stacked on the first phosphor layer is made of a mixture obtained by mixing a phosphor emitting green light (G) and a phosphor emitting blue light (B) together in a resin.

Through such a configuration, ultraviolet rays emitted from the UV LED chip excite the phosphors contained in the first phosphor layer to emit red light (R) and excite the two types of phosphors mixed in the second phosphor layer to emit green light (G) and blue light (B). As light beams of the three types of colors are combined, white light (W) is seen by human eyes.

As described above, the phosphor layer for converting ultraviolet ray into phosphor is formed as a two-storied layer, and the first phosphor layer emitting red light (R) having the longest wavelength is first stacked on the UV LED chip and then, the second phosphor layer emitting green light (G) and blue light (B) having a shorter wavelength are stacked thereon. According to the multi-phosphor layer stacked structure, the effect of photo conversion efficiency can be obtained, likewise as in the former exemplary embodiment.

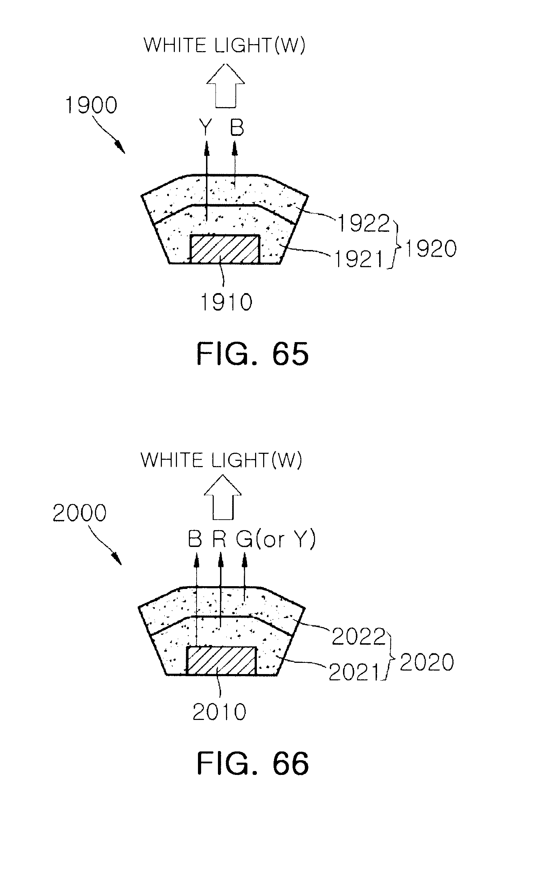

In FIG. 65, multiple phosphor layers are configured as two-storied phosphor layers covering the UV LED chip, and in this case a first phosphor layer formed on the UV LED chip is made of a mixture obtained by mixing a phosphor emitting yellow light (Y) and a resin. As the phosphor emitting yellow light (Y), a phosphor emitting light having a wavelength ranging from 560 nm to 580 nm upon being excited ultraviolet ray is used.

A second phosphor layer stacked on the first phosphor layer is made of a mixture obtained by mixing a phosphor emitting blue light (B) in a resin.

In FIG. 66, multiple phosphor layers are configured as two-storied layers to cover the LED chip emitting blue light (B) having a wavelength ranging from 420 nm to 480 nm as excitation light, and in this case, a first phosphor layer formed on the LED chip is made of a mixture obtained by mixing a phosphor emitting red light (R) and a resin, and a second phosphor layer stacked on the first phosphor layer is made of a mixture obtained by mixing a phosphor emitting green light (G) or yellow light (Y) in a resin.

Through such a configuration, blue light (B) emitted from the LED chip excites the phosphors contained in the first phosphor layer to emit red light (R), and excites the phosphors contained in the second phosphor layer to emit green light (G) or yellow light (Y). In this manner, red light (R) and green light (G) (or yellow light (Y)) emitted from the multiple phosphor layers and blue light (B) generated from the LED chip are combined to form white light (W).

Meanwhile, the resin packaging unit 150 has a dome-shaped form such that an outer surface thereof forms an upwardly convex curved surface due to surface tension.

The resin packaging unit 150 having the dome shape may be made of any material among glass, silicon, epoxy, or a transparent resin. The resin packaging unit 150 having the dome shape may be configured such that its upper surface is a convex curved surface or its central portion is concave while the outer portion is sloped to have a convex curved surface in consideration of a light orientation angle, and in this case, the height of the convex curved surface slope is 10 to 50 The of the diameter or a maximum linear distance of the bottom point from which the slope starts.

A scattering substance for diffusing or mixing light may be included.

As the blue phosphor, (Ba, Sr, Ca)5(PO4)3Cl:(Eu2+ , Mn2+) or Y2O3:(Bi3+, Eu2+) may be selectively used.

The red phosphor may include nitride-based or sulfide-based red phosphors. The nitride-based red phosphors may include CaAlSiN3:Eu, Sr2-z-xBazSi4-yO4-2yN4:Eux2+ (0.001< x <0.5, 0≤ y <2, 0≤ z ≤1.5), CaAlSiOy(N1-xClx):Eu(0.00001< x <0.5, 0≤ y <0.5), MxSiyNz:Eu(M is Ca, Sr, Ba, Zn, Mg, z=2/3x+4/3y), for example, Sr2Si5N8:Eu, A2Si3-XAIX02+ XN4-X:M (0≤ X ≤0.5)(A: Mg,Ca,Sr,Ba) (M:CI,F,Mn,Ce,Nd,Sm,Eu,Tb,Dy Ho,Er,Tm,Yb), M2SiO4-xNx: Ln (M may be at least one bivalent positive ion among Mg, Ca, Sr, Ba, Zn, Mn, or a combination of monovalent or trivalent positive ions, and Ln is a positive ion element including at least one among lanthanoids such as Ce, Eu, etc.) phosphor of a nitride series or a (Ca,Sr)S:Eu red phosphor having a sulfide-based composition.

The green phosphors may include any one of a silicate-based green phosphor, a sulfide-based green phosphor, and a nitride-based green phosphor. The silicate-based green phosphors may include any one of A2SiO4 silicate-based green phosphors having a 2,1,4 composition or a A3SiO5 silicate-based green phosphor having a 3,1,5 composition, a sulfide-based green phosphor having a SrGa2S4:Eu composition, and a nitride-based green phosphor having a Beta-SiAION composition. Here, A may be Sr, Ba, Ca, Mg, and in this case, Sr is an essential element and Ba, Ca, and Mg may be selectively included as necessary (0≤Ba,Ca,Mg≤1). The nitride-based green phosphor includes a crystal of a nitride having Eu employed in a crystal having a β type S13N4 crystal structure or an oxynitride, and may include a phosphor represented by Si6-zAlzOzN8-z : Euy, Srx (0.009<x<0.011, 0.018 < y < 0.025, 0.23 < z < 0.35) or Si6-zAlzOzN8-z (0.24 ≤ y ≤ 0.42, Content of Eu is 0.05at% ~ 0.25at%).

The yellow phosphors may include any one of a garnet-based phosphor of YAG or TAG series, an A2SiO4--based phosphor having a 2,1,4 composition or an A3SiO5 silicate-based phosphor having a 3,1,5 composition, and a nitride-based phosphor having an α-SiAION composition (Here, A may be Sr, Ba, Ca, and Mg, Sr is an essential component, and Ba, Ca, and Mg may be selectively included as necessary) (0≤Ba,Ca,Mg≤1)). As the nitride-based phosphor, a Ca-α-sialon phosphor represented by CaXSi12-(m+ 2)Al(m+ n)OnN16-n : Euy (0.01<y<0.7, 0.6<m<3.0 and 0≤n<1.5) may be used.

As the phosphor, a nano-phosphor emanating light from blue to red by adjusting the size of quantum dots may be also used. The material of the nano-phosphor may be selected from the group consisting of a group II-VI compound semiconductor nano-crystal having quantum dots such as CdS, CdSe, CdTe. ZnS, ZnSe, ZnTe, HgS, HgSe, HgTe, a group III-V compound semiconductor nano-crystal having quantum dots such as GaN, GaP, GaAs, AIN, AIP, AlAs, InN, InP, InAs, or a mixture thereof. The mixture may be selected from the group consisting of CdSeS, CdSeTe, CdSTe, ZnSeS, ZnSeTe, ZnSTe, HgSeS, HgSeTe, HgSTe, CdZnS, CdZnSe, CdZnTe, CdHgS, CdHgSe, dHgTe, HgZnS, HgZnSe, HggZnTe, CdZnSeS, CdZnSeTe, CdZnSTe, CdHgSeS, CdHgSeTe, CdHgSTe, figZnSeS, HgZnSeTe, and HgZnSTe, or selected from the group consisting of GaNP, GaNAs, GaPAs, ALNP, AINAs, AIPAs, InNP, InNAs, InPAs, GaAINP, GaAINAs, GaAIPAs, GaInNP, GaInNAs, GalnPAs, INAINP, InAINAs, and InAIPAs. In the case of mixtures, a crystal structure may be partially divided to exist in the same particle or exist in the form of an alloy. The quantum dots are fabricated according to a chemical wet synthesizing method. The carrier is i) a metal oxide, a polymer, metal salt, ii) inorganic phosphor, or iii) a mixture thereof. In the quantum dot phosphor, i) the metal oxide is selected from the group consisting of SiO2, TiO2, A12O3, and a mixture thereof, the polymer is selected from the group consisting of polystyrene, polyimide, polyacrylate, polycarbonate, polyimidazole, and a mixture thereof, the metal salt is selected from the group consisting of KBr, NaBr, KI, KCI, and NaCl. ii) The inorganic phosphor may be selected from the group consisting of ZnS:Ag, ZnS:Cu, ZnS:Mn, ZnS:Cu,Al, (Zn,Cd)S:Cu, Zn,Cd)S:Ag, (Zn,Cd)S:Cu,Al, ZnS:Cu,Au,AI, ZnS:Ag,Cu,Ga,Cl, Y2O2S:Eu, ZnS:Ag,Al, ZnO:Zn, BaMgAl10017:Eu2+, (Sr,Ca,Ba,Mg)10(PO4)6C12:Eu, Sr10(PO4)6C12:Eu, (Ba,Sr,Eu)(Mg,Mn)A110017, (Ba,Eu)MgA110017, YVO4-:Eu, and a mixture thereof.

A step of dispersing quantum dots in a dispersion solvent so as to be mixed with a carrier in a sold state, and then drying the same to remove the dispersion solvent is included. The quantum dots are reacted at a temperature ranging from 100°C to 400°C for one second to four hours according to a chemical wet synthesizing method, so as to be fabricated. The dispersion solvent is selected from the group consisting of chloroform, toluene, octane, heptane, hexane, pentane, dimethylchloride, and tetrahydrofuran. The dry processing is performed at a temperature ranging from 60°C to 120°C for 30 minutes to eight hours.

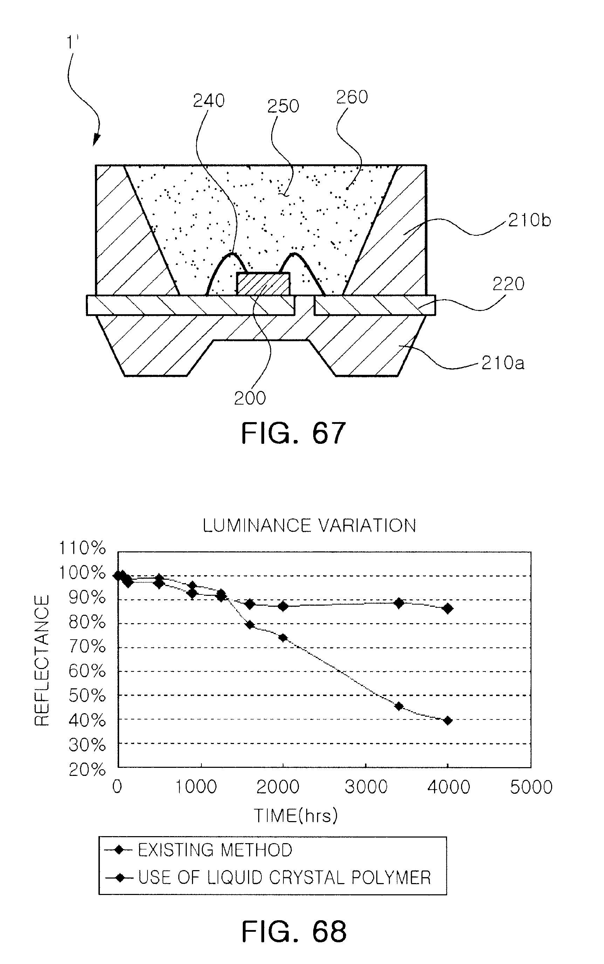

FIG. 67 is a vertical cross-sectional view of an LED package using a liquid crystal polymer according to a different exemplary embodiment of the present invention. As shown in FIG. 67, an LED package 200 includes a package main body 210a, a lead frame 220 molded on the package main body 210a, an LED chip 230 mounted on the lead frame 220, a phosphor 260, and a resin packaging unit 250 covering the LED chip 230. The LED package 200 further includes bonding wires 240 for electrically connecting the LED chip 230 and the package main body 210a.

The package main body 210a is injection-molded by using a liquid crystal polymer, and a reflective cup 210b having a recess to surround the LED chip 230 is formed at an upper portion of the package main body 210a based on the location of the lead frame 220. The reflective cup 210b is formed in a ring shape on the package main body 210a, and an area on which the LED chip 230 is mounted is formed at an inner side of the reflective cup 210b, namely, in the recess. A side wall of the reflective cup 210b is formed as a reflective face for reflecting light emitted from the LED chip 230 in a desired direction. Here, the package main body 210a may be integrally formed with the reflective cup 210b.

Here, the liquid crystal polymer exhibits the qualities of liquid crystal in a molten state. The liquid crystal polymer maintains a crystal state even in a molten state and has excellent heat resistance and formability. In particular, compared with a nylon-based polymer used for forming a package main body of the related art LED package, the liquid crystal polymer has excellent heat conductivity, thus effectively releasing heat generated from the LED chip to the outside. Also, the liquid crystal polymer has a higher reflectance than that of the nylon-based polymer, so it has excellent light reflection efficiency compared with the package main body molded by polyphthalamide so as to be formed.

Such a liquid crystal polymer has a self-reinforcement effect according to the orientation (or alignment) of stiff molecular cycles, having a high mechanical strength, and also has a high impact strength from a low temperature to a high temperature. Also, the liquid crystal polymer has excellent heat resistance and electric insulation, low melt viscosity to facilitate shaping to allow for shaping to have a small thickness, and excellent gas barrier properties.

Thus, the use of the liquid crystal polymer as an injection-molding resin obtains excellent reliability characteristics over a high temperature and ultraviolet ray compared with an existing nylon-based injection-molding resin. Also, since the liquid crystal polymer has a low moisture absorption rate, a degradation caused by moisture infiltration is reduced. Also, recently, environmental regulations for the user of halogen elements (F, Cl, Br, and I) have been strengthened. The existing injection-molding resin contains a small amount of a halogen element, but the liquid crystal polymer does not include such a halogen element and thus can be used as environment-friendly material in the future.

Also, an addition of glass fibers, mineral salts, or the like to the liquid crystal polymer used for injection-molding the reflective cup 210b of the package main body 210a according to the present exemplary embodiment can further increase the mechanical strength thereof. Also, In an exemplary embodiment of the present invention, the package main body 210a and the reflective cup 210b are injection-molded by using a liquid crystal polymer obtained by adding a light catalyst, e.g., at least any one of TiO2 MgO, CaCO3, to thereby further improve the degree of white emitted from the LED package . In an exemplary embodiment of the present invention, the package main body 210a and the reflective cup 210b are injection-molded by using a liquid crystal polymer including thermal stabilizer, photostabilizer added therein, to thereby further improve thermal, optical reliability of the LED package.

The lead frames 220, formed on the bottom of the recess, constitute electrodes to be connected to a positive electrode terminal and a negative electrode terminal of the LED chip 230 mounted on the lead frames 220, and area spaced apart so as to be insulated. The lead frames 220 are protruded from the package main body 210 so as to be electrically connected to an external power source, and the protruded lead frames may have various shapes. The lead frames 220 may be plated with Ag in order to reflect light emitted from the LED chip 220.

The LED chip 230 may be bonded on the lead frame 220 through an adhesive, or the like, and generates light having a predetermined wavelength upon receiving current from an external power source through the bonding wires 240. Here, the LED chip 230 is configured as a semiconductor stacked structure emitting light having at least a first wavelength region selected from among a UV, blue, green, or red wavelength range, from a UV, blue, yellow, and green wavelength range, from a UV and blue wavelength range, from a UV and green wavelength range, from blue, yellow and green wavelength range, or from a yellow and red wavelength range. The stacked structure may be the same as that described above.

The resin packaging unit 250 is molded to fill the space at the inner side of the reflective cup 210b to cover the LED chip 230, the bonding wires 240, and the lead frames 220. The resin packaging unit 250 is a transparent resin material in which a yellowing phenomenon does not occur, even after a long period of time operating at high temperatures, and the resin material may include silicon, an epoxy resin, or the like. The resin packaging unit 250 includes the phosphors 260 for converting the wavelength of the light of the LED chip 210. The phosphors 260 may include a mixture of one or more of green, red, and yellow phosphors.

As a material of the phosphors, those described above can be applicable in the same manner.

FIG. 68 is a graph of luminance variation over operation time of the LED package using a liquid crystal polymer according to an exemplary embodiment of the present invention.

As shown in FIG. 68, it is noted that the LED package according to an existing method shows a rapid luminance variation after 1,500 hours and the initial luminance value is dropped to 40% at about 4,000 hours.

Meanwhile, the LED package using a liquid crystal polymer according to an exemplary embodiment of the present invention maintains a luminance of 90% or higher for 1,500 hours and late 80% from 1,500 hours to 4,000 hours. Thus, it is noted that although the LED package operates at a high temperature of approximately 85°C, a 10% of luminance variation is maintained, providing excellent reliability.

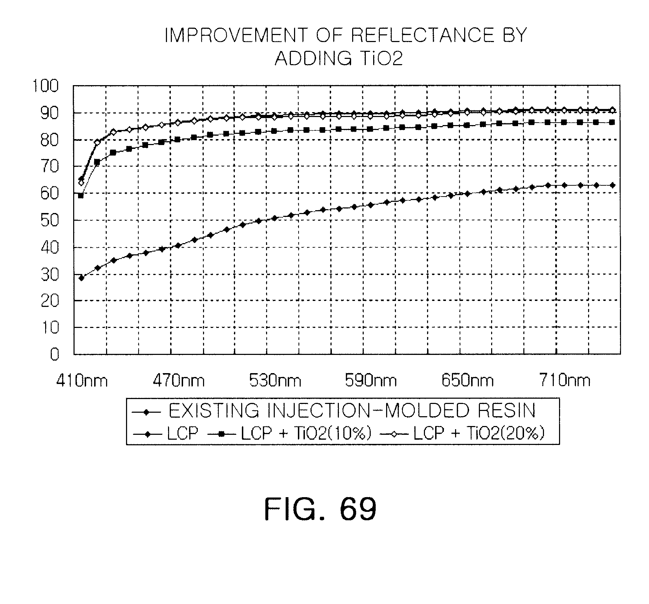

FIG. 69 is a graph showing reflectance according to materials used for forming package main bodies.

As shown in FIG. 69, it is noted that a package main body injection-molded with the existing nylon-based polymer has a reflectance ranging from 30% to 60%.

Meanwhile, it is noted that the LED package using a liquid crystal polymer according to an exemplary embodiment of the present invention has a reflectance of 60% or higher and maintains early 90% according to an addition amount of TiO2, exhibiting excellent reflectance.

As described above, the LED package using a liquid crystal polymer according to an exemplary embodiment of the present invention has the advantages in that since the package main body is injection-molded by using a liquid crystal polymer, it has excellent reliability over a high temperature and high moisture and over ultraviolet rays and near ultraviolet rays and good mechanical strength. In addition, since the LED package does not include a halogen element, an environmentally hazardous substance, it can meet requirements for environmental-friendliness.

As set forth above, according to exemplary embodiments of the invention, a package main body is injection-molded by using a liquid crystal polymer, excellent reliability against a high temperature, a high moisture, and ultraviolet rays can be secured.

In addition, since a package main body is injection-molded by using a liquid crystal polymer, it does not include a halogen element harmful to environment, and thus, it is free of environmental regulations and meets the environmentally-friendly requirements.

While the present invention has been shown and described in connection with the exemplary embodiments, it will be apparent to those skilled in the art that modifications and variations can be made without departing from the spirit and scope of the invention as defined by the appended claims.

## Claims

1. A light emitting diode (LED) package using a liquid crystal polymer, the package comprising:
a package main body formed by using a liquid crystal polymer;
a lead frame formed on the package main body; an LED chip mounted on the lead frame; and
a resin packaging unit encapsulating the LED chip, the resin packaging unit including phosphors.

2. The package of claim 1, wherein the liquid crystal polymer comprises glass fibers or mineral salts.

3. The package of claim 1, wherein the liquid crystal polymer comprises at least any one of TiO2, MgO, and CaCO3.

4. The package of claim 1, wherein the liquid crystal polymer comprises at least any one of a heat stabilizer and a light stabilizer.

5. The package of claim 1, further comprising:
a bonding wire electrically connecting the LED chip and the lead frame.

6. The package of claim 1, wherein the package main body is formed by molding a portion of the lead frame.

7. The package of claim 6, wherein the package main body comprises a reflective cup having a recess portion to accommodate the LED chip.

8. The package of claim 7, wherein the LED chip is mounted in the recess portion.

9. The package of claim 8, wherein the lead frame is formed on the bottom of the reflective cup.

10. The package of claim 9, wherein the lead frame is plated with silver (Ag).

11. The package of claim 1, wherein the resin packaging unit comprises one or more of blue, green, red, and yellow phosphors or may be formed to have a multi-layered structure.

12. The package of claim 11, wherein the resin packaging unit is made of a transparent resin.

13. The package of claim 1. wherein the liquid crystal polymer has 90% or more whiteness (Lx(D65)).

14. The package of claim 1, wherein the liquid crystal polymer has reflectance of 70% or higher, according to the wavelength in a visible region ranging from 450 nm to 780 nm.
